(19) Europäisches Patentamt
European Patent Office
Office européen des brevets

(11) EP 3 677 435 B1

(12) # EUROPEAN PATENT SPECIFICATION

(45) Date of publication and mention of the grant of the patent:
**06.09.2023 Bulletin 2023/36**

(21) Application number: **18851746.0**

(22) Date of filing: **31.08.2018**

(51) International Patent Classification (IPC):
***B41N 3/00*** *(2006.01)* ***B41N 1/14*** *(2006.01)*
***G03F 7/00*** *(2006.01)* ***G03F 7/004*** *(2006.01)*
***G03F 7/095*** *(2006.01)* ***B41C 1/10*** *(2006.01)*

(52) Cooperative Patent Classification (CPC):
**B41C 1/10;** B41C 1/1008; B41C 1/1016; B41C 1/1025; B41C 1/1033; B41C 2201/06; B41C 2201/10

(86) International application number:
**PCT/JP2018/032508**

(87) International publication number:
**WO 2019/045084 (07.03.2019 Gazette 2019/10)**

(54) **PRINTING PLATE PRECURSOR AND PRINTING PLATE PRECURSOR LAMINATE**

DRUCKPLATTENVORLÄUFER UND LAMINAT AUS DRUCKPLATTENVORLÄUFERN

PRÉCURSEUR DE PLAQUE D'IMPRESSION ET STRATIFIÉ DE PRÉCURSEURS DE PLAQUE D'IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2017 JP 2017167854**

(43) Date of publication of application:
**08.07.2020 Bulletin 2020/28**

(73) Proprietor: **FUJIFILM Corporation**
**Tokyo 106-8620 (JP)**

(72) Inventors:
- **SHIMANAKA Shuji**
**Haibara-gun**
**Shizuoka 421-0396 (JP)**
- **IKEYAMA Yusuke**
**Haibara-gun**
**Shizuoka 421-0396 (JP)**
- **WATANABE Shumpei**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 514 681**
**WO-A1-2017/002641**
**JP-A- H08 106 183**
**JP-A- 2002 333 704**
**JP-A- 2004 017 303**
**US-A- 4 272 569**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 677 435 B1

## Description

### BACKGROUND OF THE INVENTION

1. Field of the Invention

The present invention relates to a printing plate precursor including a planographic printing plate precursor and a key plate precursor, and a printing plate precursor laminate.

2. Description of the Related Art

A planographic printing plate precursor is frequently stored and transported as a laminate formed by laminating a plurality of sheets thereof. In this laminate, interleaving paper is typically inserted into the space between planographic printing plate precursors for the purpose of preventing dislocation in stacking of planographic printing plate precursors, preventing adhesion between planographic printing plate precursors, and preventing scratches on a surface of a planographic printing plate precursor on a recording layer side. However, in a case where interleaving paper is used, problems of e.g. cost increase and a disposal treatment may occur, and thus the interleaving paper needs to be removed before an exposure step. Therefore, this may also result in risk of occurrence of a load on a plate-making step and occurrence of interleaving paper peeling failure. Further, at the time of removing the interleaving paper, it is necessary to give consideration so that the surface of the planographic printing plate precursor on the recording layer side is not damaged. Accordingly, development of a planographic printing plate precursor that enables lamination without the interleaving paper has been required.

For example, a printing plate precursor including a support, a layer containing a polymer on one side of the support, and a layer contains metal oxides and fine particles obtained by hydrolyzing and polycondensing an organic metal compound or an inorganic metal compound on the other side of the support, in which the average particle diameter of the fine particles is 0.3 μm or greater and is greater than the thickness of the layer containing the metal oxides and the fine particles (WO2017/002641); and an offset planographic printing plate provided with a back coat layer which is formed of an organic polymer material having a glass transition temperature (Tg) of 35°C or higher and contains particles colored by a pigment have been known (JP-A-2002-046363).

EP-A-1514681 discloses a printing plate material in roll form of the on-press development type comprising a support, a functional layer including a hydrophilic layer and a thermosensitive image formation layer provided on one side of the support, and a back coat layer provided on the other side of the support, the functional layer containing first matting agents and having first protrusions formed from the first matting agents, and the back coat layer containing second matting agents and having second protrusions formed from the second matting agents, wherein an average protrusion height of the first protrusions is 0.5-5.0 μm higher than that of the second protrusions.

JP-A-2004-017303 relates to a lithographic printing plate material having at least a hydrophilic layer or an ink repellent layer on one surface of a flexible substrate, and having a light transmittance at 830 nm of ≥ 0.1, wherein the surface roughness (Ra value) of the flexible substrate on the opposite side of the hydrophilic layer or the ink repellent layer of the lithographic printing plate material is 0.1 to < 2 μm.

JP-A-2002-333704 describes a recording for the production of an offset printing plate having a web- or plate-shaped support, a radiation-sensitive layer on the front of the support, and a continuous layer on the back of the support. The material disposed on the back side has a glass transition temperature Tg of ≥ 55°C an electrical surface resistance of ≤ $10^{6}$ Ω at 23°C and 50% RH, wherein the back coating can have a smooth or structured surface, depending on the nature of the electrically conductive component and the method of application.

JP-A-1996-106183 discloses a direct-drawing type lithographic printing plate material comprising a water resistant support, an image receiving layer formed on one surface of the support and containing zinc oxide and a resin as main components and, formed on the opposite surface of the support, a back layer containing aluminum hydroxide and kaolin as pigments,.

### SUMMARY OF THE INVENTION

However, even in WO2017/002641 and JP-A-2002-046363, in a case where printing plate precursors each including a planographic printing plate precursor and a key plate precursor are laminated, there has been a demand for further improvement in scratches on rear surface layers of the printing plate precursors and peeling of the rear surface layers even without using interleaving paper.

An object of the present invention is to provide a printing plate precursor which is capable of preventing scratches on a rear surface layer and peeling of the rear surface layer even without interleaving paper in a case where printing plate precursors each including a planographic printing plate precursor and a key plate precursor are laminated. Further,

another object of the present invention is to provide a laminate of the printing plate precursors.

The present invention provides a printing plate precursor comprising:

1) an aluminum support;
2) a layer containing a polymer on a printing surface side on the aluminum support; and
3) a layer containing

- tabular particles having an aspect ratio (Z) of ≥ 5 on a non-printing surface side opposite to the layer containing the polymer in a state of sandwiching the support therebetween;
  the aspect ratio being defined as the ratio Z = L/a of the long diameter (L) to the thickness (a) of a particle, wherein L is the number average particle diameter determined with a LB-500 type dynamic light scattering (DLC) particle size distribution measuring device of Horiba, Ltd. while the particles are dispersed in a solvent, and the unit thickness a is a value calculated by measuring a diffraction peak of a particle using a SmartLab SE powder X-ray diffraction device of Rigaku Corporation; and
- particles other than the tabular particles, having an average particle diameter which is ≥ 0.1 μm and is greater than the thickness of the layer containing the tabular particles.

Also, the present invention provides a printing plate precursor laminate which is obtained by laminating a plurality of the present printing plate precursors, wherein the printing plate precursor laminate is formed such that an outermost layer on a surface where the layer containing the polymer is provided and an outermost layer on a surface where the layer containing the tabular particles is provided are laminated by being brought into direct contact with each other.

Preferred embodiments of the invention are as defined in the appended dependent claims and/or in the following detailed description.

According to the present invention, it is possible to provide a printing plate precursor which is capable of preventing scratches on a rear surface layer and peeling of the rear surface layer even without interleaving paper in a case where printing plate precursors each including a planographic printing plate precursor and a key plate precursor are laminated. Further, it is also possible to provide a laminate of the printing plate precursors.

## BRIEF DESCRIPTION OF THE DRAWINGS

Fig. 1 is a schematic view illustrating an anodizing device used for an anodizing treatment.
Fig. 2 is a side view illustrating the concept of a brush graining step used in a mechanical roughening treatment in production of an aluminum support.
Fig. 3 is a graph showing an example of an alternating waveform current waveform diagram used for an electrochemical roughening treatment in production of an aluminum support.
Fig. 4 is a side view illustrating an example of a radial type cell in an electrochemical roughening treatment carried out using an alternating current.

## DESCRIPTION OF THE PREFERRED EMBODIMENTS

Hereinafter, the present invention will be described in detail.

In the present specification, the term "printing plate precursor" includes a planographic printing plate precursor and a printing key plate precursor. Further, the term "printing plate" includes a planographic printing plate and a printing key plate which are produced by performing operations of e.g. exposure and development on the printing plate precursor as necessary. In a case of the printing key plate precursor, operations of exposure and development are not necessarily required.

The printing plate precursor of the present invention (the present printing plate precursor) is a printing plate precursor which includes a support, a layer containing a polymer on a printing surface side on the support, and a layer containing tabular particles on a non-printing surface side opposite to the layer containing a polymer in a state of sandwiching the support therebetween.

One feature of the present printing plate precursor is that the planographic printing plate includes a layer containing tabular particles on a non-printing surface side opposite to the layer containing a polymer in a state of sandwiching the support therebetween.

[Layer containing tabular particles]

The present printing plate precursor includes a layer containing tabular particles (hereinafter, also referred to as a "back coat layer" or a "rear surface layer") on a non-printing surface side (hereinafter, also simply referred to as a "non-printing surface side") opposite to the layer containing a polymer in a state of sandwiching the support therebetween.
It is considered that since the present printing plate precursor contains tabular particles of the back coat layer, the surface of the back coat layer becomes hard, and thus scratch and peeling of the rear surface layer can be prevented in a step of transporting and attaching a printing plate which has been transported and produced in a producing step of the printing plate precursor or a setter, vendor, or stocker plate-making step to a printing press.
in the present invention the back coat layer contains tabular particles and particles other than the tabular particles. In this embodiment, the surface of the back coat layer becomes hard. Therefore, scratches to the rear surface layer and peeling of the rear surface layer can be prevented as described above.

(Tabular particles)

As the tabular particles, optional particles can be used as long as the aspect ratio thereof is 5 or greater.
The aspect ratio thereof is preferably 10 or greater, more preferably 50 or greater, and particularly preferably 100 or greater.
Here, the aspect ratio is defined as a ratio of the long diameter to the thickness of a particle. As the aspect ratio increases, the effect to be obtained increases.
Specifically, the aspect ratio (Z) is represented by a relationship of "Z = L/a". L is a long diameter of a particle. L indicates a number average particle diameter of particles acquired according to a dynamic light scattering method carried out using a dynamic light scattering particle size distribution measuring device (manufactured by Horiba, Ltd., LB-500 type) while the particles are dispersed in a solvent.
a is a unit thickness of a particle. The unit thickness a is a value which can be calculated by measuring a diffraction peak of a particle according to a powder X-ray diffraction method. The unit thickness a can be measured using a powder-ray diffraction device (manufactured by Rigaku Corporation, SmartLab SE).

(Thickness of tabular particle)

It is preferable that the thickness of each tabular particle having an aspect ratio of 5 or greater is smaller than the thickness of the layer containing tabular particles.
It is preferable that the thickness of each tabular particle is smaller than the thickness of the layer containing tabular particles from the viewpoint that the tabular particles are unlikely to fall off and contamination does not occur during the step.
The thickness of each tabular particle is not particularly limited, but is preferably 100 nm, more preferably 50 nm or less, and still more preferably 10 nm or less.
Further, the thickness of each tabular particle is expressed as the unit thickness (a) of the tabular particle.

(Composition of tabular particle)

Examples of the tabular particles include tabular particles that do not have silicon atoms and oxygen atoms such as graphite; and tabular particle having silicon atoms and oxygen atoms such as mica, bentonite containing montmorillonite as a main component, montmorillonite classified as smectite, beidellight, nontronite, saponite, hectorite, sauconite, stevensite, the vermiculite group, and the illite group, but the present invention is not limited thereto.
As the tabular particles, tabular particles having silicon atoms and oxygen atoms are preferable, and smectite, bentonite, or mica is more preferable.
Examples of the mica include the mica group such as natural mica represented by Formula: $A(B,C)_{2\text{-}5}D_4O_{10}(OH,F,O)_2$ [here, A is any of K, Na, or Ca, B and C represent any of Fe(II), Fe(III), Mn, Al, Mg, or V, and D is Si or Al] and synthetic mica.
Examples of the natural mica include muscovite, soda mica, phlogopite, biotite, and lepidolite. Examples of the synthetic mica include non-swelling mica such as fluorine phlogopite $KMg_3(AlSi_3O_{10})F_2$ or potassium tetrasilicon mica $KMg_{2.5}(Si_4O_{10})F_2$; and swelling mica such as Na tetrasilicic mica $NaMg_{2.5}(Si_4O_{10})F_2$, Na or Li teniolite $(Na,Li)Mg_2Li(Si_4O_{10})F_2$.
In the present invention, among examples of the mica, fluorine-based swelling mica is particularly useful. That is, the swelling synthetic mica has a laminated structure formed of a unit crystal lattice layer having a thickness of approximately 100-150 nm (10-15 Å), and the metal atom substitution in the lattice is significantly larger than that of any other viscosity mineral. As the result, the lattice layer becomes deficient in a positive charge, and cations such as $Na^+$,

$Ca^{2+}$, and $Mg^{2+}$ are adsorbed between layers to compensate for the deficiency. The cations interposed between these layers are referred to as exchangeable cations and exchanged for various cations. Particularly, in a case where the cations between the layers are $Li^+$ or $Na^+$, since the ionic radius is small, bonds between layered crystal lattices are weak and greatly swollen with water. Cleavage easily occurs at the time of application of a shear force in this state, and a stabilized sol is formed in water. The swelling synthetic mica has such a strong tendency and thus is useful in the present invention. Particularly, from the viewpoint that particles with a uniform quality are available, the swelling synthetic mica is preferably used.

Montmorillonite: $Si_8(Al_{3.34}Mg_{0.66})O_{20}(OH)_4$ contained in bentonite or smectite is a laminated structure formed of thin tabular crystals having a thickness of approximately 1 nm and a width of approximately 50-1000 nm. Cations such as $Na^+$, $Ca^{2+}$, $K^+$, and $Mg^{2+}$ are interposed between layers. Since montmorillonite having a large amount of $Na^+$ ions in interlayer ions has a weak electrical attraction of unit layers resulting from the $Na^+$ ions, in a case where the montmorillonite is dispersed in water, $Na^+$ ions and water molecules are hydrated, the montmorillonite is swollen, and the unit layers are separated. Cleavage easily occurs at the time of application of a shear force in this state, and a stabilized sol is formed in water.

Interlayer cations of mica, bentonite, and smectite can be simply ion-exchanged for other cations. In a case where the cations are exchanged for cations such as quaternary ammonium ions, particles are unlikely to be dispersed in water. However, the particles have an affinity for an organic solvent and dispersed therein.

Specific examples of the mica, bentonite, and smectite include SOMASIF MEB-3 of mica (manufactured by Katakura Chikkarin Co., Ltd.), KUNIPIA-F, KUNIPIA-G, KUNIPIA-G4, or KUNIPIA-G10 of bentonite, and SUMECTON-SA, SUMECTON-ST, SUMECTON-SW, SUMECTON-SWN, or SUMECTON-SWF of smectite, MOISTNITE-U, MOISTNITE-S, or MOISTNITE-HC of bentonite (manufactured by Kunimine Industries Co., Ltd.).

As described above, interlayer cations of mica, bentonite, and smectite can be simply ion-exchanged for other cations. In a case where the cations are exchanged for cations such as quaternary ammonium ions, particles are unlikely to be dispersed in water. However, the particles have an affinity for an organic solvent and can be dispersed therein. Specific examples thereof include SOMASIF MAE, SOMASIF MTE, or SOMASIF MEE of organic mica (manufactured by Katakura Chikkarin Co., Ltd.), KUNIBIS-110, KUNIBIS-127, or MOISTNITE-WO of organic bentonite, and SUMECTON-SAN, SUMECTON-SAN-P, SUMECTON-STN, OR SUMECTON-SEN of organic smectite (manufactured by Kunimine Industries Co., Ltd.). Further, the types of organic solvents suitable for dispersion vary.

The content of the tabular particles in the layer containing tabular particles is preferably 1-1000 mg/$m^2$, more preferably 5-800 mg/$m^2$, and still more preferably 10-600 mg/$m^2$.

The tabular particles may be used alone or in combination of two or more kinds thereof.

It is preferable that the layer containing tabular particles contain a polymer or a metal oxide obtained by hydrolyzing and polycondensing an organic metal compound or an inorganic metal compound.

(Polymer)

It is preferable that the layer containing tabular particles contains a polymer. It is preferable that the layer containing tabular particles contains an organic polymer as a base polymer that forms the layer. A polymer that forms a uniformly coated-film and has high adhesiveness to the support is preferable.

Hereinafter, examples of the polymer which is preferably used as a base polymer are described below, but the present invention is not limited thereto.

Suitable examples thereof include polybutene, polybutadiene, polyamide, a polyester resin, polyurethane, polyurea, polyimide, polysiloxane, polycarbonate, an epoxy resin, chlorinated polyethylene, an aldehyde condensation resin of alkylphenols, polyvinyl chloride, polyvinylidene chloride, polystyrene, an acrylic resin, and copolymer resins thereof, hydroxy cellulose, polyvinyl alcohol, a polyvinyl acetal resin, a vinylidene chloride copolymer resin, a phenoxy resin, cellulose acetate, carboxy methyl cellulose, a novolac resin, and a pyrogallol acetone resin.

The content of the polymer with respect to the total solid content of the layer containing tabular particles is preferably 99.99-50 mass%, more preferably 99.9-60 mass%, and particularly preferably 99.5-70 mass%.

(Metal oxide obtained by hydrolyzing and polycondensing organic metal compound or inorganic metal compound)

It is preferable that the layer containing tabular particles contain a metal oxide obtained by hydrolyzing and polycondensing an organic metal compound or an inorganic metal compound.

It is preferable that the metal oxide (hereinafter, also simply referred to as a metal oxide) obtained by hydrolyzing and polycondensing the organic metal compound or the inorganic metal compound described above is a so-called sol-gel reaction solution obtained by hydrolyzing and polycondensing an organic metal compound or an inorganic metal compound in water and an organic solvent using a catalyst such as an acid or an alkali.

Examples of the organic metal compound or the inorganic metal compound include a metal alkoxide, a metal

acetylacetonate, a metal acetate, a metal oxalate, a metal nitrate, a metal sulfate, a metal carbonate, a metal oxychloride, a metal chloride, and a condensate obtained by partially hydrolyzing and oligomerizing these.

The metal alkoxide is a compound represented by $M(OR)_n$ (in the formula, M is a metal element, R is an alkyl group, and n is the oxidation number of the metal element). Specific examples thereof include $Si(OCH_3)_4$, $Si(OC_2H_5)_4$, $Si(OC_3H_7)_4$, $Si(OC_4H_9)_4$, $Al(OCH_3)_3$, $Al(OC_2H_5)_3$, $Al(OC_3H_7)_3$, $Al(OC_4H_9)_3$, $B(OCH_3)_3$, $B(OC_2H_5)_3$, $B(OC_3H_7)_3$, $B(OC_4H_9)_3$, $Ti(OCH_3)_4$, $Ti(OC_2H_5)_4$, $Ti(OC_3H_7)_4$, $Ti(OC_4H_9)_4$, $Zr(OCH_3)_4$, $Zr(OC_2H_5)_4$, $Zr(OC_3H_7)_4$, and $Zr(OC_4H_9)_4$; and other examples thereof include alkoxides of atoms such as Ge, Li, Na, Fe, Ga, Mg, P, Sb, Sn, Ta, and V In addition, monosubstituted silicon alkoxides such as $CH_3Si(OCH_3)_3$, $C_2H_5Si(OCH_3)_3$, $CH_3Si(OC_2H_5)_3$, and $C_2H_5Si(OC_2H_5)_3$ can be also used.

Among the organic metal compounds or the inorganic metal compounds, a metal alkoxide is preferable from the viewpoints of being rich in reactivity and easily generating a polymer from a metal-oxygen bond. Among the examples, alkoxide compounds of silicon such as $Si(OCH_3)_4$, $Si(OC_2H_5)_4$, $Si(OC_3H_7)_4$, and $Si(OC_4H_9)_4$ are particularly preferable from the viewpoints of low cost, availability, and excellent coatability of metal oxides obtained from these. Further, oligomers obtained by hydrolyzing and condensing these alkoxide compounds of silicon are also preferable, and examples thereof include an ethyl silicate oligomer of an average pentamer oligomer which contains approximately 40 mass% of $SiO_2$.

The organic metal compound or the inorganic metal compound can be used alone or in combination of two or more kinds thereof.

Further, it is also preferable that a so-called silane coupling agent obtained by substituting one or two alkoxy groups in a tetraalkoxy compound of the silicon with an alkyl group or a group having reactivity is used in combination with a metal alkoxide. Examples of the silane coupling agent include a silane coupling agent obtained by substituting one or two alkoxy groups in a tetraalkoxy compound of the silicon with a hydrophobic substituent such as a long chain alkyl group having 4-20 carbon atoms or a fluorine-substituted alkyl group. Among these, a silane coupling agent containing a fluorine-substituted alkyl group is particularly preferable. Specific examples of the silane coupling agent include $CF_3CH_2CH_2Si(OCH_3)_3$, $CF_3CF_2CH_2CH_2Si(OCH_3)_3$, and $CF_3CH_2CH_2Si(OC_2H_5)_3$, and examples of the commercially available products thereof include LS-1090 (manufactured by Shin-Etsu Chemical Co., Ltd.). The content of the silane coupling agent is preferably 5-90 mass% and more preferably 10-80 mass% with respect to the total solid content of the back coat layer.

As a catalyst useful for forming a sol-gel reaction solution, an organic or inorganic acid and an alkali are used. Examples thereof include an inorganic acid such as hydrochloric acid, sulfuric acid, sulfurous acid, nitric acid, nitrous acid, hydrofluoric acid, phosphoric acid, or phosphorous acid; an organic acid such as formic acid, acetic acid, propionic acid, butyric acid, glycolic acid, chloroacetic acid, dichloroacetic acid, trichloroacetic acid, fluoroacetic acid, bromoacetic acid, methoxyacetic acid, oxaloacetic acid, citric acid, oxalic acid, succinic acid, malic acid, tartaric acid, fumaric acid, maleic acid, malonic acid, ascorbic acid, benzoic acid, substituted benzoic acid such as 3,4-dimethoxybenzoic acid, phenoxyacetic acid, phthalic acid, picric acid, nicotinic acid, picolinic acid, pyrazine, pyrazole, dipicolinic acid, adipic acid, p-toluic acid, terephthalic acid, 1,4-cyclohexene-2,2-dicarboxylic acid, erucic acid, lauric acid, or n-undecanoic acid; and an alkali such as a hydroxide of an alkali metal or an alkaline earth metal, ammonia, ethanolamine, diethanolamine, or triethanolamine.

Other preferred examples of the catalyst include sulfonic acids, sulfinic acids, alkylsulfuric acids, phosphonic acids, and phosphoric esters. Specifically, an organic acid such as p-toluenesulfonic acid, dodecylbenzenesulfonic acid, p-toluenesulfinic acid, ethyl acid, phenylphosphonic acid, phenylphosphinic acid, phenyl phosphate, or diphenyl phosphate can also be used.

The catalyst can be used alone or in combination of two or more kinds thereof. The amount of the catalyst is preferably 0.001-10 mass% and more preferably 0.05-5 mass% with respect to the amount of the metal compound in a raw material. In a case where the amount of the catalyst is in the above-described range, the initiation of the sol-gel reaction is satisfactorily performed, a rapid reaction is suppressed, and generation of non-uniform sol-gel particles can be prevented.

An appropriate amount of water is required to initiate the sol-gel reaction. The amount of water to be added is preferably 0.05-50 molar times and preferably 0.5-30 molar times the amount to be required for completely hydrolyzing the metal compound in the raw material. In a case where the amount of water is in the above-described range, the hydrolysis proceeds satisfactorily.

A solvent is added to the sol-gel reaction solution. The solvent is not limited as long as the solvent dissolves the metal compound in the raw material and dissolves or disperses the sol-gel particles generated by the reaction, and examples thereof include lower alcohols such as methanol, ethanol, propanol, and butanol; and ketones such as acetone, methyl ethyl ketone, and diethyl ketone. Further, mono- or dialkyl ether or acetic acid ester of glycols such as ethylene glycol, diethylene glycol, triethylene glycol, propylene glycol, or dipropylene glycol can be used for the purpose of improving the quality of the coating surface of the back coat layer. As the solvent, lower alcohols which can be mixed with water are preferable. The concentration of the sol-gel reaction solution is adjusted to be suitable for coating using

a solvent, but the hydrolysis reaction is unlikely to proceed because the raw material is diluted in a case where the total amount of solvent is added to the reaction solution from the beginning. Therefore, a method of adding a part of the solvent to the sol-gel reaction solution and then adding the remaining solvent after the reaction proceeds is preferable.

(Other components)

For the purpose of imparting the flexibility, adjusting the slipperiness, and improving the coating surface state, a plasticizer, a surfactant, and other additives can be added to the layer containing tabular particles as necessary within a range where the effects of the present invention are not impaired.

Examples of effective plasticizers include phthalic acid esters such as dimethyl phthalate, diethyl phthalate, dibutyl phthalate, diisobutyl phthalate, dioctyl phthalate, octyl capryl phthalate, dicyclohexyl phthalate, ditridecyl phthalate, butyl benzyl phthalate, diisodecyl phthalate, and diallyl phthalate; glycol esters such as dimethyl glycol phthalate, ethyl phthalyl ethyl glycolate, methyl phthalyl ethyl glycolate, butyl phthalyl butyl glycolate, and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate, dibutyl maleate; polyglycidyl methacrylate, triethyl citrate, glycerin triacetyl ester, and butyl laurate.

The amount of the plasticizer to be added to the layer containing tabular particles varies depending on the type of the polymer used in the layer containing tabular particles, but it is preferable that the plasticizer is added thereto within a range where the glass transition temperature thereof does not reach 60°C.

Examples of the surfactant include anionic surfactants, cationic surfactants, nonionic surfactants, and amphoteric surfactants. Specific examples thereof include nonionic surfactants such as polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbital fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanol amides, N,N-bis-2-hydroxyalkylamines, polyoxyethylene alkylamine, triethanolamine fatty acid ester, and trialkylamine oxide; anionic surfactants such as fatty acid salts, abietates, hydroxyalkane sulfonates, alkane sulfonates, dialkylsulfosuccinic acid ester salts, linear alkylbenzene sulfonates, branched alkylbenzene sulfonates, alkyl naphthalene sulfonates, alkylphenoxy polyoxyethylene propyl sulfonates,
polyoxyethylene alkylsulfophenyl ether salts, N-methyl-N-oleyl taurine sodium salt, N-alkylsulfusuccinic acid monoamide disodium salt, petroleum sulfonates, sulfated tallow oil, sulfuric acid esters of fatty acid alkyl ester, alkyl sulfuric acid ester salts, polyoxyethylene alkyl ether sulfuric acid ester salts, fatty acid monoglyceride sulfuric acid ester salts, polyoxyethylene alkyl phenyl ether sulfuric acid ester salts, polyoxyethylene styryl phenyl ether sulfuric acid ester salts, alkyl phorphoric acid ester salts, polyoxyethylene alkyl ether phosphoric acid ester salts, polyoxyethylene alkyl phenyl ether phosphoric acid ester salts, partially saponified products of a styrene/maleic acid anhydride copolymer, partially saponified products of an olefin/maleic acid anhydride copolymer, and naphthalenesulfonic acid salt formalin condensates; cationic surfactants such as alkylamine salts, quaternary ammonium salts, polyoxyethylene alkylamine salts, and polyethylene polyamine derivatives; and amphoteric surfactants such as carboxy betaines, aminocarboxylic acids, sulfobetaines, aminosulfuric acid esters, and imidazolines.

Among these surfactants exemplified above, polyoxyethylene can also be read as polyoxyalkylene such as polyoxyethylene, polyoxypropylene, or polyoxybutylene and surfactants thereof are also included.

As the surfactant, a fluorine-based surfactant containing a perfluoroalkyl group in a molecule is more preferable. Examples of the fluorine-based surfactant include anionic surfactants such as a perfluoroalkyl carboxylate, a perfluoroalkyl sulfonate, and perfluoroalkyl phosphoric acid ester; amphoteric surfactants such as perfluoroalkylbetaine; cationic surfactants such as a perfluoroalkyl trimethyl ammonium salt; and nonionic surfactants such as perfluoroalkylamine oxide, a perfluoroalkylethylene oxide adduct, an oligomer containing a perfluoroalkyl group and a hydrophilic group, an oligomer containing a perfluoroalkyl group and a lipophilic group, a perfluoroalkyl group, an oligomer containing a hydrophilic group and a lipophilic group, and urethane containing a perfluoroalkyl group and a lipophilic group.

The surfactant can be used alone or in combination of two or more kinds thereof, and the content of the surfactant with respect to the total solid content of the layer containing tabular particles is preferably 0.001-10 mass% and more preferably 0.01-5 mass%.

In a case where the layer containing tabular particles contains a polymer, a dye for coloring, a silane coupling agent for improving the adhesiveness to an aluminum support, a diazo resin formed of a diazonium salt, organic phosphonic acid, organic phosphoric acid, a cationic polymer, a wax typically used as a slip agent, a higher fatty acid, higher fatty acid amide, a silicone compound formed of dimethylsiloxane, modified dimethylsiloxane, or polyethylene powder can be appropriately added to the layer.

The coating amount of the layer containing tabular particles is preferably 0.01-30 g/$m^2$, more preferably 0.1-10

$g/m^2$, and particularly preferably 0.2-5 $g/m^2$.

(Particles other than tabular particles)

It is preferable that the layer containing tabular particles further contain particles other than the tabular particles (hereinafter, also referred to as "non-tabular particles").

It is preferable that the layer contains non-tabular particles from the viewpoint that scratches to the rear surface layer and peeling of the rear surface layer are unlikely to occur.

Here, optional particles can be used as the non-tabular particles as long as the particles do not belong to the range of the tabular particles described above.

That is, the aspect ratio of the particles other than the tabular particles is less than 5 and typically 1 or greater. The aspect ratio thereof is preferably 1-3 and more preferably 1 or 2.

As the particles other than the tabular particles, e.g. organic resin particles, inorganic particles or organic-inorganic composite particles can be used.

Preferred examples of the organic resin particles include particles formed of synthetic resins such as poly(meth)acrylic acid esters, polystyrene and a derivative thereof, polyamides, polyimides, polyolefins such as low-density polyethylene, high-density polyethylene, and polypropylene, polyurethane, polyurea, and polyesters; and particles formed of natural polymers such as chitin, chitosan, cellulose, cross-linked starch, and cross-linked cellulose.

Among these, synthetic resin particles have advantages of easily controlling the particle size and easily controlling desired surface characteristics through surface modification.

Among examples of the method of producing organic resin particles, a method of granulation according to a crushing method can be used in a case of a relatively hard resin such as PMMA, but a method of synthesizing particles according to an emulsification and suspension polymerization method is preferably employed from the viewpoints of ease of controlling the particle diameter and the precision.

The method of producing organic resin particles is specifically described in "Ultrafine Particles and Materials" edited by Materials Science Society of Japan, published by SHOKABO Co., Ltd., in 1993 and "Manufacturing & Application of Microspheres & Powders" supervised by Haruma Kawaguchi, published by CMC Publishing Co., Ltd., in 2005.

The organic resin particles are also available as commercially available products, and examples thereof include acrylic particles such as ART PEARL J-6PF (manufactured by Negami Chemical Industrial Co.,Ltd.); cross-linked acrylic resins such as MX-300, MX-500, MX-1000, MX-1500H, MR-2HG, MR-7HG, MR-10HG, MR-3GSN, MR-5GSN, MR-7G, MR-10G, MR-5C, and MR-7GC; styryl resins such as SX-350H and SX-500H (all manufactured by Soken Chemical & Engineering Co., Ltd.); acrylic resins such as MBX-5, MBX-8, MBX-12, MBX-15, MBX-20, MB20X-5, MB30X-5, MB30X-8, MB30X-20, SBX-6, SBX-8, SBX-12, and SBX-17 (all manufactured by Sekisui Plastics Co., Ltd.); and polyolefin resins such as CHEMIPEARL W100, W200, W300, W308, W310, W400, W401, W405, W410, W500, WF640, W700, W800, W900, W950, and WP100 (all manufactured by Mitsui Chemicals, Inc.).

Examples of the inorganic particles include silica, alumina, zirconia, titania, carbon black, graphite, $TiO_2$, $BaSO_4$, ZnS, $MgCO_3$, $CaCO_3$, ZnO, CaO, $WS_2$, $MoS_2$, MgO, $SnO_2$, $Al_2O_3$, $\alpha$-$Fe_2O_3$, $\alpha$-FeOOH, SiC, $CeO_2$, BN, SiN, MoC, BC, WC, titanium carbide, corundum, artificial diamond, garnet, silica stone, tripolite, diatomaceous earth, and dolomite.

The organic-inorganic composite particles are not particularly limited, but organic resin particles which have been subjected to inorganic surface modification or inorganic particles which have been subjected to organic surface modification are preferable.

Hereinafter, the organic resin particles which have been subjected to inorganic surface modification will be described in detail using organic resin particles coated with silica (hereinafter, also referred to as "silica-coated organic resin particles") as an example, and the organic resin particles which have been subjected to inorganic surface modification in the present invention are not limited thereto.

(Silica-coated organic resin particles)

The silica-coated organic resin particle is a particle which is formed of an organic resin and has a surface coated with silica. It is preferable that the organic resin particles constituting a core are not softened or become sticky due to the moisture in the air or the temperature.

Examples of the organic resin constituting the organic resin particles of the silica-coated organic resin particles include a polyacrylic resin, a polyurethane-based resin, a polystyrene-based resin, a polyester-based resin, an epoxy-based resin, a phenol resin, and a melamine resin.

As a material forming the silica layer covering the surface of the silica-coated organic resin particles, a compound containing an alkoxysilyl group such as a condensate of an alkoxysiloxane-based compound, particularly, a siloxane-based material, and specifically, silica particles such as silica sol, colloidal silica, and silica nanoparticles are preferably exemplified.

The configuration of the silica-coated organic resin particles may be a configuration in which a silica particle adheres to the surface of an organic resin particle as a solid component or a configuration in which a siloxane-based compound layer is formed on the surface of an organic resin particle by performing a condensation reaction on an alkoxysiloxane-based compound.

Silica does not necessarily cover the entire surface of the organic resin particles, and the effects of the present invention can be easily obtained in a case where the surface thereof is coated with at least 0.5 mass% or greater of silica with respect to the mass of the organic resin particles. In other words, in a case where silica is present on at least a part of the surface of the organic resin particles, improvement in affinity of surface of organic particles for a coexisting water-soluble polymer such as PVA is achieved, falling off of the particles is suppressed even in a case where external stress is applied thereto, and excellent scratch resistance and adhesion resistance can be maintained. Accordingly, the expression "coated with silica" in the present invention includes a state in which silica is present on at least a part of the surface of the organic resin particles as described above.

The state of the surface being coated with silica can be confirmed by e.g. morphological observation using a scanning electron microscope (TEM). Further, the coating amount of silica can be confirmed by detecting Si atoms through elemental analysis such as fluorescent X-ray analysis and calculating the amount of silica present therein.

A method of producing silica-coated organic resin particles is not particularly limited, and examples thereof include a method of forming a silica surface coating layer simultaneously with formation of organic resin particles by allowing silica particles or a silica precursor compound to coexist with a monomer component which becomes the raw material of the organic resin particles; and a method of forming organic resin particles, physically adhering silica particles to the surface of the organic resin particles, and then fixing the silica particles thereto.

Hereinafter, an example of the method of producing the silica-coated organic resin particles will be described. First, silica and a raw material resin (more specifically, a raw material resin such as a monomer capable of suspension polymerization, a pre-polymer capable of suspension cross-linking, or a resin liquid, constituting the above-described organic resin) are added to water containing a suspension stabilizer appropriately selected from a water-soluble polymer such as polyvinyl alcohol, methyl cellulose, or polyacrylic acid and an inorganic suspending agent such as calcium phosphate or calcium carbonate, and stirred and mixed with the water to prepare a suspension in which silica and a raw material resin are dispersed. At this time, a suspension having a target particle diameter can be formed by adjusting the type, the concentration, and the stirring rotation speed of the suspension stabilizer. Next, the suspension is heated to initiate the reaction, and resin particles are generated by performing suspension polymerization or suspension cross-linking of the resin raw material. At this time, the coexisting silica is fixed to the resin particles cured by the polymerization or the cross-linking reaction, particularly, the vicinity of the surface of the resin particles due to the physical properties thereof. Thereafter, the suspension is subjected to solid-liquid separation, the suspension stabilizer adhering to the particles is removed by washing, and the particles are dried. In this manner, silica-coated organic resin particles to which silica is fixed and which have a desired particle diameter and a substantially spherical shape can be obtained.

Silica-coated organic resin particles having a desired particle diameter may be obtained by controlling the conditions during the suspension polymerization as described above, or the suspension cross-linking or silica-coated organic resin particles may be generated without strictly controlling the conditions and then silica-coated organic particles having a desired size is obtained by e.g. a mesh filtration method.

In regard to the amount of the raw material to be added to the mixture during the production of the silica-coated organic particles according to the above-described method, in a case where the total amount of the raw material resin and the silica is 100 parts by weight (pbw), first, 0.1-20 pbw of the suspension stabilizer is added to 200-800 pbw of water serving as a dispersion medium, and sufficiently dissolved or dispersed therein, 100 pbw of a mixture of the raw material resin and the silica is put into the solution, the solution is stirred while the stirring speed is adjusted such that the dispersed particles have a predetermined particle size, the solution temperature is increased to 30-90°C after the adjustment of the particle size, and then a reaction is performed for 1-8 hours.

The above-described method is merely an example of the method of producing silica-coated organic resin particles and silica-coated organic resin particles obtained by the methods specifically described in e.g. JP-A-2002-327036, JP-A-2002-173410, JP-A-2004-307837 and JP-A-2006-038246 can be also suitably used in the present invention.

Further, the silica-coated organic resin particles are also available as commercially available products, and specific examples of silica-melamine composite fine particles include OPTBEADS 2000M, OPTBEADS 3500M, OPTBEADS 6500M, OPTBEADS 10500M, OPTBEADS 3500S, and OPTBEADS 6500S (all manufactured by Nissan Chemical Industries, Ltd.). Specific examples of silica-acrylic composite particles include ART PEARL G-200 transparent, ART PEARL G-400 transparent, ART PEARL G-800 transparent, ART PEARL GR-400 transparent, ART PEARL GR-600 transparent, ART PEARL GR-800 transparent, ART PEARL J-4P, J-5P, J-7P, J-3PY, J-4PY, and J-7PY (all manufactured by Negami Chemical Industrial Co., Ltd.). Specific examples of silica-urethane composite particles include ART PEARL C-400 transparent, C-800 transparent, P-800T, U-600T, U-800T, CF-600T, CF800T (all manufactured by Negami Chemical Industrial Co., Ltd.) and DYNAMIC BEADS CN5070D and DANPLACOAT THU (both manufactured by Dainichiseika

Color & Chemicals Mfg. Co., Ltd.).

Hereinbefore, the organic resin particles used for the back coat layer of the present invention have been described using the example of the silica-coated organic resin particles, and the same applies to organic resin particles coated with alumina, titania, or zirconia by using alumina, titania, or zirconia in place of silica.

Further, inorganic particles which have been subjected to organic surface modification can also be used. Examples of the commercially available products thereof include, as methyl group-modified silica particles, TOSPEARL 120, TOSPEARL 130, TOSPEARL 145, TOSPEARL 2000B, TOSPEARL 1110, and TOSPEARL 240 (manufactured by Momentive Performance Materials Japan LLC).

It is preferable that the average particle diameter of the non-tabular particles is greater than the thickness of the layer (back coat layer) containing tabular particles. It is preferable that the average particle diameter of the non-tabular particles is greater than the thickness of the back coat layer by 0.1 μm or greater.

The average particle diameter of the non-tabular particles is 0.1 μm or greater, preferably 0.3-30 μm, more preferably 0.5-15 μm, and particularly preferably 1-10 μm. In a case where the average particle diameter thereof is in the above-described range, a spacer function can be sufficiently exhibited, the particles are easily fixed to the back coat layer, and an excellent holding function with respect to contact stress from the outside is exhibited.

In the present invention, the average particle diameter of the non-tabular particles indicates the volume average particle diameter which has been typically used, and such a volume average particle diameter can be measured using a laser diffraction scattering particle size distribution meter. Examples of the measuring device include a particle size distribution measuring device "Microtrac MT-3300II" (manufactured by Nikkiso Co., Ltd.).

It is preferable that the average particle diameter of the particles other than the tabular particles is greater than the thickness of the layer containing tabular particles.

The content of the non-tabular particles in the layer containing tabular particles is preferably 5-1000 $mg/m^2$, more preferably 10-500 $mg/m^2$, and still more preferably 20-300 $mg/m^2$.

The thickness of the layer containing tabular particles is preferably 0.01-30 μm, more preferably 0.1-10 μm, and still more preferably 0.2-5 μm. Here, it is preferable that the thickness of the back coat layer is smaller than the average particle diameter of the non-tabular particles which can be contained in the back coat layer.

The thickness of the back coat layer can be measured by coating a smooth aluminum support which has not been subjected to a surface treatment with a back coat layer coating solution, observing the cross section thereof using a scanning electron microscope (SEM), measuring the film thicknesses of five sites in smooth regions where particles are not present, and acquiring the average value of the obtained thicknesses.

The arithmetic average height Sa of the layer containing tabular particles is preferably 0.1-20 μm, more preferably 0.3-15 μm, and still more preferably 0.5-10 μm.

In the present invention, the arithmetic average height Sa is measured in conformity with the method described in ISO 25178. That is, three or more sites are selected from the same sample using MICROMAP MM3200-M100 (manufactured by Mitsubishi Chemical Systems, Inc.), the heights thereof are measured, and the average value thereof is set as the arithmetic average height Sa. As the measurement range, a range with a size of 1 cm × 1 cm randomly selected from the sample surface is measured.

The back coat layer can be produced by adjusting the metal oxide and fine particles and a back coat layer coating solution containing other additives as necessary, coating the support with the back coat layer coating solution, and drying the support. The support is coated with the back coat layer according to a known coating method such as bar coater coating. The support is preferably dried at 50-200°C for approximately 10 seconds to 5 minutes.

[Printing plate precursor]

The present printing plate precursor includes a layer containing a polymer on a printing surface side.

Hereinafter, a preferred embodiment of the present planographic printing plate precursor will be described.

[Planographic printing plate precursor]

The present planographic printing plate precursor has an image recording layer on a support. The image recording layer of the planographic printing plate precursor corresponds to the layer containing a polymer in the printing plate precursor. The image recording layer of the planographic printing plate precursor may have an undercoat layer between the support and the image recording layer and a protective layer on the image recording layer as necessary.

[Image recording layer]

According to one preferred embodiment, the image recording layer is an image recording layer of which a non-image area is removed by at least one of acidic to alkaline dampening water or printing ink on a printing press.

According to one embodiment, the image recording layer is an image recording layer (hereinafter, also referred to as an image recording layer A) that contains an infrared absorbent, a polymerization initiator, a polymerizable compound, and a binder polymer.

According to another embodiment, the image recording layer is an image recording layer (hereinafter, also referred to as an image recording layer B) that contains an infrared absorbent, a polymerization initiator, a polymerizable compound, and a polymer compound having a particle shape.

According to still another embodiment, the image recording layer is an image recording layer (hereinafter, also referred to as an image recording layer C) that contains an infrared absorbent and thermoplastic polymer particles.

(Image recording layer A)

The image recording layer A contains an infrared absorbent, a polymerization initiator, a polymerizable compound, and a binder polymer. Hereinafter, the constituent components of the image recording layer A will be described.

<Infrared absorbent>

An infrared absorbent has a function of converting absorbed infrared rays into heat, a function of electron transfer to a polymerization initiator described below through excitation by infrared rays, and/or a function of energy transfer thereto. As the infrared absorbent used in the present invention, a dye or a pigment having maximum absorption at a wavelength of 760-1,200 nm is preferable and a dye is more preferable.

As the dye, dyes described in paragraphs 0082-0088 of JP-A-2014-104631 can be used.

The particle diameter of the pigment is preferably 0.01-1 μm and more preferably 0.01-0.5 μm. A known dispersion technique used to produce inks or toners can be used for dispersion of the pigment. The details are described in e.g. "Latest Pigment Application Technology" (CMC Publishing Co., Ltd., published in 1986).

The infrared absorbent may be used alone or in combination of two or more kinds thereof.

The content of the infrared absorbent is preferably 0.05-30 parts by mass (pbm), more preferably 0.1-20 pbm, and particularly preferably 0.2-10 pbm with respect to 100 pbm of the total solid content of the image recording layer.

<Polymerization initiator>

The polymerization initiator indicates a compound that initiates and promotes polymerization of a polymerizable compound. As the polymerization initiator, a known thermal polymerization initiator, a compound having a bond with small bond dissociation energy, or a photopolymerization initiator can be used. Specifically, radical polymerization initiators described in paragraphs 0092-0106 of JP-A-2014-104631 can be used.

Preferred examples of compounds in the polymerization initiators include onium salts such as iodonium salts and sulfonium salts. Specific preferred examples of the compounds in each of the salts are the compounds described in paragraphs 0104-0106 of JP-A-2014-104631.

The content of the polymerization initiator is preferably 0.1-50 mass%, more preferably 0.5-30 mass%, and particularly preferably 0.8-20 mass% with respect to the total solid content of the image recording layer. In a case where the content thereof is in the above-described range, improved sensitivity and improved stain resistance of a non-image area at the time of printing are obtained.

<Polymerizable compound>

A polymerizable compound is an addition polymerizable compound having at least one ethylenically unsaturated double bond and is selected from compounds having at least one and preferably two or more terminal ethylenically unsaturated bonds. These have chemical forms such as a monomer, a pre-polymer, that is, a dimer, a trimer, an oligomer, and a mixture of these. Specifically, polymerizable compounds described in paragraphs 0109-0113 of JP-A-2014-104631 can be used.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable.

The details of the structures of these polymerizable compounds, whether to be used alone or in combination, and the usage method such as the addition amount can be arbitrarily set according to the final performance design of a planographic printing plate precursor. The content of the above-described polymerizable compound to be used is preferably 5-75 mass%, more preferably 10-70 mass%, and particularly preferably 15-60 mass% with respect to the total solid content of the image recording layer.

<Binder polymer>

A binder polymer can be mainly used to improve the film hardness of the image recording layer. As the binder polymer, known polymers of the related art can be used and polymers having coated-film properties are preferable. Among examples thereof, an acrylic resin, a polyvinyl acetal resin, and a polyurethane resin are preferable.

Preferred examples of the binder polymers include polymers having a cross-linking functional group in the main chain or side chain, preferably in the side chain, for improving coated-film hardness of an image area as described in JP-A-2008-195018. Cross-linking occurs between polymer molecules by a cross-linking group so that curing is promoted.

Preferred examples of the cross-linking functional group include an ethylenically unsaturated group such as (meth)acryl, vinyl, allyl or styryl and epoxy, and the cross-linking functional group can be introduced into a polymer by a polymer reaction or copolymerization. For example, a reaction between an acrylic polymer having a carboxy group in the side chain thereof or polyurethane and glycidyl methacrylate or a reaction between a polymer having an epoxy group and ethylenically unsaturated group-containing carboxylic acid such as methacrylic acid can be used.

The content of the cross-linking group in the binder polymer is preferably 0.1-10.0 mmol, more preferably 0.25-7.0 mmol, and particularly preferably 0.5-5.5 mmol with respect to 1 g of the binder polymer.

Moreover, it is preferable that the binder polymer includes a hydrophilic group. The hydrophilic group contributes to imparting on-press developability to the image recording layer. Particularly, in the coexistence of a cross-linking group and a hydrophilic group, both of printing durability and on-press developability can be achieved.

Examples of the hydrophilic group include hydroxy, carboxy, an alkylene oxide structure, amino, ammonium, amide, sulfo and phosphoric acid. Among these, an alkylene oxide structure having 1-9 alkylene oxide units having 2 or 3 carbon atoms is preferable. A monomer having a hydrophilic group may be copolymerized in order to impart a hydrophilic group to a binder polymer.

In addition, to control the impressing property, a lipophilic group such as alkyl, aryl, aralkyl or alkenyl can be introduced into the binder polymer. For example, a lipophilic group-containing monomer such as methacrylic acid alkyl ester may be copolymerized.

The mass average molecular weight (Mw) of the binder polymer is preferably 2,000 or greater, more preferably 5,000 or greater, and still more preferably 10,000-300,000.

The content of the binder polymer is practically 3-90 mass%, preferably 5-80 mass%, and more preferably 10-70 mass% with respect to the total solid content of the image recording layer.

As a preferred example of the binder polymer, a polymer compound having a polyoxyalkylene chain in the side chain is exemplified. In a case where the image recording layer contains a polymer compound having a polyoxyalkylene chain in the side chain (hereinafter, also referred to as a POA chain-containing polymer compound), permeability of dampening water is promoted and on-press developability is improved.

Examples of the resin constituting the main chain of the POA chain-containing polymer compound include an acrylic resin, a polyvinyl acetal resin, a polyurethane resin, a polyurea resin, a polyimide resin, a polyamide resin, an epoxy resin, a methacrylic resin, a polystyrene resin, a novolac type phenolic resin, a polyester resin, synthetic rubber, and natural rubber. Among these, an acrylic resin is particularly preferable.

The POA chain-containing polymer compound does not substantially contain a perfluoroalkyl group. The expression "does not substantially contain a perfluoroalkyl group" means that the mass ratio of a fluorine atom present as a perfluoroalkyl group in a polymer compound is less than 0.5 mass%, and it is preferable that the polymer compound does not contain a fluorine atom. The mass ratio of the fluorine atom is measured by an elemental analysis method.

In addition, the "perfluoroalkyl group" is a group in which all hydrogen atoms of the alkyl group are substituted with fluorine atoms.

As alkyleneoxide (oxyalkylene) in a polyoxyalkylene chain, alkylene oxide having 2-6 carbon atoms is preferable, ethyleneoxide (oxyethylene) or propyleneoxide (oxypropylene) is more preferable, and ethyleneoxide is still more preferable.

The repetition number of the alkyleneoxide in a polyoxyalkylene chain, that is, a poly(alkyleneoxide) moiety is preferably 2-50 and more preferably 4-25.

In a case where the repetition number of the alkyleneoxide is 2 or greater, the permeability of dampening water is sufficiently improved. Further, from the viewpoint that printing durability is not degraded due to abrasion, it is preferable that the repetition number thereof is 50 or less.

As the poly(alkyleneoxide) moiety, structures described in paragraphs 0060-0062 of JP-A-2014-104631 are preferable.

The POA chain-containing polymer compound may have cross-linking properties in order to improve coated-film hardness of an image area. Examples of the POA chain-containing polymer compounds having cross-linking properties are described in paragraphs 0063-0072 of JP-A-2014-104631.

The proportion of repeating units having a poly(alkyleneoxide) moiety in the total repeating units constituting the POA chain-containing polymer compound is not particularly limited, but is preferably 0.5-80 mol% and more preferably

0.5-50 mol%. Specific examples of the POA chain-containing polymer compounds are described in paragraphs 0075 and 0076 of JP-A-2014-104631.

As the POA chain-containing polymer compound, hydrophilic polymer compounds such as polyacrylic acid and polyvinyl alcohol described in JP-A-008-195018 can be used in combination as necessary. Further, a lipophilic polymer compound and a hydrophilic polymer compound can be used in combination.

In addition to the presence of the POA chain-containing polymer compound in the image recording layer as a binder that has a function of connecting image recording layer components with each other, the specific polymer compound may be present in the form of particles. In a case where the specific polymer compound is present in the form of particles, the average particle diameter is 10-1,000 nm, preferably 20-300 nm, and particularly preferably 30-120 nm.

The content of the POA chain-containing polymer compound is preferably 3-90 mass% and more preferably 5-80 mass% with respect to the total solid content of the image recording layer. In a case where the content thereof is in the range of 3-90 mass%, both of permeability of dampening water and image formability can be reliably achieved.

Other preferred examples of the binder polymer include a polymer compound (hereinafter, also referred to as a "star type polymer compound") which has a polymer chain bonded to a nucleus through a sulfide bond by means of using a polyfunctional, hexa- to deca-functional, thiol as the nucleus and in which the polymer chain has a polymerizable group. As the star type polymer compound, for example, compounds described in JP2012-148555A can be preferably used.

Examples of the star type polymer compound include compounds having a polymerizable group such as an ethylenically unsaturated bond in the main chain or in the side chain, preferably in the side chain, for improving coated-film hardness of an image area as described in JP2008-195018A. Cross-linking occurs between polymer molecules by a polymerizable group so that curing is promoted.

Preferred examples of the polymerizable group include an ethylenically unsaturated group such as (meth)acryl, vinyl, allyl or styryl and epoxy. Among these, from the viewpoint of polymerization reactivity, (meth)acryl, vinyl or styryl is more preferable and (meth)acryl is particularly preferable. These groups can be introduced into a polymer by a polymer reaction or copolymerization. For example, a reaction between a polymer having a carboxy group in the side chain thereof and glycidyl methacrylate or a reaction between a polymer having an epoxy group and ethylenically unsaturated group-containing carboxylic acid such as methacrylic acid can be used. These groups may be used in combination.

The content of the cross-linking group in the star type polymer compound is preferably 0.1-10.0 mmol, more preferably 0.25-7.0 mmol, and most preferably 0.5-5.5 mmol with respect to 1 g of the star type polymer compound.

Moreover, it is preferable that the star type polymer compound further includes a hydrophilic group. The hydrophilic group contributes to imparting on-press developability to the image recording layer. Particularly, in the coexistence of a polymerizable group and a hydrophilic group, both of printing durability and developability can be achieved.

Examples of the hydrophilic group include $-SO_3M^1$, -OH, $-CONR^1R^2$ ($M^1$ is H, a metal ion, an ammonium ion, or a phosphonium ion, $R^1$ and $R^2$ each independently are H, alkyl, alkenyl or aryl, and $R^1$ and $R^2$ may be bonded to each other to form a ring), $-N+R^3R^4R^5X^-$($R^3$-$R^5$ each independently represent an $C_{1-8}$-alkyl and $X^-$ is a counter anion), a group of Formula (1), and a group of Formula (2).

$-(CH_2CH_2O)_nR$ formula (1)

$-(C_3H_6O)_mR$ formula (2)

In the above-described formulae, n and m each independently represent an integer of 1-100 and R's each independently represent a hydrogen atom or an alkyl group having 1-18 carbon atoms.

Here, in a case where the star type polymer compound is a star type polymer compound having a polyoxyalkylene chain (for example, a group of the above-described Formula (1) or (2)) in the side chain, such a star type polymer compound is a polymer compound having the above-described polyoxyalkylene chain in the side chain.

Among these hydrophilic groups, $-CONR^1R^2$, groups of Formula (1), and groups of Formula (2) are preferable, $-CONR^1R^2$ and groups of Formula (1) are more preferable, and groups of Formula (1) are particularly preferable. Among the groups of Formula (1), n is preferably 1-10 and particularly preferably 1-4. Further, R is more preferably H or $C_{1-4}$-alkyl and particularly preferably H or methyl. These hydrophilic groups may be used in combination of two or more kinds thereof.

Further, it is preferable that the star type polymer compound does not substantially include a carboxylic acid group, a phosphoric acid group, or a phosphonic acid group. Specifically, the amount of these acid groups is preferably less than 0.1 mmol/g, more preferably less than 0.05 mmol/g, and particularly preferably 0.03 mmol/g or less. In a case where the amount of these acid groups is less than 0.1 mmol/g, developability is further improved.

In order to control impressing property, a lipophilic group such as alkyl, aryl, aralkyl or alkenyl can be introduced into the star type polymer compound. Specifically, a lipophilic group-containing monomer such as methacrylic acid alkyl ester may be copolymerized.

Specific examples of the star type polymer compound include compounds described in paragraphs 0153-0157

of JP-A-2014-104631.

The star type polymer compound can be synthesized, using a known method, by performing radical polymerization on the above-described monomers constituting a polymer chain in the presence of the above-described polyfunctional thiol compound.

The mass average molecular weight of the star type polymer compound is preferably 5,000-500,000, more preferably 10,000-250,000, and particularly preferably 20,000-150,000. In a case where the mass average molecular weight thereof is in the above-described range, the on-press developability and the printing durability are more improved.

The star type polymer compound may be used alone or in combination of two or more kinds thereof. Further, the star type polymer compound may be used in combination with a typical linear binder polymer.

The content of the star type polymer compound is preferably 5-95 mass%, more preferably 10-90 mass%, and particularly preferably 15-85 mass% with respect to the total solid content of the image recording layer.

From the viewpoint of promoting the permeability of dampening water and improving the on-press developability, star type polymer compounds described in JP-A-2012-148555 are particularly preferable.

<Other components>

The image recording layer A can contain other components described below as necessary.

(1) Low-molecular weight hydrophilic compound

In order to improve the on-press developability without degrading the printing durability, the image recording layer may contain a low-molecular weight hydrophilic compound.

As the low-molecular weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

Among these, it is preferable that the image recording layer contains at least one selected from the group consisting of polyols, organic sulfates, organic sulfonates, and betaines.

Specific examples of the compounds of the organic sulfonates include compounds described in paragraphs 0026-0031 of JP-A-2007-276454 and paragraphs 0020-0047 of JP-A-2009-154525. The salt may be potassium salt or lithium salt.

Examples of the organic sulfates include compounds described in paragraphs 0034-0038 of JP-A-2007-276454.

As betaines, compounds having 1-5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular weight hydrophilic compound has a small structure of a hydrophobic portion, hydrophobicity or coated-film hardness of an image area is not degraded by dampening water permeating into an image recording layer exposed area (image area) and ink receptivity or printing durability of the image recording layer can be maintained satisfactorily.

The amount of the low-molecular weight hydrophilic compounds to be added to the image recording layer is preferably 0.5-20 mass% with respect to the total solid content of the image recording layer. The amount thereof is more preferably 1-15 mass% and still more preferably 2-10 mass%. In a case where the amount thereof is in the above-described range, excellent on-press developability and printing durability can be obtained.

These compounds may be used alone or in combination of two or more kinds thereof.

(2) Oil sensitizing agent

In order to improve the impressing property, an oil sensitizing agent such as a phosphonium compound, a nitrogen-containing low-molecular weight compound, or an ammonium group-containing polymer can be used for the image recording layer. Particularly, in a case where a protective layer contains an inorganic layered compound, the above-described compounds function as a surface coating agent of the inorganic layered compound and prevent a

degradation in impressing property due to the inorganic layered compound during the printing.

The phosphonium compound, the nitrogen-containing low-molecular weight compound, and the ammonium group-containing polymer are described in paragraphs 0184-0190 of JP-A-2014-104631 in detail.

The content of the oil sensitizing agent is preferably 0.01-30.0 mass%, more preferably 0.1-15.0 mass%, and still more preferably 1-10 mass% with respect to the total solid content of the image recording layer.

(3) Others

The image recording layer may further contain other components such as a surfactant, a coloring agent, a printing-out agent, a polymerization inhibitor, a higher fatty acid derivative, a plasticizer, inorganic particles, an inorganic layered compound, a co-sensitizer, and a chain transfer agent. Specifically, the compounds and the addition amounts described in paragraphs 0114-0159 of JP-A-2008-284817, paragraphs 0023-0027 of JP-A-2006-091479 and paragraph 0060 of US-A-2008/0311520 can be preferably used.

<Formation of image recording layer A>

The image recording layer A is formed by dispersing or dissolving each of the above-described required components in a known solvent to prepare a coating solution, coating a support with the coating solution directly or through an undercoat layer using a known method such as a bar coater coating method, and drying the resultant, as described in paragraphs 0142 and 0143 of JP-A-2008-195018. The coating amount of the image recording layer (solid content) on the support to be obtained after the coating and the drying varies depending on the applications thereof, but is preferably 0.3-3.0 $g/m^2$. In a case where the coating amount thereof is in the above-described range, excellent sensitivity and excellent film-coating characteristics of the image recording layer are obtained.

(Image recording layer B)

The image recording layer B contains an infrared absorbent, a polymerization initiator, a polymerizable compound, and a polymer compound having a particle shape. Hereinafter, the constituent components of the image recording layer B will be described.

Similarly, the infrared absorbent, the polymerization initiator, and the polymerizable compound described in the image recording layer A can be used as an infrared absorbent, a polymerization initiator, and a polymerizable compound in the image recording layer B.

<Polymer compound having particle shape>

It is preferable that the polymer compound having a particle shape is selected from thermoplastic polymer particles, thermally reactive polymer particles, polymer particles having a polymerizable group, a microcapsule encapsulating a hydrophobic compound, and a microgel (cross-linked polymer particles). Among these, polymer particles having a polymerizable group and a microgel are preferable. According to a particularly preferred embodiment, the particulate polymer compound includes at least one ethylenically unsaturated polymerizable group. Because of the presence of the polymer compound having a particle shape, effects of improving the printing durability of an exposed area and the on-press developability of an unexposed area are obtained.

Preferred examples of the thermoplastic polymer particles include thermoplastic polymer particles described in Research Disclosure No. 33303 on January, 1992, JP-A-1997-123387, JP-A-1997-131850, JP-A-1997-171249, JP-A-1997-171250 and EP-B-0931647.

Specific examples of a polymer constituting thermoplastic polymer particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, and polymethyl methacrylate are more preferable. The average particle diameter of the thermoplastic polymer particles is preferably 0.01-3.0 $\mu m$. The average particle diameter is calculated according to a laser light scattering method.

Examples of the thermally reactive polymer particles include polymer particles having a thermally reactive group. The thermally reactive polymer particles are cross-linked by a thermal reaction and have hydrophobic regions formed by a change in functional groups during the cross-linking.

As the thermally reactive group in polymer particles having a thermally reactive group, a functional group that performs any reaction may be used as long as a chemical bond is formed, but a polymerizable group is preferable. Preferred examples of the polymerizable group include an ethylenically unsaturated group that performs a radical polymerization reaction (such as acryloyl, methacryloyl, vinyl or allyl); a cationic polymerizable group (such as vinyl, vinyloxy,

epoxy or oxetanyl); an isocyanate group that performs an addition reaction or a block body thereof, epoxy, vinyloxy, and a functional group having active hydrogen atom as a reaction partner of these (such as amino, hydroxy or carboxy); a carboxy group that performs a condensation reaction and a hydroxy group or an amino group as a reaction partner thereof; and an acid anhydride that performs a ring-opening addition reaction and an amino group or a hydroxy group as a reaction partner thereof.

The microcapsule is a microcapsule in which at least a part of constituent components of the image recording layer is encapsulated as described in JP-A-2001-277740 and JP-A-2001-277742. Further, the constituent components of the image recording layer may be contained in a portion other than the microcapsule. Moreover, a preferred embodiment of the image recording layer containing the microcapsule is an embodiment in which hydrophobic constituent components are encapsulated in a microcapsule and hydrophilic constituent components are contained in a portion other than the microcapsule.

The microgel (cross-linked polymer particles) may contain a part of the constituent components of the image recording layer in at least one of the surface or the inside of the microgel. From the viewpoints of image forming sensitivity and printing durability, a reactive microgel having a radical polymerizable group on the surface thereof is particularly preferable.

The constituent components of the image recording layer can be made into microcapsules or microgels using a known method.

Further, from the viewpoints of the printing durability and the solvent resistance, it is preferable that the polymer compound having a particle shape has a hydrophobic main chain and both of a constitutional unit (i) which contains a pendant-cyano group directly bonded to the hydrophobic main chain and a constitutional unit (ii) which contains a pendant group having a hydrophilic polyalkylene oxide segment.

Preferred examples of the hydrophobic main chain include an acrylic resin chain.

Preferred examples of the pendant-cyano group include $-[CH_2CH(C{=}N)-]$ and $-[CH_2C(CH_3)(C{\equiv}N)-]$.

Further, the constitutional unit having a pendant-cyano group can be easily derived from an ethylene-based unsaturated monomer such as acrylonitrile or methacrylonitrile or a combination of these.

Further, as the alkylene oxide in the hydrophilic polyalkylene oxide segment, ethylene oxide or propylene oxide is preferable and ethylene oxide is more preferable.

The repetition number of alkylene oxide structures in the hydrophilic polyalkylene oxide segment is preferably 10-100, more preferably 25-75, and still more preferably 40-50.

As the resin particles which have a hydrophobic main chain and both of a constitutional unit (i) containing a pendant-cyano group directly bonded to the hydrophobic main chain and a constitutional unit (ii) containing a pendant group having a hydrophilic polyalkylene oxide segment, those described in paragraphs 0039-0068 of JP-A-2008-503365 are preferably exemplified.

The average particle diameter of the polymer compound having a particle shape is preferably 0.01-3.0 μm, more preferably 0.03-2.0 μm, and still more preferably 0.10-1.0 μm. In a case where the average particle diameter thereof is in the above-described range, excellent resolution and temporal stability are obtained. The average particle diameter is calculated according to a laser light scattering method.

The content of the polymer compound having a particle shape is preferably 5-90 mass% with respect to the total solid content of the image recording layer.

<Other components>

The image recording layer B can contain the other components described in the above-described image recording layer A as necessary.

<Formation of image recording layer B>

The image recording layer B can be formed in the same manner as the image recording layer A described above.

(Image recording layer C)

The image recording layer C contains an infrared absorbent and thermoplastic polymer particles. Hereinafter, the constituent components of the image recording layer C will be described.

<Infrared absorbent>

The infrared absorbent contained in the image recording layer C is preferably a dye or a pigment having maximum absorption at a wavelength of 760-1,200 nm. A dye is more preferable.

As the dye, commercially available dyes and known dyes described in the literatures (for example, "Dye Handbook" edited by The Society of Synthetic Organic Chemistry, Japan, published in 1970, "Near-Infrared Absorbing Coloring agent" of "Chemical Industry", p. 45-51, published on May, 1986, and "Development and Market Trend of Functional Dyes in 1990's" Section 2.3 of Chapter 2 (CMC Publishing Co., Ltd., published in 1990)) and the patents can be used. Specific preferred examples thereof include infrared absorbing dyes such as an azo dye, a metal complex salt azo dye, a pyrazolone azo dye, an anthraquinone dye, a phthalocyanine dye, a carbonium dye, a quinone imine dye, a polymethine dye, and a cyanine dye.

Among these, infrared absorbing dyes having a water-soluble group are particularly preferable from the viewpoint of addition to the image recording layer.

Specific examples of the infrared absorbing dyes are described below, but the present invention is not limited thereto.

(IR-1)

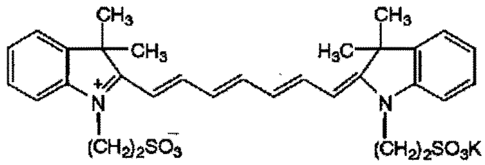

(IR-2)

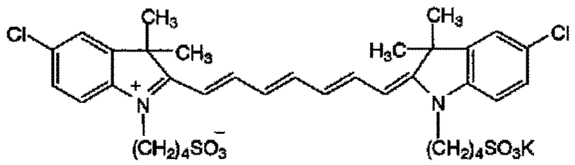

(IR-3)

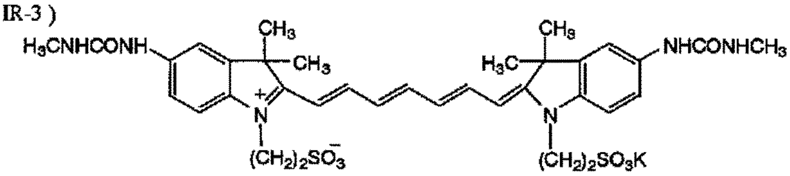

(IR-4)

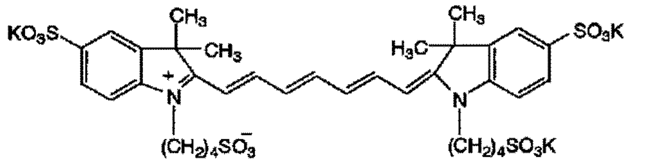

(IR-5)

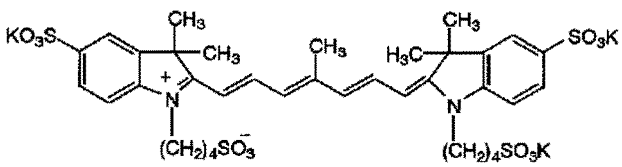

(IR-6)

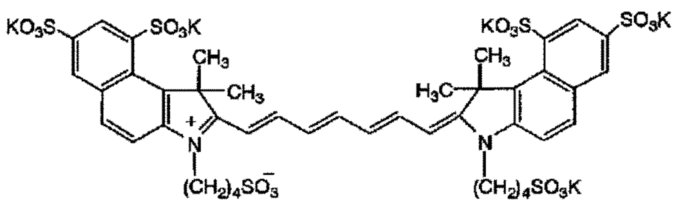

(IR-7)

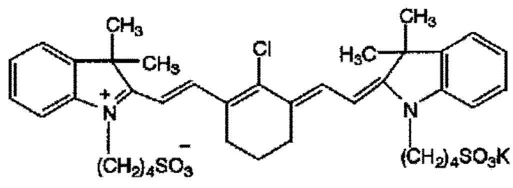

(IR-8)

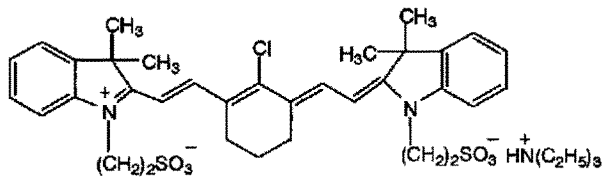

(IR-9)

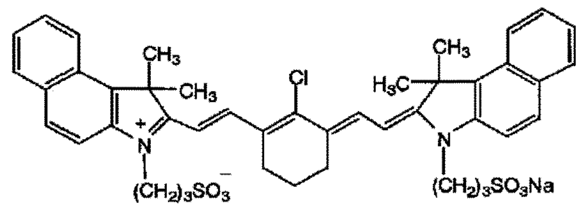

(IR-10)

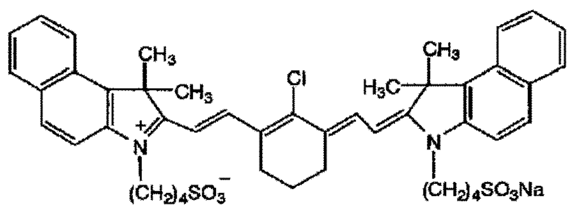

(IR-11)

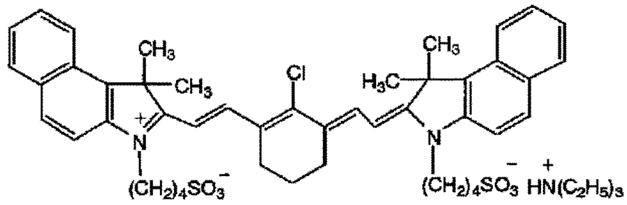

As the pigments, commercially available pigments and pigments described in Color Index (C. I.) Handbook, "Latest Pigment Handbook" (edited by Japan Pigment Technology Association, published in 1977), "Latest Pigment Application Technology" (CMC Publishing Co., Ltd., published in 1986), and "Printing Ink Technology" (CMC Publishing Co., Ltd., published in 1984) can be used.

The particle diameter of the pigment is preferably 0.01-1 μm and more preferably 0.01-0.5 μm. A known dispersion technique used to produce inks or toners can be used as a method of dispersing the pigment. The details are described in "Latest Pigment Application Technology" (CMC Publishing Co., Ltd., published in 1986).

The content of the infrared absorbent is preferably 0.1-30 mass%, more preferably 0.25-25 mass%, and particularly preferably 0.5-20 mass% with respect to the solid content of the image recording layer. In a case where the content thereof is in the above-described range, excellent sensitivity is obtained without damaging the film hardness of the image recording layer.

<Thermoplastic polymer particles>

The glass transition temperature (Tg) of the thermoplastic polymer particles is preferably 60-250°C. Tg of the thermoplastic polymer particles is more preferably 70-140°C and still more preferably 80-120°C.

Preferred examples of the thermoplastic polymer particles having a Tg of 60°C or higher include thermoplastic polymer particles described in Research Disclosure No. 33303 on January, 1992, JP-A-1997-123387, JP-A-1997-131850, JP-A-1997-171249, JP-A-1997-171250 and EP-B-0931647.

Specific examples thereof include homopolymers or copolymers formed of monomers such as ethylene, styrene, vinyl chloride, methyl acrylate, ethyl acrylate, methyl methacrylate, ethyl methacrylate, vinylidene chloride, acrylonitrile, and vinyl carbazole, and mixtures of these. Among these, polystyrene and polymethyl methacrylate are preferable.

The average particle diameter of the thermoplastic polymer particles is preferably 0.005-2.0 μm from the viewpoints of the resolution and the temporal stability. This value is used as the average particle diameter in a case where two or more kinds of thermoplastic polymer particles are mixed with each other. The average particle diameter thereof is more preferably 0.01-1.5 μm and particularly preferably 0.05-1.0 μm. The polydispersity in a case where two or more kinds of thermoplastic polymer particles are mixed with each other is preferably 0.2 or greater. The average particle diameter and the polydispersity are calculated according to a laser light scattering method.

The thermoplastic polymer particles may be used in combination of two or more kinds thereof. Specifically, at least two kinds of thermoplastic polymer particles with different particle sizes or at least two kinds of thermoplastic polymer particles with different Tg's may be exemplified. When two or more kinds of thermoplastic polymer particles are used in combination, coated-film curing properties of an image area are further improved and printing durability in a case where a planographic printing plate is obtained is further improved.

For example, in a case where thermoplastic polymer particles having the same particle size are used, voids are present between the thermoplastic polymer particles to some extent and thus the curing properties of the coated-film are not desirable in some cases even when the thermoplastic polymer particles are melted and solidified by image exposure. Meanwhile, in a case where thermoplastic polymer particles having different particle sizes are used, the void volume between the thermoplastic polymer particles can be decreased and thus the coated-film curing properties of the image area after image exposure can be improved.

Further, in a case where thermoplastic polymer particles having the same Tg are used, the thermoplastic polymer particles are not sufficiently melted and solidified in some cases when an increase in temperature of the image recording layer resulting from image exposure is insufficient, and thus the curing properties of the coated-film are not desirable. Meanwhile, in a case where thermoplastic polymer particles having different Tg's are used, the coated-film curing properties of the image area can be improved even in a case where an increase in temperature of the image recording layer resulting from image exposure is insufficient.

In a case where two or more kinds of thermoplastic polymer particles having different Tg's are used in combination, the Tg of at least one thermoplastic polymer particle is preferably 60°C or higher. At this time, a difference in Tg is preferably 10°C or higher and still more preferably 20°C or higher. In addition, it is preferable that the content of the thermoplastic polymer particles having a Tg of 60°C or higher is 70 mass% or greater with respect to the total amount of all thermoplastic polymer particles.

The thermoplastic polymer particles may include a cross-linking group. In a case where thermoplastic polymer particles having a cross-linking group are used, the cross-linking group is thermally reacted due to heat generated by an image-exposed area so as to be cross-linked between the polymers, and thus coated-film hardness of the image area is improved and printing durability becomes more excellent. As the cross-linking group, a functional group that performs any reaction may be used as long as a chemical bond is formed, and examples thereof include an ethylenically unsaturated group that performs a polymerization reaction (such as acryloyl, methacryloyl, vinyl or allyl); an isocyanate group that performs an addition reaction or a block body thereof, and a group having active hydrogen atom as a reaction partner of these (such as amino, hydroxy or carboxyl); epoxy that performs an addition reaction and amino, carboxyl or hydroxy as a reaction partner thereof; a carboxyl group that performs a condensation reaction and hydroxy or amino; and an acid anhydride that performs a ring-opening addition reaction and amino or hydroxy.

Specific examples of the thermoplastic polymer particles having a cross-linking group include thermoplastic polymer particles having a cross-linking group such as acryloyl, methacryloyl, vinyl, allyl, epoxy, amino, hydroxy, carboxyl, isocyanate, acid anhydride, and a protecting group of these. These cross-linking groups may be introduced into polymers at the time of polymerization of polymer particles or may be introduced using a polymer reaction after polymerization of the polymer particles.

In a case where a cross-linking group is introduced to a polymer at the time of polymerization of polymer particles, it is preferable that a monomer having a cross-linking group may be subjected to an emulsion polymerization or a suspension polymerization. Specific examples of the monomer having a cross-linking group include allyl methacrylate, allyl acrylate, vinyl methacrylate, vinyl acrylate, glycidyl methacrylate, glycidyl acrylate, 2-isocyanate ethyl methacrylate or a block isocyanate resulting from alcohol thereof, 2-isocyanate ethyl acrylate or a block isocyanate resulting from alcohol thereof, 2-aminoethyl methacrylate, 2-aminoethyl acrylate, 2-hydroxyethyl methacrylate, 2-hydroxyethyl acrylate, acrylic acid, methacrylic acid, maleic acid anhydride, difunctional acrylate, and difunctional methacrylate.

Examples of the polymer reaction used in a case where a cross-linking group is introduced after polymerization of polymer particles include polymer reactions described in WO96/034316A.

Polymer particles may react with each other through a cross-linking group or the thermoplastic polymer particles may react with a polymer compound or a low-molecular weight compound added to the image recording layer.

The content of the thermoplastic polymer particles is preferably 50-95 mass%, more preferably 60-90 mass%, and particularly preferably 70-85 mass% with respect to the solid content of the image recording layer.

<Other components>

The image recording layer C may further contain other components as necessary.

<Surfactant having polyoxyalkylene group or hydroxy group>

As the surfactant having a polyoxyalkylene group (hereinafter, also referred to as a "POA group") or a hydroxy group, a surfactant having a POA group or a hydroxy group may be suitably used, but an anionic surfactant or a non-ionic surfactant is preferable. Among anionic surfactants or non-ionic surfactants having a POA group or a hydroxy group, anionic surfactants or non-ionic surfactants having a POA group are preferable.

As the POA group, a polyoxyethylene group, a polyoxypropylene group, or a polyoxybutylene group is preferable and a polyoxyethylene group is particularly preferable.

The average degree of polymerization of an oxyalkylene group is practically 2-50 and preferably 2-20.

The number of hydroxy groups is practically 1-10 and preferably 2-8. Here, the number of terminal hydroxy groups in the oxyalkylene group is not included in the number of hydroxy groups.

(Anionic surfactant having POA group or hydroxy group)

The anionic surfactant having a POA group is not particularly limited, and examples thereof include polyoxyalkylene alkyl ether carboxylates, polyoxyalkylene alkyl sulfosuccinates, polyoxyalkylene alkyl ether sulfuric acid ester salts, alkyl phenoxy polyoxyalkylene propyl sulfonates, polyoxyalkylene alkyl sulfophenyl ethers, polyoxyalkylene aryl ether sulfuric acid ester salts, polyoxyalkylene polycyclic phenylether sulfuric acid ester salts, polyoxyalkylene styryl phenyl ether sulfuric acid ester salts, polyoxyalkylene alkyl ether phosphoric acid ester salts, polyoxyalkylene alkyl phenyl ether phosphoric acid ester salts, and polyoxyalkylene perfluoroalkyl ether phosphoric acid ester salts.

The anionic surfactant having a hydroxy group is not particularly limited, and examples thereof include hydroxy carboxylates, hydroxy alkyl ether carboxylates, hydroxy alkane sulfonates, fatty acid monoglyceride sulfuric acid ester salts, and fatty acid monoglyceride acid ester salts.

The content of the surfactant having a POA group or a hydroxy group is preferably 0.05-15 mass% and more preferably 0.1-10 mass% with respect to the solid content of the image recording layer.

Hereinafter, specific examples of the surfactant having a POA group or a hydroxy group will be described, but the present invention is not limited thereto. A surfactant A-12 described below is a trade name of Zonyl FSP and available from Dupont. Further, a surfactant N-11 described below is a trade name of Zonyl FSO 100 and available from Dupont.

A-1 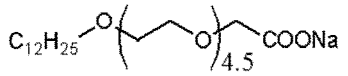

A-2 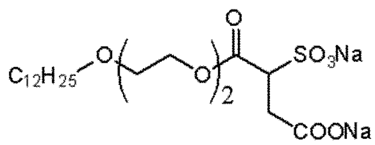

A-3 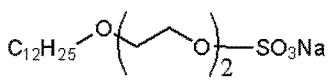

A-4 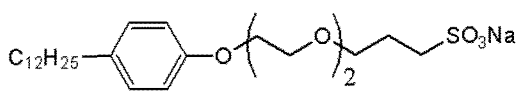

A-5 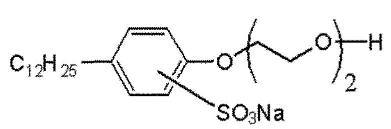

A-9 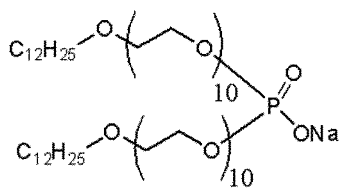

A-10 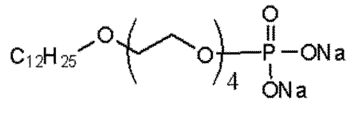

A-11 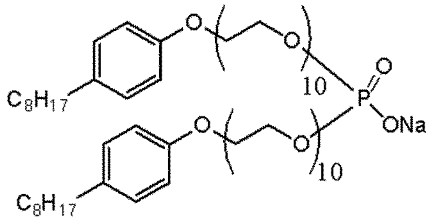

A-6
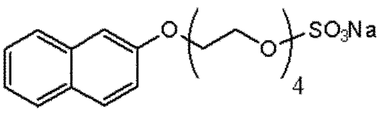

A-12
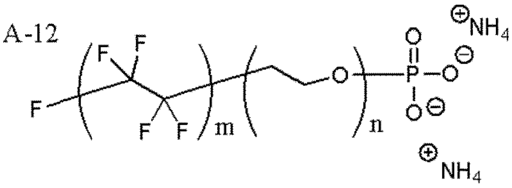

A-7
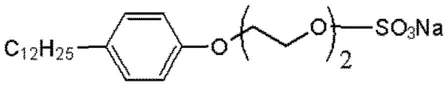

A-13
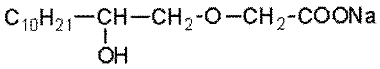

A-8
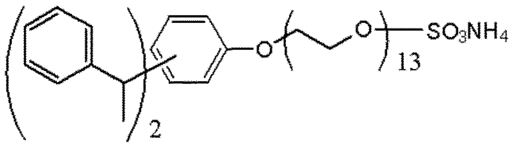

A-14
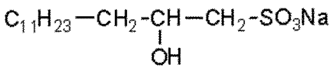

A-15
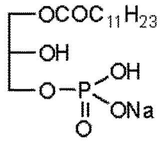

N-1
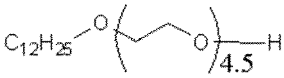

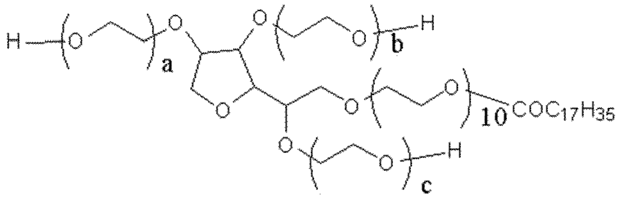

a+b+c=20

N-8

N-2
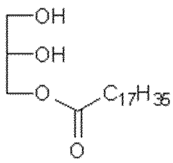

N-3
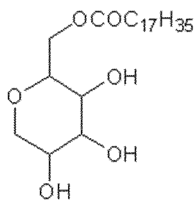

N-9
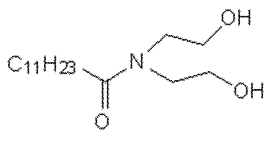

N-10
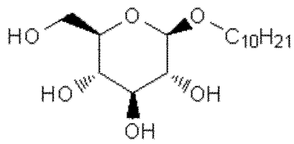

N-4
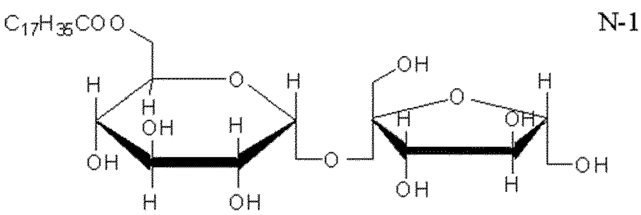

N-5
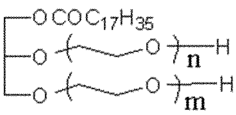

m+n=5

N-11
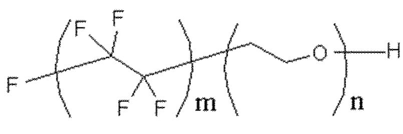

N-6 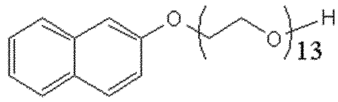

N-7 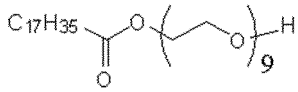

For the purpose of ensuring coating uniformity of the image recording layer, the image recording layer may contain an anionic surfactant that does not have a polyoxyalkylene group or a hydroxy group.

The anionic surfactant is not particularly limited as long as the above-described purpose is achieved. Among the examples of the anionic surfactants, alkyl benzene sulfonic acid or a salt thereof, alkyl naphthalene sulfonic acid or a salt thereof, (di)alkyl diphenyl ether (di)sulfonic acid or a salt thereof, or alkyl sulfuric acid ester salt is preferable.

The addition amount of the anionic surfactant that does not have a polyoxyalkylene group or a hydroxy group is preferably 1-50 mass% and more preferably 1-30 mass% with respect to the surfactant which has a polyoxyalkylene group or a hydroxy group.

Hereinafter, specific examples of the anionic surfactant that does not have a polyoxyalkylene group or a hydroxy group will be described, but the present invention is not limited thereto.

AA-1 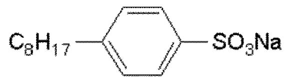

AA-2 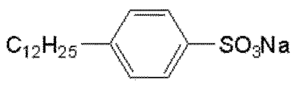

AA-3 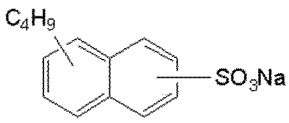

AA-4 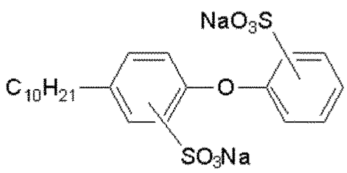

AA-5 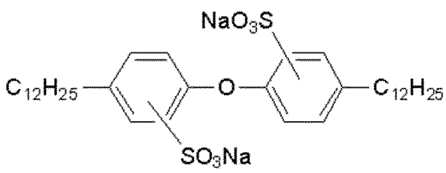

AA-6 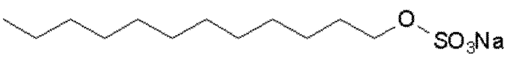

Further, for the purpose of ensuring coating uniformity of the image recording layer, a non-ionic surfactant that does not have a polyoxyalkylene group or a hydroxy group or a fluorine-based surfactant may be used. For example, fluorine-based surfactants described in JP-A-1987-170950 are preferably used.

The image recording layer may contain a hydrophilic resin. Preferred examples of the hydrophilic resin include resins having a hydrophilic group such as hydroxy, hydroxyethyl, hydroxypropyl, amino, aminoethyl, aminopropyl, carboxyl, carboxylate, sulfo, sulfonate and phosphoric acid.

Specific examples of the hydrophilic resin include gum Arabic, casein, gelatin, a starch derivative, carboxy methyl cellulose and sodium salt thereof, cellulose acetate, sodium alginate, vinyl acetate-maleic acid copolymers,

styrene-maleic acid copolymers, polyacrylic acids and salts of these, polymethacrylic acids and salts of these, a homopolymer and a copolymer of hydroxy ethyl methacrylate, a homopolymer and a copolymer of hydroxyethyl acrylate, a homopolymer and a copolymer of hydroxypropyl methacrylate, a homopolymer and a copolymer of hydroxypropyl acrylate, a homopolymer and a copolymer of hydroxybutyl methacrylate, a homopolymer and a copolymer of hydroxybutyl acrylate, polyethylene glycols, hydroxy propylene polymers, polyvinyl alcohols, hydrolyzed polyvinyl acetate having a degree of hydrolysis of at least 60% and preferably at least 80%, polyvinyl formal, polyvinyl butyral, polyvinyl pyrrolidone, a homopolymer and a copolymer of acrylamide, a homopolymer and a copolymer of methacrylamide, and a homopolymer and a copolymer of N-methylol acrylamide.

The mass average molecular weight of the hydrophilic resin is preferably 2,000 or greater from the viewpoints of obtaining sufficient coated-film hardness or printing durability.

The content of the hydrophilic resin is preferably 0.5-50 mass% and more preferably 1-30 mass% with respect to the solid content of the image recording layer.

The image recording layer may contain inorganic particles. Preferred examples of the inorganic particles include silica, alumina, magnesium oxide, titanium oxide, magnesium carbonate, calcium alginate, and a mixture of these. The inorganic particles can be used for the purpose of improving coated-film hardness.

The average particle diameter of the inorganic particles is preferably 5 nm to 10 $\mu$m and more preferably 10 nm to 1 $\mu$m. In a case where the average particle diameter thereof is in the above-described range, the thermoplastic polymer particles are stably dispersed, the film hardness of the image recording layer is sufficiently held, and a non-image area with excellent hydrophilicity in which printing stain is unlikely to occur can be formed.

The inorganic particles are available as commercial products such as a colloidal silica dispersion.

The content of the inorganic particles is preferably 1.0 -70 mass% and more preferably 5.0-50 mass% with respect to the solid content of the image recording layer.

The image recording layer may contain a plasticizer in order to impart e.g. flexibility to a coated film. Examples of the plasticizer include polyethylene glycol, tributyl citrate, diethyl phthalate, dibutyl phthalate, dihexyl phthalate, dioctyl phthalate, tricresyl phosphate, tributyl phosphate, trioctyl phosphate, and tetrahydrofurfuryl oleate.

The content of the plasticizer is preferably 0.1-50 mass% and more preferably 1-30 mass% with respect to the solid content of the image recording layer.

In a case where polymer particles having a thermally reactive functional group (cross-linking group) are used for the image recording layer, a compound that initiates or promotes a reaction of the thermally reactive functional group (cross-linking group) can be added to the image recording layer as necessary. As the compound that initiates or promotes a reaction of the thermally reactive functional group, a compound that generates a radical or a cation by heating may be exemplified. Examples of the compound include a lophine dimer, a trihalomethyl compound, a peroxide, an azo compound, onium salts including diazonium salts and diphenyl iodonium salts, acyl phosphine, and imide sulfonate. The amount of the compound to be added to the image recording layer is preferably 1-20 mass% and more preferably 1-10 mass% with respect to the solid content of the image recording layer. In a case where the amount thereof is in the above-described range, on-press developability is not degraded and excellent effects for initiating or promoting a reaction are obtained.

<Formation of image recording layer C>

The image recording layer C is formed by dissolving or dispersing each of the above-described required components in a suitable solvent to prepare a coating solution, coating a support with the coating solution directly or through an undercoat layer. As the solvent, water or a mixed solvent of water and an organic solvent is used, and a mixed solvent of water and an organic solvent is preferable from the viewpoint of the excellent surface state after coating. Since the amount of the organic solvent varies depending on the type of organic solvent, the amount thereof cannot be specified unconditionally, but the amount of the organic solvent in the mixed solvent is preferably 5-50 vol.%. Here, it is necessary that the amount of the organic solvent to be used is set to such that the thermoplastic polymer particles are not aggregated. The concentration of solid contents of the image recording layer coating solution is preferably 1-50 mass%.

As the organic solvent used as a solvent of the coating solution, a water-soluble organic solvent is preferable. Specific examples thereof include alcohol solvents such as methanol, ethanol, propanol, isopropanol, or 1-methoxy-2-propanol, ketone solvents such as acetone or methyl ethyl ketone, glycol ether solvents such as ethylene glycol dimethyl ether, $\gamma$-butyrolactone, N,N-dimethylformamide, N,N-dimethylacetamide, tetrahydrofuran, and dimethylsulfoxide. Particularly, an organic solvent having a boiling point of 120°C or lower and a solubility (amount of a solvent to be dissolved in 100 g of water) of 10 g or greater in water is preferable and an organic solvent having a solubility of 20 g or greater is more preferable.

As a coating method of the image recording layer coating solution, various methods can be used. Examples of the methods include a bar coater coating method, a rotary coating method, a spray coating method, a curtain coating method, a dip coating method, an air knife coating method, a blade coating method, and a roll coating method. The

coating amount (solid content) of the image recording layer on the support obtained after the coating and the drying varies depending on the applications thereof, but is preferably 0.5-5.0 g/$m^2$ and more preferably 0.5-2.0 g/$m^2$.

The image recording layer of the planographic printing plate precursor according to the present invention may be an image recording layer of which non-image area is removed by a developer. Such an image recording layer includes image recording layers of many planographic printing plate precursors known as a so-called development treatment type planographic printing plate precursor.

According to one embodiment of the image recording layer to be removed by a developer, the image recording layer may be a negative type image recording layer containing a sensitizing dye, a polymerization initiator, a polymerizable compound, and a binder polymer. Such a negative type image recording layer is described as a "recording layer" in paragraphs 0057-0154 of JP2008-015503A.

According to one embodiment of the image recording layer to be removed by a developer, the image recording layer is a positive type image recording layer containing a water-insoluble and alkali-soluble resin and an infrared absorbent. Such a positive type image recording layer is described as a "recording layer" in paragraphs 0055-0132 of JP2007-148940A.

Hereinafter, other constituent elements of the planographic printing plate precursor will be described.

[Undercoat layer]

The planographic printing plate precursor may be provided with an undercoat layer between the image recording layer and the support as necessary. Since intimate attachment of the support to the image recording layer becomes stronger in an exposed area and the support is easily peeled off from the image recording layer in an unexposed area, the undercoat layer contributes to improvement of on-press developability without degrading printing durability. Further, in a case of infrared laser exposure, the undercoat layer functions as a heat insulating layer so that a degradation in sensitivity due to heat, generated by the exposure, being diffused in the support is prevented.

Examples of the compound used for the undercoat layer include a silane coupling agent having an ethylenic double bond reactive group, which is an addition-polymerizable group, described in JP-A-1998-282679; and a phosphorus compound having an ethylenic double bond reactive group described in JP-A-1990-304441. Preferred examples thereof include polymer compounds having an adsorptive group, which can be adsorbed to the surface of the support, a hydrophilic group, and a cross-linking group, as described in JP-A-2005-125749 and JP-A-2006-188038. As such a polymer compound, a copolymer of a monomer having an adsorptive group, a monomer having a hydrophilic group, and a monomer having a cross-linking group is preferable. Specific examples thereof include a copolymer of a monomer having an adsorptive group such as a phenolic hydroxy group, a carboxy group, $-PO_3H_2$, $-OPO_3H_2$, $-CONHSO_2-$, $-SO_2NHSO_2-$, or $-COCH_2COCH_3$, a monomer having a hydrophilic group such as a sulfo group, and a monomer having a polymerizable cross-linking group such as a methacryl group or an allyl group. The polymer compound may have a cross-linking group introduced by forming salts between a polar substituent of the polymer compound and a compound that includes a substituent having the opposite charge of the polar substituent and an ethylenically unsaturated bond. Further, monomers other than the above-described monomers, preferably hydrophilic monomers may be further copolymerized.

The content of the unsaturated double bond in the polymer compound for an undercoat layer is preferably 0.1-10.0 mmol and more preferably 2.0-5.5 mmol with respect to 1 g of the polymer compound.

The mass average molecular weight of the polymer compound for an undercoat layer is preferably 5,000 or greater and more preferably 10,000-300,000.

For the purpose of preventing stain over time, the undercoat layer may contain e.g. a chelating agent, a secondary or tertiary amine, a polymerization inhibitor, and a compound that includes an amino group or a functional group having polymerization inhibiting ability and a group interacting with the surface of an aluminum support (for example, 1,4-diazabicyclo[2,2,2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) in addition to the compounds for an undercoat layer described above.

The undercoat layer is applied according to a known method. The coating amount (solid content) of the undercoat layer is preferably 0.1-100 mg/$m^2$ and more preferably 1-30 mg/$m^2$.

[Support]

A known support is used as the support of the planographic printing plate precursor. Among examples of the known support, an aluminum plate subjected to a roughening treatment and an anodizing treatment using a known method is preferable.

The aluminum plate can be subjected to a treatment appropriately selected from an expansion treatment or a sealing treatment of micropores of an anodized film described in JP-A-2001-253181 or JP-A-2001-322365 or a surface hydrophilization treatment using alkali metal silicate described in US 2,714,066, US 3,181,461, US 3,280,734 and US

3,902,734 or polyvinyl phosphonic acid described in US 3,276,868, US 4,153,461 and US 4,689,272 as necessary.

The center line average roughness of the support is preferably 0.10-1.2 μm.

The rear surface of the support may be provided with an organic polymer compound described in JP-A-1993-045885 and a back coat layer containing an alkoxy compound of silicon described in JP-A-1994-035174 as necessary.

[Protective layer]

A protective layer may be provided on the image recording layer of the planographic printing plate precursor as necessary. The protective layer has a function of preventing generation of damage to the image recording layer and a function of preventing ablation at the time of high illuminance laser exposure, in addition to a function of suppressing a reaction of inhibiting image formation through oxygen blocking.

As the protective layer having such functions, a protective layer described in paragraphs 0202-0204 of JP-A-2014-104631 can be used.

The protective layer is applied according to a known method. The coating amount of the protective layer after the drying is preferably 0.01-10 g/$m^2$, more preferably 0.02-3 g/$m^2$, and particularly preferably 0.02-1 g/$m^2$.

The planographic printing plate precursor can be produced by applying a coating solution of each configuration layer according to a typical method, performing drying, and forming each configuration layer. The coating solution can be applied according to a die coating method, a dip coating method, an air knife coating method, a curtain coating method, a roller coating method, a wire bar coating method, a gravure coating method, or a slide coating method.

Hereinafter, a printing key plate precursor which is another preferred embodiment of the printing plate precursor will be described.

The printing key plate precursor is a precursor for producing a printing key plate by performing the same plate-making step (here, image exposure is not performed) as that for the planographic printing plate precursor and basically does not have photosensitivity. As well-known in the printing industry, the printing key plate is used by being attached to a plate cylinder in a case where it is necessary to print a part of the paper surface with two colors or one color in color newspaper printing (multicolor printing).

[Printing key plate precursor]

The present printing key plate precursor includes a non-photosensitive layer on a side (referred to as a "printing surface side" herein) of the support to which ink and dampening water are supplied during printing. The non-photosensitive layer in the printing key plate precursor corresponds to the layer containing a polymer in the printing plate precursor. The printing key plate precursor may include an undercoat layer between the support and the non-photosensitive layer and a hydrophilic layer on the non-photosensitive layer as necessary.

It is preferable that the non-photosensitive layer in the printing key plate precursor contains a water-soluble binder polymer or a water-insoluble and alkali-soluble binder polymer (hereinafter, also referred to as a "binder polymer"). Further, the non-photosensitive layer may contain a colorant having maximum absorption at a wavelength of 350-550 nm and a low-molecular-weight acidic compound.

The binder contained in the non-photosensitive layer of the printing key plate precursor is described in, for example, paragraphs 0069-0074 of JP-A-2012-218778.

The non-photosensitive layer of the printing key plate precursor and the method of forming the same are described in, for example, paragraphs 0021-0054 of JP-A-2012-218778.

The hydrophilic layer of the printing key plate precursor contains a binder.

The hydrophilic layer can be formed by coating the non-photosensitive layer with a hydrophilic layer coating solution prepared by mixing a binder and various additives such as a colorant, a water-soluble plasticizer, and a surfactant to be added depending on the purpose thereof and stirring the solution according to a method described in, for example, US 3,458,311 or JP-A-1980-049729. The coating amount of the hydrophilic layer is preferably 0.2-5.0 g/$m^2$ and more preferably 0.3-3.0 g/$m^2$.

The binder contained in the hydrophilic layer of the printing key plate precursor is described in, for example, paragraphs 0069-0074 of JP-A-2012-218778.

The plate-making of the present printing plate precursor will be described below. The plate-making of the present printing plate precursor basically includes an image exposure step and a development treatment step. In the present printing plate precursor, the development treatment step is performed without performing the image exposure step in a case of the printing key plate precursor.

[Image exposure step]

The image exposure of the planographic printing plate precursor can be performed in conformity with an image exposure operation for a typical planographic printing plate precursor.

The image exposure is performed by laser exposure through a transparent original picture having e.g. a line image or a halftone image or by laser beam scanning using digital data. The wavelength of a light source is preferably 700-1,400 nm. As the light source having a wavelength of 700-1,400 nm, a solid-state laser or a semiconductor laser that radiates infrared rays is preferable. The output of the infrared laser is preferably 100 mW or greater, the exposure time per one pixel is preferably less than 20 microseconds, and the irradiation energy quantity is preferably 10-300 $mJ/cm^2$. For the purpose of reducing the exposure time, it is preferable to use a multi-beam laser device. The exposure mechanism may be any of e.g. an internal drum system, an external drum system and a flat bed system. The image exposure can be performed using a plate setter according to a usual method.

[Development treatment step]

The development treatment can be performed using a typical method. In a case of on-press development, a printing ink receiving unit having a lipophilic surface is formed by the image recording layer cured by light exposure in the exposed area of the image recording layer in a case where dampening water and printing ink are supplied to the image-exposed planographic printing plate precursor on a printing press. Meanwhile, in an unexposed area, a non-cured image recording layer is dissolved or dispersed by supplied dampening water and/or printing ink and then removed, a hydrophilic surface is exposed to the portion. As the result, dampening water is exposed and adheres to the hydrophilic surface, the printing ink is impressed on the image recording layer of the exposed region, and then the printing is started.

Here, either of dampening water or printing ink may be initially supplied to the surface of the planographic printing plate precursor, but it is preferable that dampening water is initially supplied thereto so that the on-press developability is promoted by permeation of the dampening water.

The development treatment using a developer can be performed by a usual method. The development treatment of a development treatment type negative type planographic printing plate precursor is described in, for example, paragraphs 0197-0220 of JP-A-2008-015503. The development treatment of the development treatment type positive type planographic printing plate precursor is described in, for example, paragraphs 0157-0160 of JP-A-2007-148040.

[Printing plate precursor laminate and printing plate laminate]

A printing plate precursor laminate according to the embodiment of the present invention is a laminate obtained by laminating the printing plate precursors according to the embodiment of the present invention and is formed by laminating a plurality of the printing plate precursors according to the embodiment of the present invention. Further, it is preferable that the printing plate precursor laminate is a laminate obtained by bringing the outermost layer on the surface where the layer containing a polymer is provided into direct contact with the outermost layer on the surface where the layer containing tabular particles is provided so that the layers are laminated on each other.

The present printing plate precursor laminate is a laminate formed by directly laminating a plurality (typically, 2-500 sheets) of the present printing plate precursors without sandwiching interleaving paper between the precursors.

The present printing plate precursor laminate has an excellent property of preventing scratches to the back coat layer and preventing peeling of the back coat layer because of the effects of the tabular particles of the back coat layer included in the present printing plate precursor.

The present printing plate laminate is a laminate formed by directly laminating a plurality of sheets of planographic printing plates or printing key plates without sandwiching interleaving paper between the plates. Such a laminate is formed by laminating a plurality of sheets of planographic printing plates or printing key plates and placing the laminate in an appropriate place in a case where there is a gap in time for about several hours to several days after the plate-making to starting of printing.

Examples

Hereinafter, the present invention will be described in detail with reference to examples. Further, in a polymer compound, the molecular weight indicates the mass average molecular weight (Mw) and the proportion of repeating units indicates mole percentage unless otherwise specified. Further, the mass average molecular weight (Mw) is a value in terms of polystyrene obtained by performing measurement using gel permeation chromatography (GPC).

<Production of support 1>

As a roughening treatment, the following treatments (a)-(e) were performed. In addition, a water washing treatment was performed between all the treatment steps.

(a) Alkali etching treatment

An aluminum plate (material JIS 1052) having a thickness of 0.3 mm was subjected to an etching treatment by spraying an aqueous solution in which the concentration of caustic soda was 25 mass% and the concentration of aluminum ions was 100 g/L using a spray tube at a temperature of 60°C. The etching amount of the surface of the aluminum plate to be subjected to an electrochemical roughening treatment was 3 g/$m^2$.

(b) Desmutting treatment

Next, a desmutting treatment was performed by spraying a sulfuric acid aqueous solution (concentration of 300 g/L) at a temperature of 35°C for 5 seconds using the spray tube.

(c) Electrolytic roughening treatment

Thereafter, an electrochemical roughening treatment was continuously performed using an electrolyte (solution temperature of 35°C) obtained by dissolving aluminum chloride in a 1 mass% of hydrochloric acid aqueous solution and adjusting the aluminum ion concentration to 4.5 g/L, a 60 Hz AC power source, and a flat cell type electrolytic cell. A sine wave was used as the waveform of the AC power source. In the electrochemical roughening treatment, the current density of the aluminum plate during the anodic reaction at the peak of the alternating current was 30 A/$dm^2$. The ratio between the sum total of electric quantity at the time of the anodic reaction and the sum total of electric quantity at the time of the cathodic reaction of the aluminum plate was 0.95. The electric quantity was set to 480 C/$dm^2$ in terms of the sum total of electric quantity at the time of the anodic reaction of the aluminum plate. The electrolyte was circulated using a pump so that the stirring inside the electrolytic cell was performed.

(d) Alkali etching treatment

The aluminum plate was subjected to an etching treatment by spraying an aqueous solution at a temperature of 35°C in which the concentration of caustic soda was 5 mass% and the concentration of aluminum ions was 5 g/L using a spray tube. The etching amount of the surface of the aluminum plate on which the electrolytic roughening treatment had been performed was 0.05 g/$m^2$.

(e) Desmutting treatment

Next, a desmutting treatment was performed by spraying an aqueous solution at a solution temperature of 35°C with a sulfuric acid concentration of 300 g/L and an aluminum ion concentration of 5 g/L using the spray tube for 5 seconds.
The aluminum plate on which the roughening treatment had been performed was subjected to an anodizing treatment at a treatment temperature of 38°C and a current density of 15A/$dm^2$ using a 22 mass% of phosphoric acid aqueous solution as an electrolyte.
Thereafter, washing with water by spraying was performed. The final amount of the oxide film was 1.5 g/$m^2$. The surface of the substrate was imaged at a magnification of 150000 times using an electronic microscope and the average pore diameter in a case of n = 90 was actually measured, and the value was 30 nm.

<Production of support 2>

An aluminum plate having a thickness of 0.19 mm was immersed in a 40 g/L sodium hydroxide aqueous solution at 60°C for 8 seconds so as to be degreased and then washed with demineralized water for 2 seconds. Next, the aluminum plate was subjected to an electrochemical roughening treatment in an aqueous solution containing 12 g/L of hydrochloric acid and 38 g/L of aluminum sulfate (18 hydrates) at a temperature of 33°C and at a current density of 130 A/$dm^2$ using an AC for 15 seconds. Next, the aluminum plate was washed with demineralized water for 2 seconds, subjected to a desmutting treatment by being etched using 155 g/L of a sulfuric acid aqueous solution at 70°C for 4 seconds, and washed with demineralized water at 25°C for 2 seconds. The aluminum plate was subjected to an anodizing treatment in 155 g/L of a sulfuric acid aqueous solution for 13 seconds at a temperature of 45°C and at a current density

of 22 A/$dm^2$ and washed with demineralized water for 2 seconds. Further, the aluminum plate was treated at 40°C for 10 seconds using 4 g/L of a polyvinyl phosphonic acid aqueous solution, washed with demineralized water at 20°C for 2 seconds, and then dried, thereby producing a support. The surface roughness Ra of the obtained support was 0.21 μm and the amount of the anodized film was 4 g/$m^2$.

<Production of support 3>

An aluminum alloy plate having a thickness of 0.3 mm and having a composition listed in Table A was subjected to the following treatments (a)-(m), whereby a support 3 was produced. Moreover, during all treatment steps, a water washing treatment was performed, and liquid cutting was performed using a nip roller after the water washing treatment.

[Table 1]

| Table A | | | | | | | |
|---|---|---|---|---|---|---|---|
| Composition (mass%) | | | | | | | |
| Si | Fe | Cu | Mn | Mg | Zn | Ti | Al |
| 0.085 | 0.303 | 0.037 | 0 | 0 | 0 | 0.018 | Remainder |

(a) Mechanical roughening treatment (brush grain method)

While supplying a suspension of pumice (specific gravity of 1.1 g/$cm^3$) to the surface of an aluminum plate as a polishing slurry liquid, a mechanical roughening treatment was performed using rotating bundle bristle brushes.

The mechanical roughening treatment was performed under conditions in which the median diameter of a polishing material pumice was 30 μm, the number of the bundle bristle brushes was four, and the rotation speed of the bundle bristle brushes was set to 250 rpm. The material of the bundle bristle brushes was nylon 6 10, the diameter of the brush bristles was 0.3 mm, and the bristle length was 50 mm. The bundle bristle brushes were produced by implanting bristles densely into holes in a stainless steel cylinder having a diameter of φ300 mm. The distance between two support rollers (φ200 mm) of the lower portion of the bundle bristle brushes was 300 mm. The bundle bristle brushes were pressed until the load of a driving motor for rotating the brushes became 10 kW plus with respect to the load before the bundle bristle brushes were pressed against the aluminum plate. The rotation direction of the bundle bristle brushes was the same as the moving direction of the aluminum plate.

(b) Alkali etching treatment

The aluminum plate was subjected to an etching treatment by spraying a caustic soda aqueous solution in which the concentration of caustic soda was 26 mass% and the concentration of aluminum ions was 6.5 mass% using a spray tube at a temperature of 70°C. Thereafter, washing with water by spraying was performed. The amount of aluminum dissolved was 10 g/$m^2$.

(c) Desmutting treatment in acidic aqueous solution

Next, a desmutting treatment was performed in a nitric acid aqueous solution. As the nitric acid aqueous solution used in the desmutting treatment, a nitric acid electrolyte used in electrochemical roughening of the subsequent step was used. The solution temperature was 35°C. The desmutting treatment was performed for 3 seconds by spraying the desmutting liquid using a spray.

(d) Electrochemical roughening treatment

An electrochemical roughening treatment was continuously performed using an AC voltage of 60 Hz. An electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. The current density was 30 A/$dm^2$ as the peak current value, and 5% of the current from the power source was separately flowed to the auxiliary anode. The electric quantity was 185 C/$dm^2$ as the sum total of electric quantity at the time of anodization of the aluminum plate. Thereafter,

washing with water by spraying was performed.

(e) Alkali etching treatment

The aluminum plate was subjected to an etching treatment by spraying a caustic soda aqueous solution in which the concentration of caustic soda was 5 mass% and the concentration of aluminum ions was 0.5 mass% using a spray tube at a temperature of 50°C. Thereafter, washing with water by spraying was performed. The amount of aluminum dissolved was 0.5 g/m$^2$.

(f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The solution temperature was 60°C. The desmutting treatment was performed for 3 seconds by spraying the desmutting liquid using a spray.

(g) Electrochemical roughening treatment

An electrochemical roughening treatment was continuously performed using an AC voltage of 60 Hz. An electrolyte which had been adjusted to have a concentration of aluminum ions of 4.5 g/L by adding aluminum chloride to a hydrochloric acid aqueous solution having a concentration of 6.2 g/L at a solution temperature of 35°C was used. Using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. The current density was 25 A/dm$^2$ as the peak current value, and the electric quantity in the hydrochloric acid electrolysis was 63 C/dm$^2$ as the sum total of electric quantity at the time of anodization of the aluminum plate. Thereafter, washing with water by spraying was performed.

(h) Alkali etching treatment

The aluminum plate was subjected to an etching treatment by spraying a caustic soda aqueous solution in which the concentration of caustic soda was 5 mass% and the concentration of aluminum ions was 0.5 mass% using a spray tube at a temperature of 50°C. Thereafter, washing with water by spraying was performed. The amount of aluminum dissolved was 0.1 g/m$^2$.

(i) Desmutting treatment in acidic aqueous solution

Next, a desmutting treatment was performed in a sulfuric acid aqueous solution. The desmutting treatment was performed at a solution temperature of 35°C for 4 seconds using the sulfuric acid aqueous solution (aluminum ions having a concentration of 5 g/L were contained in a sulfuric acid aqueous solution having a concentration of 170 g/L) used for the anodizing treatment step. The desmutting treatment was performed for 3 seconds by spraying the desmutting liquid using a spray.

(j) First anodizing treatment

A first step of an anodizing treatment was performed with an anodizing device using DC electrolysis. An anodized film having a predetermined film thickness was formed by performing an anodizing treatment under conditions listed in Table B. An aqueous solution containing components listed in Table B was used as the electrolyte. In Tables B-D, the "component concentration" indicates the concentration (g/L) of each component described in the column of "liquid component".

[Table 2]

| Table B | | | | | | |
|---|---|---|---|---|---|---|
| First anodizing treatment | | | | | | |
| Liquid type | Liquid component | Component concentration (g/L) | Temperature (°C) | Current density ($A/dm^2$) | Time (s) | Film thickness (nm) |
| Sulfuric acid | $H_2SO_4$/Al | 170/5 | 55 | 90 | 0.40 | 110 |

(k) Second anodizing treatment

A second step of an anodizing treatment was performed with an anodizing device using DC electrolysis. An anodized film having a predetermined film thickness was formed by performing an anodizing treatment under conditions listed in Table C. An aqueous solution containing components listed in Table C was used as the electrolyte.

[Table 3]

| Table C | | | | | | |
|---|---|---|---|---|---|---|
| Second anodizing treatment | | | | | | |
| Liquid type | Liquid component | Component concentration (g/L) | Temperature (°C) | Current density ($A/dm^2$) | Time (s) | Film thickness (nm) |
| Sulfuric acid | $H_2SO_4$/Al | 170/5 | 54 | 15 | 13 | 900 |

(1) Third anodizing treatment

A third step of an anodizing treatment was performed with an anodizing device using DC electrolysis. An anodized film having a predetermined film thickness was formed by performing an anodizing treatment under conditions listed in Table D. An aqueous solution containing components listed in Table D was used as the electrolyte.

[Table 4]

| Table D | | | | | | |
|---|---|---|---|---|---|---|
| Third anodizing treatment | | | | | | |
| Liquid type | Liquid component | Component concentration (g/L) | Temperature (°C) | Current density ($A/dm^2$) | Time (s) | Film thickness (nm) |
| Sulfuric acid | $H_2SO_4$/Al | 170/5 | 54 | 50 | 0.4 | 100 |

(m) Hydrophilization treatment

In order to ensure hydrophilicity of a non-image area, the non-image area was subjected to a silicate treatment by being dipped in 2.5 mass% of a No. 3 sodium silicate aqueous solution at 50°C for 7 seconds. The adhesion amount of Si was 8.5 $mg/m^2$. Thereafter, washing with water by spraying was performed.

The average diameter (average diameter of surface layer) of a large-diameter hole portion on the surface of the anodized film having micropores obtained in the above-described manner, the average diameter (average diameter of bottom portion) of the large-diameter hole portion in a communication position, the average diameter (diameter of small-diameter hole portion) of a small-diameter hole portion in the communication position, the average depth of the large-diameter hole portion and the small-diameter hole portion, the thickness (thickness of barrier layer) of the anodized film from the bottom portion of the small-diameter hole portion to the surface of the aluminum plate, and the density of the small-diameter hole portion are listed in Table E. The small-diameter hole portion includes a first small-diameter

hole portion and a second small-diameter hole portion with depths different from each other and a small-diameter hole portion which is deeper than the other is referred to as the first small-diameter hole portion.

[Table 5]

| Table E (part 1) | | | | | |
|---|---|---|---|---|---|
| Micropores | | | | | |
| Large-diameter hole portion | | | | | |
| Average diameter of surface layer (nm) | Average diameter of bottom portion (nm) | Average depth (nm) | Average depth/ Average diameter of surface layer | Average depth/ Average diameter of bottom portion | Shape |
| 12 | 25 | 98 | 8.2 | 3.9 | Reversely tapered shape |

[Table 6]

| Table E (part 2) | | | | | | | |
|---|---|---|---|---|---|---|---|
| Micropores | | | | | | | |
| Small-diameter hole portion | | | | | Density of micropores (pieces/ pieces/ $\mu m^2$) | Increase magnification of surface area | Ratio (Average diameter of surface layer/ Diameter of small-diameter hole portion) |
| Average diameter (nm) | Average depth (nm) | Density of communication portion (pieces/ $\mu m^2$) | Average thickness of barrier layer (nm) | Minimum thickness of barrier layer (nm) | | | |
| 9.8 | 888,968 | 800 (650) | 17 | 16 | 500 | 4.0 | 1.22 |

In Table E, the average value and the minimum value of the barrier layer thickness are shown. The average value is obtained by measuring 50 thicknesses of the anodized film from the bottom portion of the first small-diameter hole portion to the surface of the aluminum plate and arithmetically averaging the values.

The average diameter of micropores (average diameter of large-diameter hole portion and small-diameter hole portion) is a value obtained by observing four sheets (N = 4) of the surfaces of the large-diameter hole portion and the surfaces of the small-diameter hole portion using FE-SEM at a magnification of 150,000, measuring the diameters of micropores (the large-diameter hole portion and the small-diameter hole portion) present 400 $\times$ 600 $nm^2$ in the obtained images of four sheets, and averaging the values. Further, in a case where the depth of the large-diameter hole portion is deep and the diameter of the small-diameter hole portion is unlikely to be measured, the upper portion of the anodized film is cut and then various kinds of diameters are acquired.

The average depth of the large-diameter hole portion is a value obtained by observing the cross section of the support (anodized film) using FE-TEM at a magnification of 500,000, measuring 60 cases (N = 60) of distances from the surface of an arbitrary micropore to the communication position in the obtained image, and averaging the values. Further, the average depth of the small-diameter hole portion is a value obtained by observing the cross section of the support (anodized film) using FE-SEM (at a magnification of 50,000), measuring 25 depths of arbitrary micropores in the obtained image, and averaging the values.

The "density of the communication portion" indicates the density of the small-diameter hole portion of the cross section of the anodized film in the communication position. The "increase magnification of the surface area" indicates the value calculated based on the following Equation (A).

Equation (A)

Increase magnification of surface area = 1 + pore density ´ ((π × (average diameter of surface layer/2 + average diameter of bottom portion/2) × ((average diameter of bottom portion/2 - average diameter of surface layer/2)$^2$ + depth A$^2$)$^{1/2}$ + π × (average diameter of bottom portion/2)$^2$ - π × (average diameter of surface layer/2)$^2$))

In the column of the "average depth (nm)" of the small-diameter hole portion, the average depth of the second small-diameter hole portion is shown on the left side and the average depth of the first small-diameter hole portion is shown on the right side. In the column of the "density of communication portion" of the small-diameter hole portion in Table E, the density of the first small-diameter hole portion is shown in parentheses together with the density of the communication portion of the small-diameter hole portion.

In addition, the average diameter of the first small-diameter hole portion positioning from the bottom portion of the second small-diameter hole portion to the bottom portion of the first small-diameter hole portion was approximately 12 nm.

[Example 1] (not according to the claimed invention)

<Formation of back coat layer>

(Preparation of back coat layer coating solution (1))

· Polyvinyl alcohol (PVA-405, manufactured by KURARAY CO., LTD., 212.03 g saponification degree: 81.5 mol%, degree of polymerization: 500), 6 mass% of aqueous solution
· SOMASIF MEB-3, manufactured by Katakura Chikkarin Co., Ltd., 8 mass% of aqueous solution: 11.61 g

The components were mixed and stirred, thereby a back coat layer coating solution (1) was prepared.

The surface of the support 1 on the back coat layer side (non-printing surface side) was bar-coated with the back coat layer coating solution (1) with the composition described above and dried at 100°C for 120 seconds, thereby forming a back coat layer having a thickness of 1.2 μm.

<Formation of undercoat layer>

The other surface (printing surface side) of the support 1 was coated with an undercoat layer coating solution (1) with the following composition such that the drying coating amount thereof reached 20 mg/m$^2$, thereby forming an undercoat layer.

(Undercoat layer coating solution (1))

· Compound for undercoat layer (UC-1) (the following structure) 0.18 g
· Hydroxyethyl imino diacetic acid 0.05 g
· Surfactant (EMALEX 710, manufactured by Nihon Emulsion Co., Ltd.) 0.03 g
· Water 28.0 g

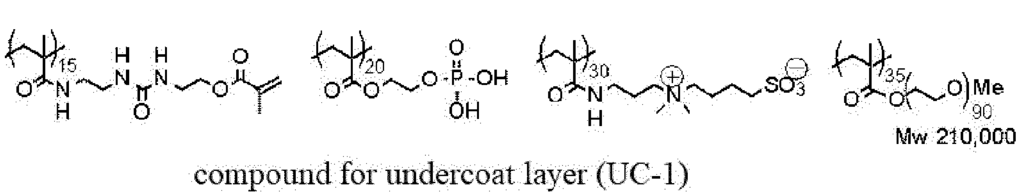

compound for undercoat layer (UC-1)

<Formation of image recording layer>

An undercoat layer of the support including a back coat layer and an undercoat layer was bar-coated with an image recording layer coating solution (2) with the following composition and dried in an oven at 70°C for 60 seconds to form an image recording layer (polymer-containing layer 1) having a drying coating amount of 0.6 g/m$^2$, thereby producing a planographic printing plate precursor.

(Image recording layer coating solution (2))

· Thermoplastic polymer particles aqueous dispersion liquid (described below) 20.0 g
· Infrared absorbent (2) (the following structure) 0.2 g
· Polymerization initiator (IRGACURE 250, manufactured by Ciba Specialty Chemicals, Inc.) 0.4 g
· Polymerization initiator (2) (the following structure) 0.15 g
· Polymerizable compound SR-399 (manufactured by Sartomer Japan Inc.) 1.50 g
· Mercapto-3-triazole 0.2 g
· Byk336 (manufactured by BYK Chemie GmbH) 0.4 g
· Klucel M (manufactured by Hercules, Inc.) 4.8 g
· ELUACITE 4026 (manufactured by Ineos Acrylics Ltd.) 2.5 g
· Anionic surfactant 1 (the following structure) 0.15 g
· n-propanol 55.0 g
· 2-butanone 17.0 g

The compounds described with the trade names in the composition above as follows.

IRGACURE 250: (4-methylphenyl)[4-(2-methylpropyl)phenyl]iodonium=hexafluorophosphate (75 mass% propylene carbonate solution)
· SR-399: dipentaerythritolpentaacrylate
· Byk336: modified dimethyl polysiloxane copolymer (25 mass% xylene/methoxy propyl acetate solution)
· Klucel M: hydroxypropyl cellulose (2 mass% of aqueous solution)
· ELVACITE 4026: highly branched polymethyl methacrylate (10 mass% 2-butanone solution)

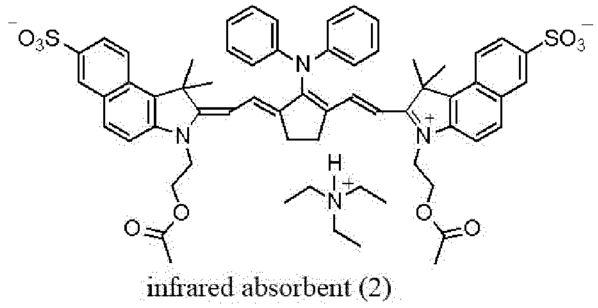

infrared absorbent (2)

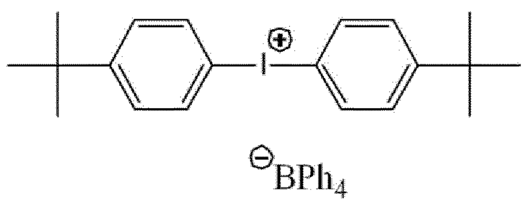

polymerization initiator (2)

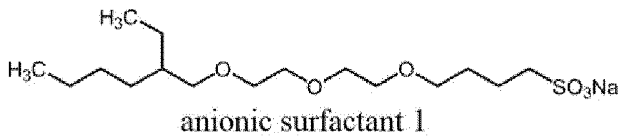

anionic surfactant 1

(Production of thermoplastic polymer particles aqueous dispersion liquid)

Nitrogen gas was introduced into a 1,000 ml four-necked flask equipped with a stirrer, a thermometer, a dropping funnel, a nitrogen introduction pipe, and a reflux condenser, deoxygenation was performed, 10 g of polyethylene glycol methyl ether methacrylate (PEGMA, average number of repeating units of ethylene glycol: 20), 200 g of distilled water, and 200 g of n-propanol were added thereto, and then the mixture was heated until the internal temperature thereof was set to 70°C. Next, a mixture of 10 g of styrene (St), 80 g of acrylonitrile (AN), and 0.8 g of 2,2'-azobisisobutyronitrile prepared in advance was added dropwise thereto for 1 hour. After dropwise addition was finished, the reaction was allowed to be continued for 5 hours, 0.4 g of 2,2'-azobisisobutyronitrile was added thereto, and the mixture was heated until the internal temperature was set to 80°C. Subsequently, 0.5 g of 2,2'-azobisisobutyronitrile was added for 6 hours. The total degree of polymerization at the step of the continued reaction for 20 hours was 98% or greater, and a thermoplastic polymer particles aqueous dispersion liquid having PEGMA, St, and AN at a mass ratio of 10/10/80 was obtained. The particle size distribution of the thermoplastic polymer particles has a maximum value at 150 nm of the volume average particle diameter.

Here, the particle size distribution was acquired by imaging an electron micrograph of polymer particles, measuring the total number of 5,000 particle diameters of particles on the photograph, dividing the interval from the maximum value of the obtained measured value of the particle diameter to 0 into the logarithmic scale of 50, and plotting the appearance frequency of each particle diameter. Further, as a non-spherical particle, the particle diameter of a spherical particle having the same particle area as the particle area of the non-spherical particle on the photograph was set to the particle diameter.

[Example 2] (not according to the claimed invention)

A back coat layer, an undercoat layer, and an image recording layer were formed in the same manner as in Example 1 except that the back coat layer coating solution (1) of Example 1 was changed to a back coat layer coating solution (2), thereby a planographic printing plate precursor was produced.

(Preparation of back coat layer coating solution (2))

· Polyvinyl alcohol (PVA-405, manufactured by KURARAY CO., LTD., 212.03 g saponification degree: 81.5 mol%, degree of polymerization: 500), 6 mass% of aqueous solution
· SUMECTON-SWF, manufactured by Kunimine Industries Co., Ltd.: 0.93 g

The components were mixed and stirred, thereby a back coat layer coating solution (2) was prepared.

[Example 13] (not according to the claimed invention)

A back coat layer, an undercoat layer, and an image recording layer were formed in the same manner as in Example 1 except that the back coat layer coating solution (1) of Example 1 was changed to a back coat layer coating solution (13), thereby a planographic printing plate precursor was produced.

(Preparation of back coat layer coating solution (13))

· Methyl methacrylate/methacrylic acid copolymer, Mw = 40000 (the following structure): 12.71 g (MMA/MMA copolymer)
· SOMASIF MEE, manufactured by Katakura Chikkarin Co., Ltd.: 0.93 g
· 2-butanone 76.89 g
· 1-methoxy-2-propanol 8.54 g

The components were mixed and stirred, thereby a back coat layer coating solution (13) was prepared.

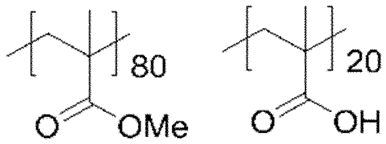

[Example 17] (not according to the claimed invention)

A back coat layer, undercoat layer, and image recording layer were formed in the same manner as in Example 13 except that the thickness of the back coat layer, the kind of the tabular particles in the back coat layer coating solution (1), and the amount of the tabular particles to be added in Example 13 were changed as listed in Table 7, thereby producing planographic printing plate precursors.

[Production of Example 26]

A back coat layer, an undercoat layer, and an image recording layer were formed in the same manner as in Example 1 except that the back coat layer coating solution (1) of Example 1 was changed to a back coat layer coating solution (26), thereby a planographic printing plate precursor was produced.

(Preparation of back coat layer coating solution (26))

· Tetraethyl silicate 50 pbm
· Water 20 pbm
· Methanol 15 pbm
· Phosphoric acid 0.05 pbm

After the above-described components were mixed and stirred, heat generation was started in approximately 5 minutes. The mixture was reacted for 60 minutes, and a liquid described below was added thereto, thereby preparing a back coat coating solution (26).

· Pyrogallol-formaldehyde condensation resin (Mw: 2000) 4 pbm
· Dimethyl phthalate 5 pbm
Fluorine-based surfactant (N-butyl perfluorooctane sulfonamide ethyl acrylate/polyoxyethylene acrylate copolymer (Mw: 20000)) 0.7 pbm
· Silica-coated acrylic resin particles ART PEARL J-7P (particles other than tabular particles), manufactured by Negami Chemical Industrial Co., Ltd. 25 pbm
· SUMECTON-STN, manufactured by Kunimine Industries Co., Ltd.: 50 pbm
· Methanol 800 pbm

[Production of Example 27]

A back coat layer, an undercoat layers, and an image recording layers were formed in the same manner as in Example 26 except that the kind of the particles other than the tabular particles in the back coat layer coating solution (26) of Example 26 were changed as listed in Table 1, thereby producing a planographic printing plate precursor.

As the particles other than the tabular particles, SILYSIA 440 (manufactured by Fuji Silysia Chemical Ltd.) was used.

[Example 28]

A back coat layer, an undercoat layer, and an image recording layer were formed in the same manner as in Example 1 except that the back coat layer coating solution (1) of Example 1 was changed to a back coat layer coating solution (28), thereby a planographic printing plate precursor was produced.

(Preparation of back coat layer coating solution (28))

· Methyl methacrylate/methacrylic acid copolymer, Mw = 40000 (the following structure): 12.71 g
· SUMECTON-STN, manufactured by Kunimine Industries Co., Ltd.: 0.93 g
· Silica-coated melamine resin particles OPTBEADS 3500M, manufactured by Nissan Chemical Industries, Ltd.: 0.47 g
(Particles other than tabular particles)
· 2-butanone 76.89 g
· 1-methoxy-2-propanol 8.54 g

The components were mixed and stirred, thereby a back coat layer coating solution (28) was prepared.

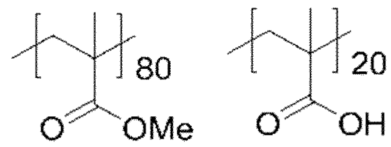

[Examples 29-36]

Back coat layers, undercoat layers, and image recording layers were formed in the same manner as in Example 28 except that the thickness of the back coat layer, the amount of the tabular particles added to the back coat layer coating solution (28), the kind of particles other than the tabular particles, and the amount of the particles to be added in Example 28 were changed as listed in Table 1, thereby producing planographic printing plate precursors.
The particles other than the tabular particles are described below.

TOSPEARL 145 (manufactured by Momentive Performance Materials Japan LLC)
ART PEARL J-6PF (manufactured by Negami Chemical Industrial Co., Ltd.)
OPTBEADS 6500M (manufactured by Nissan Chemical Industries, Ltd.)

[Example 37] (not according to the claimed invention)

The surface of the support 2 on the back coat layer side (non-printing surface side) was bar-coated with the back coat layer coating solution of Example 17 and dried at 100°C for 120 seconds, thereby forming a back coat layer having a thickness of 1.2 μm.

<Formation of image recording layer>

An image recording layer aqueous coating solution containing thermoplastic polymer particles, an infrared absorbent, and polyacrylic acid described below was prepared, the pH thereof was adjusted to 3.6, and the surface of the support 2 on the printing surface side was coated with the coating solution and dried at 50°C for 1 minute to form and produce an image recording layer. The coating amount after the drying of each component is shown below.

Thermoplastic polymer particles: 0.7 g/$m^2$
Infrared absorbent IR-01: 1.20 $\times$ $10^{-4}$ g/$m^2$
Polyacrylic acid: 0.09 g/$m^2$

The thermoplastic polymer particles, the infrared absorbent IR-01, and the polyacrylic acid used for the image recording layer coating solution are as follows.

Thermoplastic polymer particles: styrene-acrylonitrile copolymer (molar ratio of 50:50), Tg: 99°C, volume average particle diameter: 60 nm
Infrared absorbent IR-01: infrared absorbent having the following structure

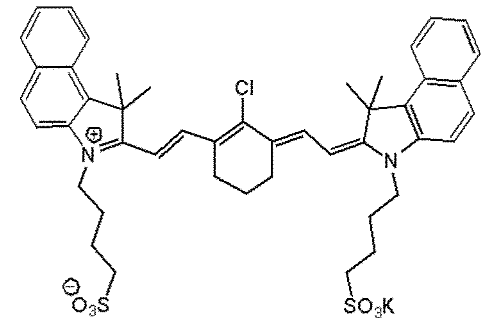

Polyacrylic acid Mw: 250,000

[Example 38] (not according to the claimed invention)

The surface of the support 3 on the back coat layer side (non-printing surface side) was bar-coated with the back coat layer coating solution of Example 17 and dried at 100°C for 120 seconds, thereby forming a back coat layer having a thickness of 1.2 μm.

<Formation of undercoat layer>

The surface of the support 3 on the printing surface side was coated with the undercoat layer coating solution (1) such that the drying coating amount thereof reached 20 mg/$m^2$, thereby forming an undercoat layer.

The undercoat layer was bar-coated with an image recording layer coating solution (3) with the following composition and dried in an oven at 100° for 60 seconds, thereby forming an image recording layer having a drying coating amount of 1.0 g/$m^2$.

The image recording layer coating solution (3) was obtained by mixing a photosensitive solution (1) and a microgel solution (1) described below immediately before the coating and then stirring the solution.

(Image recording layer coating solution (3))

(Photosensitive solution (1))

· Binder polymer (1) (the following structure, Mw: 55,000 and n (number of ethylene oxide (EO) repeating units): 2): 0.240 parts
· Infrared absorbent (1) (the following structure): 0.020 parts
· Borate compound (1) (Sodium tetraphenylborate): 0.010 parts
· Polymerization initiator (1) (the following structure): 0.162 parts
· Polymerizable compound (tris(acryloyloxyethyl) isocyanurate, NK ESTER A-9300, manufactured by Shin-Nakamura Chemical Co., Ltd.): 0.192 parts
· Anionic surfactant 1 (the above-described structure): 0.050 parts
· Fluorine-based surfactant (1) (the following structure): 0.008 parts
· 2-butanone: 1.091 parts
· 1-methoxy-2-propanol: 8.609 parts

(Microgel solution (1))

· Microgel (1): 2.640 parts
· Distilled water: 2.425 parts

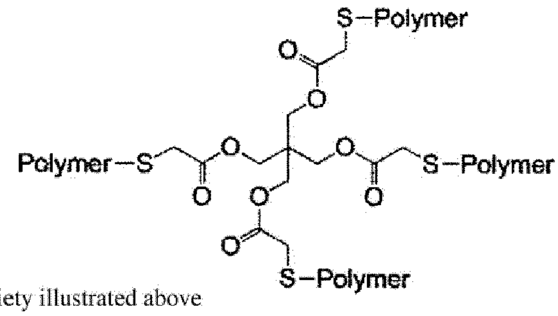

polymer moiety illustrated above

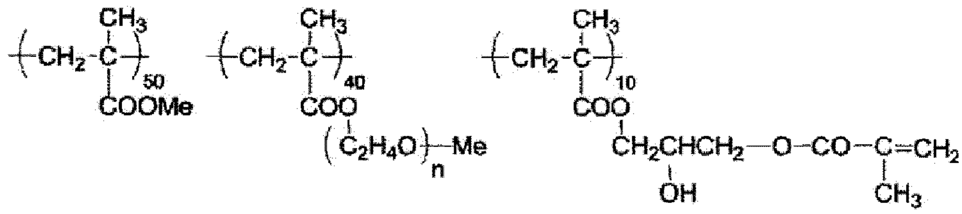

binder polymer (1)

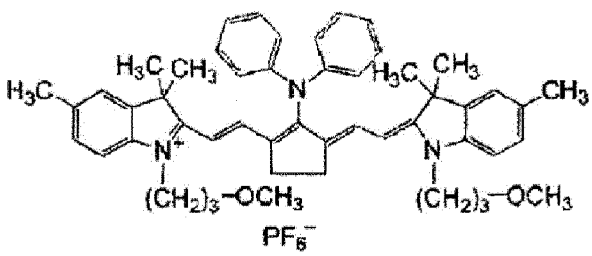

infrared absorber (1)

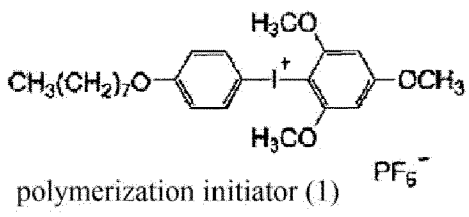

polymerization initiator (1)

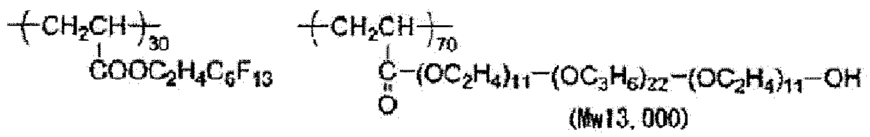

fluorine-based surfactant (1)

(Production of microgel (1))

A method of preparing a microgel (1) used for the microgel solution will be described below.

<Preparation of polyvalent isocyanate compound (1)>

0.043 parts of bismuth tris(2-ethylhexanoate) (NEOSTANN U-600, manufactured by NITTO KASEI CO., LTD.) was added to an ethyl acetate (25.31 parts) suspension solution of 17.78 parts (80 molar equivalent) of isophorone diisocyanate and 7.35 parts (20 molar equivalent) of the following polyhydric phenol compound (1), and the solution was stirred. The reaction temperature was set to 50°C at the time of heat generation being subsided, and the solution was stirred for 3 hours, thereby obtaining an ethyl acetate solution (50 mass%) of a polyvalent isocyanate compound (1).

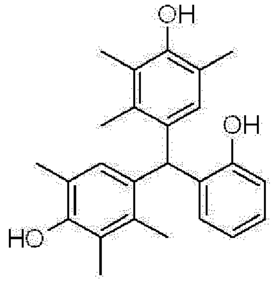

polyhydric phenol compound (1)

<Preparation of microgel (1)>

The following oil phase components and the water phase component were mixed with each other and emulsified at 12,000 rpm for 10 minutes using a homogenizer. The obtained emulsion was stirred at 45°C for 4 hours, 5.20 parts of a 10 mass% of aqueous solution of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. The concentration of solid contents was adjusted to 20 mass% using distilled water, thereby obtaining an aqueous dispersion liquid of the microgel (1). The volume average particle diameter was measured using a dynamic light scattering type particle size distribution measuring device LB-500 (manufactured by Horiba Ltd.) according to a light scattering method, and the value was 0.28 μm.

(Oil phase components)

(Component 1) ethyl acetate: 12.0 parts
(Component 2) adduct (50 mass% of ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto: 3.76 parts
(Component 3) polyvalent isocyanate compound (1) (as 50 mass% of ethyl acetate solution): 15.0 parts
(Component 4) 65 mass% of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts
(Water phase component)
Distilled water: 46.87 parts

<Formation of protective layer>

The image recording layer was bar-coated with a protective layer coating solution (1) with the following composition and dried in an oven at 120° for 60 seconds to form a protective layer having a drying coating amount of 0.15 g/m$^2$, thereby producing a planographic printing plate precursor.

(Protective layer coating solution (1))

· Inorganic layered compound dispersion liquid (1) (described below) 1.5 g
· Hydrophilic polymer (1) (the following structure, Mw: 30,000) (solid content) 0.03 g
· Polyvinyl alcohol (CKS50, manufactured by Nippon Synthetic Chemical Industry Co., Ltd., 0.10 g sulfonic acid-modified, saponification degree: 99 mol% or greater, degree of polymerization: 300) 6 mass% of aqueous solution
· Polyvinyl alcohol (PVA-405, manufactured by KURARAY CO., LTD., 0.03 g saponification degree: 81.5 mol%, degree of polymerization: 500), 6 mass% of aqueous solution
· Surfactant (EMALEX 710, the following structure, manufactured by Nihon Emulsion Co., Ltd.) (the following structure) 1 mass% of aqueous solution: 0.86 g
· Ion exchange water 6.0 g

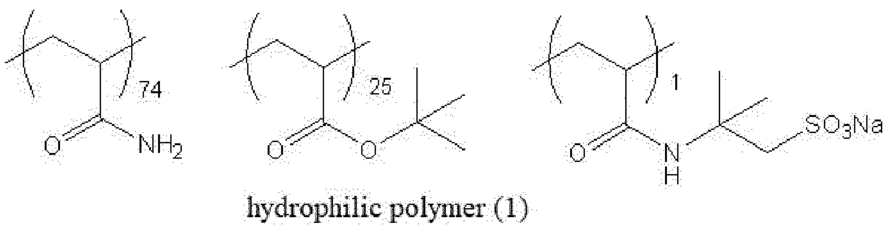

hydrophilic polymer (1)

$C_{12}H_{25}$-$(OCHCH_2)_{10}$-OH EMALEX 710

(Preparation of inorganic layered compound dispersion liquid (1))

6.4 g of synthetic mica Somasif ME-100 (manufactured by CO-OP CHEMICAL CO., LTD.) was added to 193.6 g of ion exchange water and dispersed such that the volume average particle diameter (laser scattering method) was set to 3 μm using a homogenizer. The aspect ratio of the obtained dispersed particles was 100 or greater.

[Examples 39] (not according to the claimed invention)

<Formation of undercoat layer>

The surface of the support 3 having the back coat layer used for production of Example 38 on the printing surface side was coated with an undercoat layer coating solution (2) with the following composition using a wire bar and dried at 90°C for 30 seconds. The coating amount thereof was 10 mg/$m^2$.

(Undercoat layer coating solution (2))

· Polymer compound A (the following structure) (mass average molecular weight: 30,000) 0.05 g
· Methanol 27 g
· Ion exchange water 3 g

polymer compound A

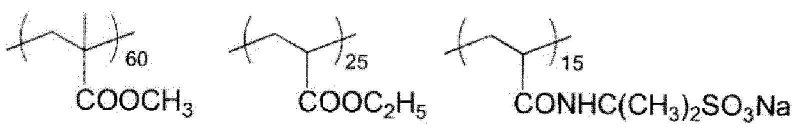

<Formation of image recording layer>

The undercoat layer was coated with the image recording layer coating solution (4) with the following composition using a wire bar and dried at 115°C for 34 seconds using a hot air dryer. The coating amount after the drying was 1.4 g/$m^2$.

(Image recording layer coating solution (4))

· Infrared absorbent (IR-1) (the following structure) 0.074 g
· Polymerization initiator (OS-12) (the following structure) 0.280 g
· Additive (PM-1) (the following structure) 0.151 g
· Polymerizable compound (AM-1) (the following structure) 1.00 g
· Binder polymer (BT-1) (the following structure) 1.00 g
· Ethyl violet (C-1) (the following structure) 0.04 g
· Fluorine-based surfactant 0.015 g (MEGAFACE F-780-F, manufactured by DIC Corporation, 30 mass% of solution

of methyl isobutyl ketone (MIBK)
· Methyl ethyl ketone 10.4 g
· Methanol 4.83 g
· 1-methoxy-2-propanol 10.4 g

(OS-12)

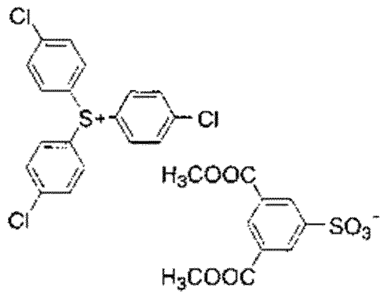

(IR-1)

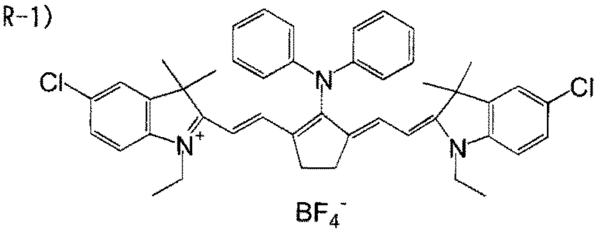

(PM-1)

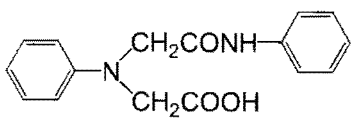

(AM-1)

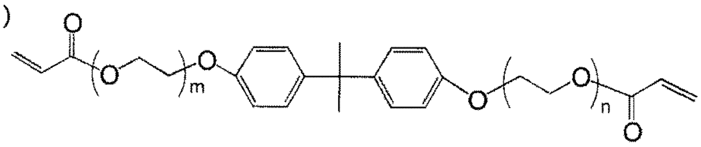

m + n ≒ 4

(BT-1)

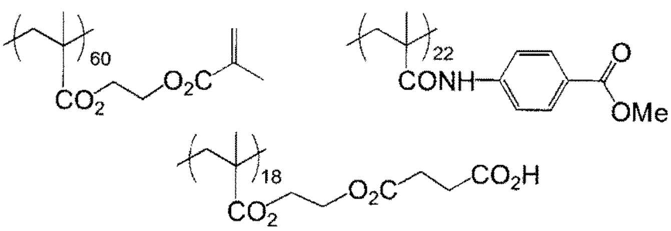

(C-1)

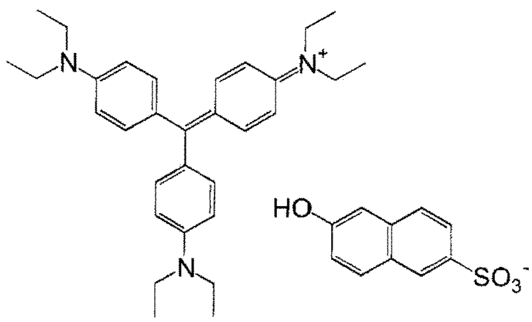

<Formation of protective layer>

The image recording layer was coated with the protective layer coating solution (2) with the following composition using a wire bar and dried at 125°C for 75 seconds using a hot air dryer, thereby forming a protective layer. The coating amount after the drying was 1.6 g/$m^2$. In this manner, a negative type planographic printing plate precursor of Example 39 was produced.

<Protective layer coating solution (2)>

· Synthetic mica (SOMASIF ME-100, manufactured by CO-OP CHEMICAL CO., LTD., 8% aqueous dispersion liquid) 94 g
· Polyvinyl alcohol (CKS-50, manufactured by Nippon Synthetic Chemical Industry Co, Ltd., degree of saponification of 99 mol%, degree of polymerization of 300) 58 g
· Carboxy methyl cellulose (CELOGEN PR, manufactured by DKS Co., Ltd.) 24 g
· Surfactant-1 (PLURONIC P-84, manufactured by BASF SE) 2.5 g
· Surfactant-2 (EMALEX 710, manufactured by Nihon Emulsion Co., Ltd.) 5 g
· Pure water 1364 g

[Example 40] (not according to the claimed invention)

<Formation of undercoat layer>

The surface of the support 3 having the back coat layer used for production of Example 38 on the printing surface side was coated with an undercoat layer coating solution (3) with the following composition using a bar coater and dried at 80°C for 15 seconds, thereby forming an undercoat layer having a coating amount of 18 mg/$m^2$ after the drying of the solution.

(Undercoat layer coating solution (3))

· Polymer compound (the following structure) 0.3 g
· Methanol 100 g

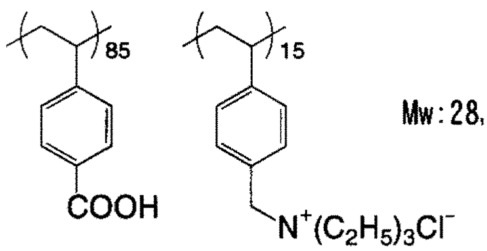

Mw:28, 000

<Formation of image recording layer>

The undercoat layer was coated with an underlayer coating solution with the following composition using a bar coater such that the coating amount after the drying was set to 0.85 g/$m^2$, dried at 160°C for 44 seconds, and immediately cooled with cold air in a temperature range of 17-20°C until the temperature of the support was set to 35°C, thereby forming an underlayer. Thereafter, the underlayer was coated with an upper layer coating solution with the following composition using a bar coater such that the coating amount after the drying was set to 0.22 g/$m^2$, dried at 148°C for 25 seconds, and gradually cooled with air in a temperature range of 20-26°C, thereby forming an upper layer. In this manner, a positive type planographic printing plate precursor of Example 40 was produced.

(Underlayer coating solution)

· N-(4-aminosulfonylphenyl)methacrylamide/acrylonitrile/methyl methacrylate 2.1 g (36/34/30 mass%: mass average molecular weight of 50000, acid value of 2.65)
· m,p-cresol novolac 0.1 g (m/p ratio = 6/4, mass average molecular weight of 4500, containing 0.8 mass% of unreacted cresol, Tg: 75°C)
· Cyanine dye A (the following structure) 0.13 g
· 4,4'-bishydroxyphenylsulfone 0.13 g
· Tetrahydrophthalic anhydride 0.19 g
· p-toluenesulfonic acid 0.008 g
· 3-methoxy-4-diazodiphenylamine hexafluorophosphate 0.032 g
Dye obtained by changing counter ion of ethyl violet into 6-hydroxy-2-naphthalenesulfonic acid 0.078 g
· Fluorine-based surfactant B (the following structure) 0.007 g
· Methyl ethyl ketone 25.0 g
· 1-methoxy-2-propanol 13.0g
· γ-butyrolactone 13.0 g

cyanine dye A

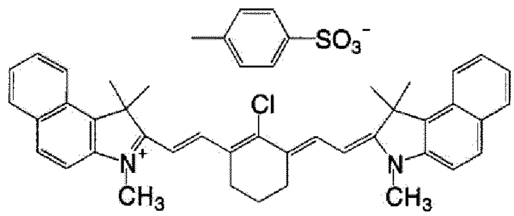

fluorine-based surfactant B

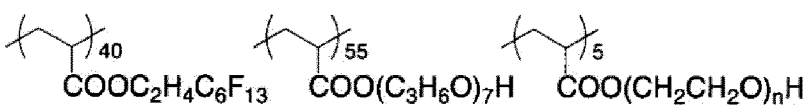

Mw:35, 000

(Upper layer coating solution)

· Phenol/m-cresol/p-cresol novolac 0.35 g
(molar ratio = 5/3/2, mass average molecular weight: 5000, content of unreacted cresol: 1.2 mass%, Tg: 70°C)
· Acrylic resin C (the following structure) 0.042 g
· Cyanine dye A (the above structure) 0.019 g
· Ammonium compound D (the following structure) 0.004 g

· Sulfonium compound G (the following structure) 0.032 g
· Fluorine-based surfactant B (the above structure) 0.0045 g
· Fluorine-based surfactant E (the following structure) 0.0033 g
· Fluorine-based polymer F (the following structure) 0.018 g
· Methyl ethyl ketone 10.0 g
· 1-methoxy-2-propanol 20.0 g

acrylic resin C

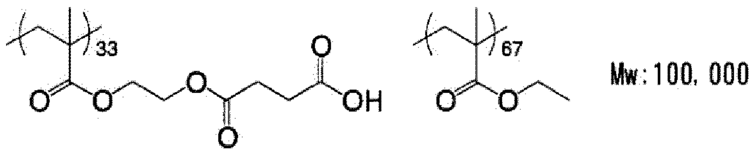

Mw:100, 000

ammonium compound D

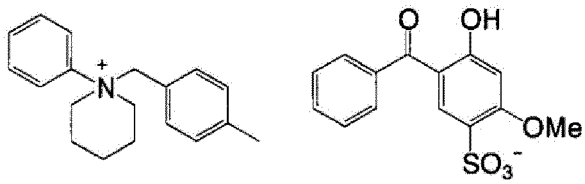

fluorine-based surfactant E

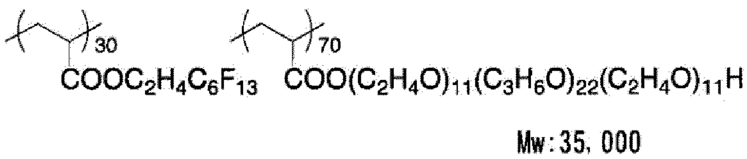

Mw:35, 000

fluorine-based polymer F (X:Y:Z=36:34:30)

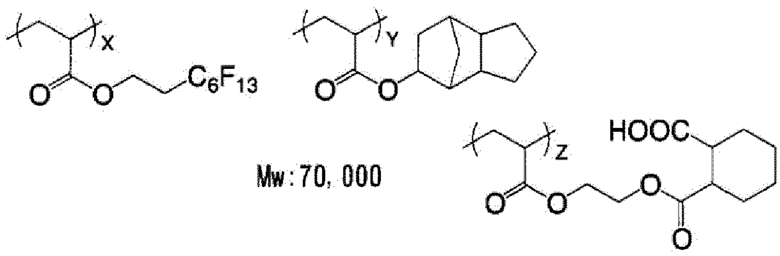

Mw:70, 000

sulfonium compound G

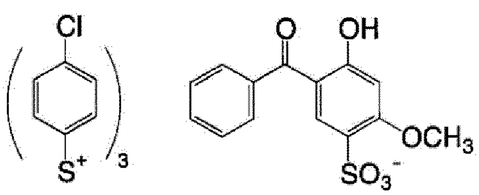

[Example 41] (not according to the claimed invention)

<Formation of undercoat layer>

The surface of the support 3 having the back coat layer used for production of Example 38 on the printing surface side was coated with an undercoat layer coating solution (4) with the following composition using a bar coater and dried at 80°C for 15 seconds, thereby forming an undercoat layer having a coating amount of 18 mg/$m^2$ after the drying of the solution.

<Undercoat layer coating solution (4)>

- · Polymer (the following structure) 0.3 pbm
- · Pure water 60.0 pbm
- · Methanol 939.7 pbm

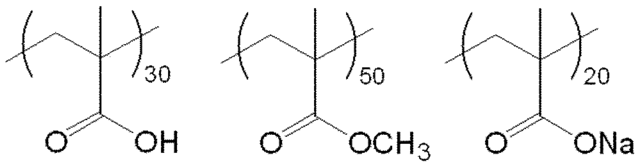

Mw = 31,000

<Formation of non-photosensitive layer>

The undercoat layer was bar-coated with a non-photosensitive layer coating solution (1) with the following composition and dried at 100°C for 60 seconds, thereby forming a non-photosensitive layer. The coating amount after the drying was 1.0 mg/$m^2$.

(Non-photosensitive layer coating solution (1))

- · Binder polymer A (described below) 2.465 pbm
- · Phosphoric acid (85 mass% of aqueous solution) 0.08 pbm
- · Sulfophthalic acid (50 mass% of aqueous solution) 0.017 pbm
- · Tricarballylic acid 0.017 pbm
- · Colorant (VPB-Naps (naphthalene sulfonate of Victoria Pure Blue, manufactured by Hodogaya Chemical Co., Ltd.) 0.0014 pbm
- · Fluorine-based surfactant (MEGAFACE F-780-F, manufactured by DIC Corporation, 30 mass% of solution of MEK) 0.009 pbm
- · Methyl ethyl ketone (MEK) 7.93 pbm
- · Methanol 6.28 pbm
- · 1-methoxy-2-propanol (MFG) 2.01 pbm

The binder polymer A is a 16 mass% of solution having MFG and MEK at a mixing ratio of 1:1 for a condensation reaction product (mass average molecular weight: 85,000, acid content: 1.64 meq/g) of four types of monomers (1)-(4) described below.

(1) 4,4-diphenylmethane diisocyanate 37.5 mol%
(2) hexamethylene diisocyanate 12.5 mol%
(3) 2,2-bis(hydroxymethyl)propionic acid 32.5 mol%
(4) tetraethylene glycol 17.5 mol%

<Formation of hydrophilic layer>

The non-photosensitive layer was bar-coated with a hydrophilic layer coating solution (1) having the following composition and dried at 125°C for 75 seconds, thereby forming a non-photosensitive layer. The coating amount after the drying was 1.6 mg/m$^2$. In this manner, a printing key plate precursor of Example 41 was produced.

(Hydrophilic layer coating solution (1))

- · Synthetic mica (SOMASIF ME-100, manufactured by CO-OP CHEMICAL CO., LTD., 8% aqueous dispersion liquid) 94 pbm
- · Polyvinyl alcohol (CKS-50, manufactured by Nippon Synthetic Chemical Industry Co, Ltd., degree of saponification: 99 mol%, degree of polymerization: 300) 58 pbm
- · Carboxy methyl cellulose (CELOGEN PR, manufactured by DKS Co., Ltd.) 24 pbm
- · Surfactant-1 (PLURONIC P-84, manufactured by BASF SE) 2.5 pbm
- · Surfactant-2 (EMALEX 710, manufactured by Nihon Emulsion Co., Ltd.) 5 pbm
- · Pure water 1364 pbm

PLURONIC P-84 described above is an ethylene oxide-propylene oxide block copolymer and EMALEX 710 is a polyoxyethylene lauryl ether.

[Example 42] (not according to the claimed invention)

<Formation of undercoat layer>

A printing key plate precursor of Example 42 was produced in the same manner as in the production of Example 38 except that the infrared absorbent (1) and the polymerization initiator (1) were removed from the image recording layer coating solution (3).

[Examples 43-48]

Planographic printing plate precursors of Examples 43-46 and printing key plate precursors of Examples 47 and 48 were produced by adding ART PEARL J-6PF to each back coat layer of Examples 37-42 as particles other than the tabular particles listed in Table 1.

[Comparative Example 6]

A planographic printing plate precursor of Comparative Example 6 was produced by coating a back coat layer with the back coat layer coating solution of Example 26, from which the tabular particles had been removed.

[Comparative Example 7]

A back coat layer was formed to produce a planographic printing plate precursor in the same manner as in Example 1 except that the back coat layer coating solution of the back coat layer of Example 1 was changed to the back coat layer coating solution (107).

(Preparation of back coat layer coating solution (107))

- · Styrene-methyl methacrylate copolymer 12.71 g
- · SILYSIA 436, manufactured by Fuji Silysia Chemical Ltd. 0.93 g
- · 2-butanone 85.43 g

[Comparative Examples 8-14]

In Comparative Examples 8-14, planographic printing plate precursors of Comparative Examples 8-12 and

printing key plate precursors of Comparative Examples 13 and 14 were respectively produced in the same manner as described above except that the tabular particles were removed from each back coat layer of Examples 37-42.

[Evaluation of printing plate precursor]

The printing plate precursors (the planographic printing plate precursors and the printing key plate precursors) obtained in each example and each comparative example were evaluated in the following manner.

<Scratch resistance>

The scratch resistance was evaluated by performing a scratch test on the plate surface of the printing plate precursor on the back coat layer side. In other words, the scratch test was performed by applying a load of 10-100 g on the back coat layer of the printing plate precursor by increasing 10 g each time using a continuous load type scratch strength tester (SB-53, manufactured by Shinto Scientific Co., Ltd.) under conditions of a sapphire needle having a diameter of 0.1 mm and a needle moving speed of 10 cm/sec, the load of occurrence of scratches was visually observed, and the scratch resistance was evaluated based on the following standards. The value of 3 is a practical lower limit level and the value of 2 or less is a practically unacceptable level.

5: The back coat layer was not scratched even at a load of 100 g.
4: The back coat layer was scratched at a load of 80-100 g.
3: The back coat layer was scratched at a load of 50-70 g.
2: The back coat layer was scratched at a load of 20-40 g.
1: The back coat layer was scratched at a load of 10 g.

<Abrasion resistance>

After the humidity of the printing plate precursor was adjusted in an environment of 25° at 60%RH for 2 hours, the precursor was punched into a size of 2.5 cm × 2.5 cm and attached to a continuous load type scratch resistance strength tester TYPE: 18 (manufactured by Shinto Scientific Co., Ltd.), the printing surface side of the punched printing plate precursor was set on the surface of the back coat layer of the printing plate precursor which had not been punched such that the printing surface side thereof was brought into contact with the surface of the back coat layer, and several sites of the printing plate precursor were damaged at a load of 0-1000 gf. The degree of damage to the back coat layer was visually observed. The evaluation was performed based on the following standard. The value of 3 is a practical lower limit level and the value of 2 or less is a practically unacceptable level.

5: Peeling was not found.
4: Although peeling was not visually confirmed, peeling which was able to be confirmed using a 50 magnification loupe was found at one site.
3: Although peeling was not visually confirmed, peeling which was able to be confirmed using a 50 magnification loupe was found at several sites.
2: Peeling which was able to be visually confirmed was found at several sites.
1: Peeling was found at several sites over the entire surface.

<Measurement of arithmetic average height Sa of layer containing tabular particles>

The arithmetic average height Sa of the layer containing tabular particles was measured in conformity with the method described in ISO 25178. In other words, three or more sites were selected from the same sample using MICROMAP MM3200-M100 (manufactured by Mitsubishi Chemical Systems, Inc.), the heights thereof were measured, and the average value thereof was set as the arithmetic average height Sa. As the measurement range, a range with a size of 1 cm × 1 cm randomly selected from the sample surface was measured.
The evaluation results were listed in Table 1.

[Table 7]

Table 1

| | Support | Printing urface side | | Non-printing surface side | | | | | | | | | | | | |
|---|---|---|---|---|---|---|---|---|---|---|---|---|---|---|---|---|
| | | | | Layer component | | | Tabular particles | | | | | Particles other than tabular particles | | | | |
| | Type | Layer containing polymer | protective layer | Type | Detail | Thickness (μm) | Type | Detail | Thickness (nm) | aspect ratio | Addition amount (mg/m$^2$) | Type | Detail | Thickness (nm) | Aspect ratio | Addition amount (mg/m$^2$) |
| Example 1 | 1 | Layer 1 | None | PVA-405 | Polyvinil alcohol | 1.2 | SOMASIF MEB-3 | Mica | 10 | 300 | 100 | None | | | | |
| Example 2 | 1 | Layer 1 | None | PVA-405 | Polyvinyl alcohol | 1.2 | SUMECTON-SWF | Smectite | 1 | 50 | 100 | None | | | | |
| Example 13 | 1 | Layer 1 | None | MMA/MAA copolymer | MMA/MAA copolymer | 1.2 | SOMASIF MEE | Organic mica | 10 | 300 | 100 | None | | | | |
| Example 17 | 1 | Layer 1 | None | MMA/MAA copolymer | MMA/MAA copolymer | 1.2 | SUMECTON-STN | Organic smectite | 1 | 50 | 100 | None | | | | |
| Example 26 | 1 | Layer 1 | None | Metal oxide | Metal oxide | 1.5 | SUMECTON-STN | Organic smectite | 1 | 50 | 100 | ART PEARL J-7P | Silica-coated acrylic | 6 | 1 | 50 |
| Example 27 | 1 | Layer 1 | None | Metal oxide | Metal oxide | 1.5 | SUMECTON-STN | Organic smectite | 1 | 50 | 100 | SILYSIA 440 | Silica | 6 | 1.4 | 50 |
| Example 28 | 1 | Layer 1 | None | MMA/MAA copolymer | MMA/MAA copolymer | 1.2 | SUMECTON-STN | Organic smectite | 1 | 50 | 100 | OPTBEADS 3500M | Silica-coated melamine | 3.5 | 1 | 50 |
| Example 29 | 1 | Layer 1 | None | MMA/MAA copolymer | MMA/MAA copolymer | 1.2 | SUMECTON-STN | Organic smectite | 1 | 50 | 100 | TOSPEARL 145 | Methyl group-modined silica | 4.5 | 1 | 50 |
| Example 30 | 1 | Layer 1 | None | MMA/MAA copolymer | MMA/MAA copolymer | 1.2 | SUMECTON-STN | Organic smectite | 1 | 50 | 10 | ART PEARL 6PF | Acrylic | 4 | 1 | 50 |

(continued)

| | Support | Printing urface side | | Non-printing surface side | | | | | | | | | | | | |
|---|---|---|---|---|---|---|---|---|---|---|---|---|---|---|---|---|
| | | | | Layer component | | | Tabular particles | | | | | Particles other than tabular particles | | | | |
| | Type | Layer contain-ing poly-mer | protec-tive layer | Type | Detail | Thick-ness (μm) | Type | Detail | Thick-ness (nm) | aspect ratio | Addi-tion amount ($mg/m^2$) | Type | Detail | Thick-ness (nm) | Aspect ratio | Addi-tion amount ($mg/m^2$) |
| Exam-ple 31 | 1 | Layer 1 | None | MMA/MAA copoly-mer | MMA/MAA copoly-mer | 1.2 | SUMEC-TON-STN | Organic smectite | 1 | 50 | 100 | ART PEARL 6PF | Acrylic | 4 | 1 | 50 |
| Example 32 | 1 | Layer 1 | None | MMA/MAA copoly-mer | MMA/MAA copoly-mer | 1.2 | SUMEC-TON-STN | Organic smectite | 1 | 50 | 300 | ART PEARL 6PF | Acrylic | 4 | 1 | 50 |

[Table 8]

Table 1

| | Support | Printing surrace side | | Non-printing surface side | | | | | | | | | | | | | |
|---|---|---|---|---|---|---|---|---|---|---|---|---|---|---|---|---|---|
| | | | | Layer component | | | Tabular particles | | | | | Particles other than tabular particles | | | | |
| | Type | Layer containing polymer | Protective layer | Type | Detail | Thickness | Type | Detail | Thickness | Aspect | Addition amount | Type | Detail | Thickness (nm) | Aspect ratio | Addition amount (mg/$m^2$) |
| Example 33 | 1 | Layer 1 | None | MMA/MAA copolymer | MMA/MAA copolymer | 1.2 | SUMECTON-STN | Organic smectite | 1 | 50 | 500 | AKI PEARL 6PF | Acrylic | 4 | 1 | 50 |
| Example 34 | 1 | Layer 1 | None | MMA/MAA copolymer | MMA/MAA copolymer | 1.2 | SUMECTON-STN | organic smectite | 1 | 50 | 100 | ART PEARL 6PF | Acrylic | 4 | 1 | 100 |
| Example 35 | 1 | Layer 1 | None | MMA/MAA copolymer | MMA/MAA copolymer | 2 | SUMECTON-STN | organic smectite | 1 | 50 | 100 | ART PEARL J-7P | Silica-coated acrylic | 6 | 1 | 200 |
| Example 36 | 1 | Layer 1 | None | MMAiMAA copolymer | MMA/MAA copolymer | 2 | SUMECTON-STN | organic smectite | 1 | 50 | 100 | Optbeads 3500M | Silica-coated melamine | 6.5 | 1 | 200 |
| Example 37 | 2 | Layer 2 | None | MMA/MAA copolymer | MMA/MAA copolymer | 1.2 | SUMECTON-STN | organic smectite | 1 | 50 | 100 | None | | | | |
| Example 38 | 3 | Layer 3 | Formed | MMA/MAA copolymer | MMA/MAA copolymer | 1.2 | SUMECTON-STN | organic smectite | 1 | 50 | 100 | None | | | | |
| Example 39 | 3 | Layer 4 | Formed | MMA/MAA copolymer | MMA/MAA copolymer | 1.2 | SUMECTON-STN | organic smectite | 1 | 50 | 100 | None | | | | |

(continued)

| | Support | Printing surrace side | | Non-printing surface side | | | | | | | | | | | | | |
|---|---|---|---|---|---|---|---|---|---|---|---|---|---|---|---|---|---|
| | | | | Layer component | | | Tabular particles | | | | | Particles other than tabular particles | | | | |
| | Type | Layer containing polymer | Protective layer | Type | Detail | Thickness | Type | Detail | Thickness | Aspect | Addition amount | Type | Detail | Thickness (nm) | Aspect ratio | Addition amount (mg/m2) |
| Example 40 | 3 | Layer 5 | Formed | MMA/MAA copolymer | MMA/MAA copolymer | 1.2 | SUMEC-TON-STN | organic smec-tite | 1 | 50 | 100 | None | | | | |
| Example 41 | 3 | Layer 6 | Formed | MMA/MAA copolymer | MMA/MAA copolymer | 1.2 | SUMEC-TON-STN | organic smec-tite | 1 | 50 | 100 | None | | | | |
| Example 42 | 3 | Layer 7 | Formed | MMA/MAA copolymer | MMA/MAA copolymer | 1.2 | SUMEC-TON-STN | organic smec-tite | 1 | 50 | 100 | None | | | | |
| Example 43 | 2 | Layer 2 | None | MMA/MAA copolymer | MMA/MAA copolymer | 1.2 | SUMEC-TON-STN | organic smec-tite | 1 | 50 | 100 | ART PEARL 6PF | Acrylic | 4 | 1 | 100 |
| Example 44 | 3 | Layer 3 | Formed | MMA/MAA copolymer | MMA/MAA copolymer | 1.2 | SUMEC-TON-STN | organic smec-tite | 1 | 50 | 100 | ART PEARL 6PF | Acrylic | 4 | 1 | 100 |
| Example 45 | 3 | Layer 4 | Formed | MMA/MAA copolymer | MMA/MAA copolymer | 1.2 | SUMEC-TON-STN | Organic smec-tite | 1 | 50 | 100 | ART PEARL 6PF | Acrylic | 4 | 1 | 100 |
| Example 46 | 3 | Layer 5 | Formed | MM.4iMAA copolymer | MMA/MAA copolymer | 1.2 | SUMEC-TON-STN | organic smec-tite | 1 | 50 | 100 | ART PEARL 6PF | Acrylic | 4 | 1 | 100 |
| Example 47 | 3 | Layer 6 | Formed | MMA/MAA copolymer | MMA/MAA copolymer | 1.2 | SUMEC-TON-STN | organic smec-tite | 1 | 50 | 100 | ART PEARL 6PF | Acrylic | 4 | 1 | 100 |

(continued)

| | Support | Printing surface side | | Non-printing surface side | | | | | | | | | | | | |
|---|---|---|---|---|---|---|---|---|---|---|---|---|---|---|---|---|
| | | | | Layer component | | | Tabular particles | | | | | Particles other than tabular particles | | | | |
| | Type | Layer containing polymer | Protective layer | Type | Detail | Thickness | Type | Detail | Thickness | Aspect | Addition amount | Type | Detail | Thickness (nm) | Aspect ratio | Addition amount (mg/m$^2$) |
| Example 48 | 3 | Layer 7 | Formed | MMA/MAA copolymer | MMA/MAA copolymer | 1.2 | SUMECTON-STN | organic smectite | 1 | 50 | 100 | ART PEARL 6PF | Acrylic | 4 | 1 | 100 |
| Comparative Example 6 | 1 | Layer 1 | None | Metal oxide | Metal oxide | 1.5 | None | | | | | ART PEARL J-7P | Silica-coated acrylic | 6 | 1 | 50 |
| Comparative Example 7 | 1 | Layer 1 | None | Styrene-methyl methacrylate copolymer | Styrene-methyl methacrylate copolymer | 1.2 | None | | | | | SILYSIA 436 | Silica gel | 4 | 1.4 | 40 |
| Comparative Example 8 | 2 | Layer 2 | None | MMA/MAA copolymer | MMA/MAA copolymer | 1.2 | None | | | | | None | | | | |
| Comparative Example 9 | 3 | Layer 3 | Formed | MMA/MAA copolymer | MMA/MAA copolymer | 1.2 | None | | | | | None | | | | |
| Comparative Example 10 | 3 | Layer 4 | Formed | MMA/MAA copolymer | MMA/MAA copolymer | 1.2 | None | | | | | None | | | | |
| Comparative Example 12 | 3 | Layer 5 | Formed | MMA/MAA copolymer | MMA/MAA copolymer | 1.2 | None | | | | | None | | | | |
| Comparative Example 13 | 3 | Layer 6 | Formed | MMA/MAA copolymer | MMA/MAA copolymer | 1.2 | None | | | | | None | | | | |

(continued)

| | Support | Printing surrace side | | Non-printing surface side | | | | | | | | | | | | | |
|---|---|---|---|---|---|---|---|---|---|---|---|---|---|---|---|---|---|
| | | | | Layer component | | | Tabular particles | | | | | Particles other than tabular particles | | | | |
| | Type | Layer containing polymer | Protective layer | Type | Detail | Thickness | Type | Detail | Thickness | Aspect | Addition amount | Type | Detail | Thickness (nm) | Aspect ratio | Addition amount ($mg/m^2$) |
| Comparative Example 14 | 3 | Layer 7 | Formed | MMA/MAA copolymer | MMA/MAA copolymer | 1.2 | None | | | | | None | | | | |

[Table 9]

| Table 1 (continued) | | | |
|---|---|---|---|
| | Evaluation result | | |
| | Sa | Scratch resistance | Abrasion resistance |
| Example 1 | 0.15 | 4 | 4 |
| Example 2 | 0.15 | 4 | 4 |
| Example 13 | 0.15 | 4 | 4 |
| Example 17 | 0.15 | 4 | 4 |
| Example 26 | 4.2 | 5 | 5 |
| Example 27 | 4.2 | 5 | 5 |
| Example 28 | 1.2 | 5 | 5 |
| Example 29 | 1.7 | 5 | 5 |
| Example 30 | 1.4 | 3 | 3 |
| Example 31 | 1.4 | 5 | 5 |
| Example 32 | 1.4 | 5 | 5 |
| Example 33 | 1.4 | 5 | 5 |
| Example 34 | 1.7 | 4 | 4 |
| Example 35 | 2 | 5 | 5 |
| Example 36 | 2.5 | 5 | 5 |
| Example 37 | 0.15 | 4 | 4 |
| Example 38 | 0.15 | 4 | 4 |
| Example 39 | 0.15 | 4 | 4 |
| Example 40 | 0.15 | 4 | 4 |
| Example 41 | 0.15 | 4 | 4 |
| Example 42 | 0.15 | 4 | 4 |
| Example 43 | 1.5 | 5 | 5 |
| Example 44 | 1.5 | 5 | 5 |
| Example 45 | 1.5 | 5 | 5 |
| Example 46 | 1.5 | 5 | 5 |
| Example 47 | 1.5 | 5 | 5 |
| Example 48 | 1.5 | 5 | 5 |
| Comparative Example 6 | 2.5 | 2 | 2 |
| Comparative Example 7 | 1.5 | 2 | 2 |
| Comparative Example 8 | 0.1 | 2 | 2 |
| Comparative Example 9 | 0.1 | 2 | 2 |
| Comparative Example 10 | 0.1 | 2 | 2 |
| Comparative Example 12 | 0.1 | 2 | 2 |
| Comparative Example 13 | 0.1 | 2 | 2 |
| Comparative Example 14 | 0.1 | 2 | 2 |

<Production of supports 4-12>

Each aluminum plate (aluminum alloy plate) formed of the material 1S with a thickness of 0.3 mm was subjected to any of the following treatments, thereby producing supports 4-12. Moreover, during all treatment steps, a water washing treatment was performed, and liquid cutting was performed using a nip roller after the water washing treatment.

<Treatment A: production of supports 4-6>

(A-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 g/m$^2$.

(A-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid concentration of 150 g/L. The solution temperature was 30°C.

(A-c) Electrochemical roughening treatment using hydrochloric acid aqueous solution

Next, an electrochemical roughening treatment was performed using the AC current and an electrolyte having a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 A/dm$^2$ in terms of the peak current value of the AC current waveform. Further, the sum total of electric quantity of the aluminum plate used for the anodic reaction was 450 C/dm$^2$, and the electrolytic treatment was performed four times at energization intervals of 4 seconds for each of the electric quantity of 112.5 C/dm$^2$. A carbon electrode was used as a counter electrode of the aluminum plate. Thereafter, a water washing treatment was performed.

(A-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. Thereafter, washing with water by spraying was performed. The dissolved aluminum amount of the surface to be subjected to an electrochemical roughening treatment was 0.2 g/m$^2$.

(A-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used for the desmutting treatment, a waste liquid generated in the anodizing treatment step (an aqueous solution having a sulfuric acid concentration of 170 g/L and an aluminum ion concentration of 5 g/L) was used. The solution temperature was 30°C.

(A-f) Anodizing treatment

An anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table F.

An aluminum plate 416 in an anodizing device 410 illustrated in Fig. 1 is transported as indicated by the arrow

in Fig. 1. The aluminum plate 416 is positively (+) charged by a power supply electrode 420 in a power supply tank 412 in which an electrolyte 418 is stored. Further, the aluminum plate 416 is transported upward by a roller 422 in the power supply tank 412, redirected downward by a nip roller 424, transported toward an electrolytic treatment tank 414 in which an electrolyte 426 was stored, and redirected to the horizontal direction by a roller 428. Next, the aluminum plate 416 is negatively (-) charged by an electrolytic electrode 430 so that an anodized film is formed on the surface thereof, and the aluminum plate 416 coming out of the electrolytic treatment tank 414 is transported to the next step. In the anodizing device 410, direction changing means is formed of the roller 422, the nip roller 424, and the roller 428. The aluminum plate 416 is transported in a mountain shape and an inverted U shape by the roller 422, the nip roller 424, and the roller 428 in an inter-tank portion between the power supply tank 412 and the electrolytic treatment tank 414. The power supply electrode 420 and the electrolytic electrode 430 are connected to a DC power source 434.

[Table 11]

| Table F | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperature (°C) | Current density (A/dm$^2$) | Coating amount (g/m$^2$) |
| Support 7 | 170 | - | 50 | 30 | 0.3 |

(A-g) Pore widening treatment

The aluminum plate after having been subjected to the anodizing treatment was subjected to a pore widening treatment by being immersed in a caustic soda aqueous solution in which the concentration of caustic soda was 5 mass% and the concentration of aluminum ions was 0.5 mass% at a temperature listed in Table G under a time condition listed in Table G. Thereafter, washing with water by spraying was performed.

[Table 12]

| Table G | | |
|---|---|---|
| Support | Pore widening treatment | |
| | Temperature (°C) | Time (second) |
| Support 4 | 28 | 3 |
| Support 5 | 40 | 3 |
| Support 6 | 40 | 15 |

<Treatment (B): production of support 7>

(B-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 g/m$^2$.

(B-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid concentration of 150 g/L. The solution temperature was 30°C.

(B-c) Electrochemical roughening treatment using hydrochloric acid aqueous solution

Next, an electrochemical roughening treatment was performed using the AC current and an electrolyte having a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 A/$dm^2$ in terms of the peak current value of the AC current waveform. Further, the total electric quantity of the aluminum plate used for the anodic reaction was 450 C/$dm^2$, and the electrolytic treatment was performed four times at energization intervals of 4 seconds for each of the electric quantity of 112.5 C/$dm^2$. A carbon electrode was used as a counter electrode of the aluminum plate. Thereafter, a water washing treatment was performed.

(B-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. Thereafter, washing with water by spraying was performed. The dissolved aluminum amount of the surface to be subjected to an electrochemical roughening treatment was 0.2 g/$m^2$.

(B-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used for the desmutting treatment, a waste liquid generated in the anodizing treatment step (an aqueous solution having a sulfuric acid concentration of 170 g/L and an aluminum ion concentration of 5 g/L) was used. The solution temperature was 30°C.

(B-f) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of the "first anodizing treatment" listed in Table H.

[Table 13]

| Table H | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperature (°C) | Current density (A/$dm^2$) | Coating amount (g/$m^2$) |
| Support 7 | 170 | - | 50 | 30 | 0.3 |

(B-g) Pore widening treatment

The aluminum plate after being subjected to the anodizing treatment was subjected to a pore widening treatment by being immersed in a caustic soda aqueous solution in which the concentration of caustic soda was 5 mass% and the concentration of aluminum ions was 0.5 mass% at a temperature of 40°C under a time condition listed in Table I. Thereafter, washing with water by spraying was performed.

[Table 14]

| Table I | | |
|---|---|---|
| Support | Pore widening treatment | |
| | Temperature (°C) | Time (second) |
| Support 7 | 40 | 3 |

(B-h) Second step of anodizing treatment

A second step of an anodizing treatment was performed with an anodizing device using DC electrolysis having the structure shown in Fig. 1. An anodized film having a predetermined coating amount was formed by performing an anodizing treatment under conditions in the columns of the "second anodizing treatment" listed in Table J.

[Table 15]

| Table J | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperature (°C) | Current density (A/dm$^2$) | Coating amount (g/m$^2$) |
| Support 7 | 170 | - | 50 | 13 | 2.1 |

<Treatment D: production of support 8>

(D-a) Mechanical roughening treatment (brush grain method)

Using the device shown in Fig. 2, while supplying a suspension of pumice (specific gravity of 1.1 g/cm$^3$) to the surface of an aluminum plate as a polishing slurry liquid, a mechanical roughening treatment was performed using rotating bundle bristle brushes. In Fig. 2, the reference numeral 1 represents an aluminum plate, the reference numerals 2 and 4 represent roller-like brushes (in the present examples, bundle bristle brushes), the reference numeral 3 represents a polishing slurry liquid, and the reference numerals 5, 6, 7, and 8 represent a support roller.

The mechanical roughening treatment is performed under conditions in which the median diameter (μm) of a polishing material was 30 μm, the number of the brushes was four, and the rotation speed (rpm) of the brushes was set to 250 rpm. The material of the bundle bristle brushes was nylon 6 10, the diameter of the brush bristles was 0.3 mm, and the bristle length was 50 mm. The brushes were produced by implanting bristles densely into holes in a stainless steel cylinder having a diameter of φ300 mm. The distance between two support rollers (φ200 mm) of the lower portion of the bundle bristle brushes was 300 mm. The bundle bristle brushes were pressed until the load of a driving motor for rotating the brushes became 10 kW plus with respect to the load before the bundle bristle brushes were pressed against the aluminum plate. The rotation direction of the brush was the same as the moving direction of the aluminum plate.

(D-b) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 10 g/m$^2$.

(D-c) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a waste liquid of nitric acid used in electrochemical roughening treatment of the subsequent step was used. The solution temperature was 35°C.

(D-d) Electrochemical roughening treatment using nitric acid aqueous solution

An electrochemical roughening treatment was continuously performed using an AC voltage of 60 Hz in nitric acid electrolysis. An electrolyte which had been adjusted to have a concentration of aluminum ions of 4.5 g/L by adding aluminum nitrate to a nitric acid aqueous solution having a concentration of 10.4 g/L at a solution temperature of 35°C was used. Using a trapezoidal rectangular waveform AC having a time tp, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. In Fig. 3, ta represents an anodic reaction time, tc represents a cathodic reaction time, tp represents a time taken for the current to reach the peak from 0, Ia represents the peak current on an anode cycle side, and Ic represents the peak current on a cathode cycle side. As an electrolytic cell, the electrolytic cell shown in Fig. 4 was used.

In Fig. 4, the reference numeral 50 represents a main electrolytic cell, the reference numeral 51 represents an AC power source, the reference numeral 52 represents a radial drum roller, the reference numerals 53a and 53b represent a main pole, the reference numeral 54 represents an electrolyte supply port, the reference numeral 55 represents an electrolyte, the reference numeral 56 represents a slit, the reference numeral 57 represents an electrolyte passage, the reference numeral 58 represents an auxiliary anode, the reference numeral 60 represents an auxiliary anode cell, and the symbol W represents an aluminum plate.

The current density was 30 $A/dm^2$ as the peak current value, and 5% of the current from the power source was separately flowed to the auxiliary anode. The electric quantity ($C/dm^2$) was 185 $C/dm^2$ as the sum total of electric quantity at the time of anodization of the aluminum plate.

(D-e) Alkali etching treatment

The obtained aluminum plate was subjected to an etching treatment by spraying a caustic soda aqueous solution in which the concentration of caustic soda was 27 mass% and the concentration of aluminum ions was 2.5 mass% using a spray at a temperature of 50°C. Thereafter, washing with water by spraying was performed. The amount of aluminum dissolved was 0.5 $g/m^2$.

(D-f) Desmutting treatment using acidic aqueous solution

Next, a desmutting treatment was performed using a sulfuric acid aqueous solution. Specifically, the desmutting treatment was performed for 3 seconds by spraying the sulfuric acid aqueous solution to an aluminum plate using a spray. As the sulfuric acid aqueous solution used in the desmutting treatment, a solution in which the concentration of sulfuric acid was 170 g/L and the concentration of aluminum ions was 5 g/L was used. The solution temperature was 30°C.

(D-g) Electrochemical roughening treatment using hydrochloric acid aqueous solution

An electrochemical roughening treatment was continuously performed using an AC voltage of 60 Hz in hydrochloric acid electrolysis. An electrolyte which had been adjusted to have a concentration of aluminum ions of 4.5 g/L by adding aluminum chloride to a hydrochloric acid aqueous solution having a concentration of 6.2 g/L, and of which the solution temperature was 35°C was used. Using a trapezoidal rectangular waveform AC having a time tp, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. As an electrolytic cell, the electrolytic cell shown in Fig. 4 was used. The current density was 25 $A/dm^2$ as the peak current value, and the electric quantity ($C/dm^2$) in the hydrochloric acid electrolysis was 63 $C/dm^2$ as the sum total of electric quantity at the time of anodization of the aluminum plate. Thereafter, washing with water by spraying was performed.

(D-h) Alkali etching treatment

The obtained aluminum plate was subjected to an etching treatment by spraying a caustic soda aqueous solution in which the concentration of caustic soda was 5 mass% and the concentration of aluminum ions was 0.5 mass% using a spray at a temperature of 60°C. Thereafter, washing with water by spraying was performed. The amount of aluminum dissolved was 0.1 $g/m^2$.

(D-i) Desmutting treatment using acidic aqueous solution

Next, a desmutting treatment was performed using a sulfuric acid aqueous solution. Specifically, the desmutting treatment was performed for 4 seconds by spraying the sulfuric acid aqueous solution to an aluminum plate using a spray. As the sulfuric acid aqueous solution used for the desmutting treatment, a waste liquid generated in the anodizing treatment step (an aqueous solution having a sulfuric acid concentration of 170 g/L and an aluminum ion concentration of 5 g/L) was used. The solution temperature was 35°C.

(D-j) Anodizing treatment

An anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table K.

[Table 16]

| Table K | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperat ure (°C) | Current density (A/dm$^2$) | Coating amount (g/m$^2$) |
| Support 8 | 170 | - | 50 | 30 | 2.4 |

(D-k) Pore widening treatment

The aluminum plate after being subjected to the anodizing treatment was subjected to a pore widening treatment by being immersed in a caustic soda aqueous solution in which the concentration of caustic soda was 5 mass% and the concentration of aluminum ions was 0.5 mass% at a temperature of 40°C for 3 seconds. Thereafter, washing with water by spraying was performed.

(D-1) Hydrophilization treatment

In order to ensure hydrophilicity of a non-image area, the obtained aluminum plate was subjected to a silicate treatment by being dipped in 2.5 mass% of a No. 3 sodium silicate aqueous solution at 50°C for 7 seconds. The adhesion amount of Si was 8.5 mg/m$^2$. Thereafter, washing with water by spraying was performed.

<Treatment (F): production of support 9>

(F-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 g/m$^2$.

(F-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid of 150 g/L. The solution temperature was 30°C.

(F-c) Electrochemical roughening treatment

Next, an electrochemical roughening treatment was performed using the AC current and an electrolyte having

a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 A/$dm^2$ in terms of the peak current value of the AC current waveform. Further, the sum total of electric quantity of the aluminum plate used for the anodic reaction was 450 C/$dm^2$, and the electrolytic treatment was performed four times at energization intervals of 4 seconds for each of the electric quantity of 112.5 C/$dm^2$. A carbon electrode was used as a counter electrode of the aluminum plate. Thereafter, a water washing treatment was performed.

(F-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. The dissolved aluminum amount of the surface to be subjected to an electrochemical roughening treatment was 0.2 g/$m^2$. Thereafter, a water washing treatment was performed.

(F-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a solution in which the concentration of sulfuric acid was 170 g/L and the concentration of aluminum ions was 5 g/L was used. The solution temperature was 35°C.

(F-f) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table L.

[Table 17]

| Table L | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperat ure (°C) | Current density (A/$dm^2$) | Coating amount (g/$m^2$) |
| Support 9 | - | 150 | 35 | 4.5 | 1 |

(F-g) Second step of anodizing treatment

A second step of an anodizing treatment was performed with an anodizing device using DC electrolysis having the structure shown in Fig. 1. An anodized film having a predetermined coating amount was formed by performing an anodizing treatment under conditions in the columns of the "second anodizing treatment" listed in Table M.

[Table 18]

| Table M | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperat ure (°C) | Current density (A/dm$^2$) | Coating amount (g/m$^2$) |
| Support 9 | 170 | - | 50 | 13 | 2.1 |

<Treatment (G): production of support 10>

(G-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 g/m$^2$.

(G-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid of 150 g/L. The solution temperature was 30°C.

(G-c) Electrochemical roughening treatment

Next, an electrochemical roughening treatment was performed using the AC current and an electrolyte having a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 A/dm$^2$ in terms of the peak current value of the AC current waveform. Further, the sum total of electric quantity of the aluminum plate used for the anodic reaction was 450 C/dm$^2$, and the electrolytic treatment was performed four times at energization intervals of 4 seconds for each of the electric quantity of 112.5 C/dm$^2$. A carbon electrode was used as a counter electrode of the aluminum plate. Thereafter, a water washing treatment was performed.

(G-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. The dissolved aluminum amount of the surface to be subjected to an electrochemical roughening treatment was 0.2 g/m$^2$. Thereafter, a water washing treatment was performed.

(G-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a solution in which the concentration of sulfuric acid was 170 g/L and the concentration of aluminum ions was 5 g/L was used. The solution temperature was 35°C.

(G-f) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table N.

[Table 19]

| Table N | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperature (°C) | Current density (A/dm$^2$) | Coating amount (g/m$^2$) |
| Support 10 | - | 150 | 35 | 4.5 | 1 |

(G-g) Pore widening treatment

The aluminum plate after being subjected to the anodizing treatment was subjected to a pore widening treatment by being immersed in a caustic soda aqueous solution in which the concentration of caustic soda was 5 mass% and the concentration of aluminum ions was 0.5 mass% at a temperature of 40°C under a time condition listed in Table O. Thereafter, washing with water by spraying was performed.

[Table 20]

| Table O | | |
|---|---|---|
| Support | Pore widening treatment | |
| | Temperature (°C) | Time (second) |
| Support 10 | 40 | 4 |

(G-h) Second step of anodizing treatment

A second step of an anodizing treatment was performed with an anodizing device using DC electrolysis having the structure shown in Fig. 1. An anodized film having a predetermined coating amount was formed by performing an anodizing treatment under conditions in the columns of "second anodizing treatment" listed in Table P.

[Table 21]

| Table P | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperature (°C) | Current density (A/dm$^2$) | Coating amount (g/m$^2$) |
| Support 10 | 170 | - | 50 | 13 | 2.1 |

<Treatment (H): production of support 11>

(H-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 g/m$^2$.

(H-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid of 150 g/L. The solution temperature was 30°C.

(H-c) Electrochemical roughening treatment

Next, an electrochemical roughening treatment was performed using the AC current and an electrolyte having a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 A/$dm^2$ in terms of the peak current value of the AC current waveform. Further, the sum total of electric quantity of the aluminum plate used for the anodic reaction was 450 C/$dm^2$, and the electrolytic treatment was performed four times at energization intervals of 4 seconds for each of the electric quantity of 112.5 C/$dm^2$. A carbon electrode was used as a counter electrode of the aluminum plate. Thereafter, a water washing treatment was performed.

(H-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. The dissolved aluminum amount of the surface to be subjected to an electrochemical roughening treatment was 0.2 g/$m^2$. Thereafter, a water washing treatment was performed.

(H-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a solution in which the concentration of sulfuric acid was 170 g/L and the concentration of aluminum ions was 5 g/L was used. The solution temperature was 35°C.

(H-f) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table Q.

[Table 22]

| Table Q | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperat ure (°C) | Current density (A/$dm^2$) | Coating amount (g/$m^2$) |
| Support 11 | - | 150 | 35 | 4.5 | 1 |

(H-g) Second step of anodizing treatment

A second step of an anodizing treatment was performed with an anodizing device using DC electrolysis having the structure shown in Fig. 1. An anodized film having a predetermined coating amount was formed by performing an

anodizing treatment under conditions in the columns of the "second anodizing treatment" listed in Table R.

[Table 23]

| Table R | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperat ure (°C) | Current density ($A/dm^2$) | Coating amount ($g/m^2$) |
| Support 11 | - | 150 | 35 | 4.5 | 1.2 |

<Treatment (I): production of support 12>

(I-a) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 5 $g/m^2$.

(I-b) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. The acidic aqueous solution used in the desmutting treatment was an aqueous solution having a sulfuric acid of 150 g/L. The solution temperature was 30°C.

(I-c) Electrochemical roughening treatment

Next, an electrochemical roughening treatment was performed using the AC current and an electrolyte having a hydrochloric acid concentration of 14 g/L, an aluminum ion concentration of 13 g/L, and a sulfuric acid concentration of 3 g/L. The solution temperature of the electrolyte was 30°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 75 $A/dm^2$ in terms of the peak current value of the AC current waveform. Further, the sum total of electric quantity of the aluminum plate used for the anodic reaction was 450 $C/dm^2$, and the electrolytic treatment was performed four times at energization intervals of 4 seconds for each of the electric quantity of 112.5 $C/dm^2$. A carbon electrode was used as a counter electrode of the aluminum plate. Thereafter, a water washing treatment was performed.

(I-d) Alkali etching treatment

The aluminum plate after the electrochemical roughening treatment was subjected to an etching treatment by spraying a caustic soda aqueous solution in which the concentration of caustic soda was 5 mass% and the concentration of aluminum ions was 0.5 mass% using a spray tube at a temperature of 45°C. The dissolved aluminum amount of the surface to be subjected to an electrochemical roughening treatment was 0.2 $g/m^2$. Thereafter, a water washing treatment was performed.

(I-e) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a solution in which the concentration of sulfuric acid was 170 g/L and the concentration of aluminum ions was 5 g/L was used. The solution temperature was 35°C.

(I-f) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table S.

[Table 24]

| Table S | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperature (°C) | Current density ($A/dm^2$) | Coating amount ($g/m^2$) |
| Support 12 | - | 150 | 35 | 4.5 | 1 |

(I-g) Pore widening treatment

The aluminum plate after being subjected to the anodizing treatment was subjected to a pore widening treatment by being immersed in a caustic soda aqueous solution in which the concentration of caustic soda was 5 mass% and the concentration of aluminum ions was 0.5 mass% at a temperature of 40°C under a time condition listed in Table T. Thereafter, washing with water by spraying was performed.

[Table 25]

| Table T | | |
|---|---|---|
| Support | Pore widening treatment | |
| | Temperature (°C) | Time (second) |
| Support 12 | 40 | 8 |

(I-h) Second step of anodizing treatment

A second step of an anodizing treatment was performed with an anodizing device using DC electrolysis having the structure shown in Fig. 1. An anodized film having a predetermined coating amount was formed by performing an anodizing treatment under conditions in the columns of the "second anodizing treatment" listed in Table U.

[Table 26]

| Table U | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperature (°C) | Current density ($A/dm^2$) | Coating amount ($g/m^2$) |
| Support 12 | - | 150 | 35 | 4.5 | 2.1 |

<Production of support 13>

-Aluminum plate-

A molten metal was prepared using an aluminum alloy containing 0.06 mass% of Si, 0.30 mass% of Fe, 0.005 mass% of Cu, 0.001 mass% of Mn, 0.001 mass% of Mg, 0.001 mass% of Zn, and 0.03 mass% of Ti and, as the remainder, aluminum and unavoidable impurities, a molten metal treatment and filtration were performed, and an ingot having a thickness of 500 mm and a width of 1200 mm was produced according to a DC casting method. The surface was scraped

off using a surface grinder having an average thickness of 10 mm and heated at 550°C and maintained the state for approximately 5 hours. After the temperature was decreased to 400°C, a rolled sheet having a thickness of 2.7 mm was obtained using a hot rolling mill. Further, a heat treatment was performed thereon at 500°C using a continuous annealing machine, and a cold rolling was performed so that the thickness of the rolled sheet was finished to 0.24 mm, thereby obtaining an aluminum plate formed of JIS 1050 material. The following surface treatment was performed after the width of this aluminum plate was adjusted to 1030 mm.

-Surface treatment-

The surface treatment was performed by continuously performing the following treatments (b)-(j).
Further, liquid cutting was performed using a nip roller after each treatment and washing with water.

(b) Alkali etching treatment

The aluminum plate obtained in the above-described manner was subjected to an etching treatment by spraying an aqueous solution in which the concentration of caustic soda was 2.6 mass% and the concentration of aluminum ions was 6.5 mass% at a temperature of 70°C so that 6 $g/m^2$ of the aluminum plate was dissolved. Thereafter, washing with water by spraying was performed.

(c) Desmutting treatment

A desmutting treatment was performed by spraying an aqueous solution (containing 0.5 mass% of aluminum ions) having a nitric acid concentration of 1 mass% at a temperature of 30°C. Thereafter, washing with water by spraying was performed. As the nitric acid aqueous solution used for the desmutting treatment, a waste liquid used for the step of performing the electrochemical roughening treatment using the alternating current in a nitric acid aqueous solution was used.

(d) Electrochemical roughening treatment

An electrochemical roughening treatment was continuously performed using an AC voltage of 60 Hz. As an electrolyte at this time, an aqueous solution containing 10.5 g/L of nitric acid (containing 5 g/L of aluminum ions and 0.007 mass% of ammonium ions) was used, and the solution temperature was 50°C. Using a trapezoidal rectangular waveform AC having a time TP, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. As an electrolytic cell to be used, the electrolytic cell shown in Fig. 4 was used. The current density was 30 $A/dm^2$ as the peak current value, and the electric quantity was 220 $C/dm^2$ as the sum total of electric quantity at the time of anodization of the aluminum plate. 5% of the current from the power source was separately flowed to the auxiliary anode. Thereafter, washing with water by spraying was performed.

(e) Alkali etching treatment

The aluminum plate was subjected to an etching treatment by spraying an aqueous solution in which the concentration of caustic soda was 26 mass% and the concentration of aluminum ions was 6.5 mass% at a temperature of 32°C so that 0.25 $g/m^2$ of the aluminum plate was dissolved. Further, a smut component mainly containing aluminum hydroxide generated at the time of the electrochemical roughening treatment using the alternating current at the former step was removed, an edge portion of a generated pit was dissolved to smooth the edge portion. Thereafter, washing with water by spraying was performed.

(f) Desmutting treatment

A desmutting treatment was performed by spraying an aqueous solution (containing 4.5 mass% of aluminum ions) having a sulfuric acid concentration of 15 mass% at a temperature of 30°C. Thereafter, washing with water was performed using a spray. As the nitric acid aqueous solution used for the desmutting treatment, a waste liquid used for the step of performing the electrochemical roughening treatment using the alternating current in a nitric acid aqueous solution was used.

(g) Electrochemical roughening treatment

An electrochemical roughening treatment was continuously performed using an AC voltage of 60 Hz. As an electrolyte at this time, an aqueous solution containing 2.5 g/L of hydrochloric acid (containing 5 g/L of aluminum ions) was used, and the temperature was 35°C. Using a trapezoidal rectangular waveform AC having a time TP, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. As an electrolytic cell to be used, the electrolytic cell shown in Fig. 4 was used. The current density was 25 $A/dm^2$ as the peak current value, and the electric quantity was 50 $C/dm^2$ as the sum total of electric quantity at the time of anodization of the aluminum plate. Thereafter, washing with water by spraying was performed.

(h) Alkali etching treatment

The aluminum plate was subjected to an etching treatment by spraying an aqueous solution in which the concentration of caustic soda was 26 mass% and the concentration of aluminum ions was 6.5 mass% at a temperature of 32°C so that 0.1 $g/m^2$ of the aluminum plate was dissolved. Further, a smut component mainly containing aluminum hydroxide generated at the time of the electrochemical roughening treatment using the alternating current at the former step was removed, an edge portion of a generated pit was dissolved to smooth the edge portion. Thereafter, washing with water by spraying was performed.

(i) Desmutting treatment

A desmutting treatment was performed by spraying an aqueous solution (containing 0.5 mass% of aluminum ions) having a sulfuric acid concentration of 25 mass% at a temperature of 60°C. Thereafter, washing with water by spraying was performed.

(j) Anodizing treatment

An anodizing treatment was performed with an anodizing device having a structure illustrated in Fig. 1, thereby obtaining a support 13. As the electrolyte supplied to first and second electrolysis portions, sulfuric acid was used. The electrolyte had a sulfuric acid concentration of 170 g/L (containing 0.5 mass% of aluminum ions) and the temperature thereof was 38°C. Thereafter, washing with water by spraying was performed. The final amount of the oxide film was 2.7 $g/m^2$.

<Production of support 14>

In order to remove rolling oil from the surface of an aluminum plate (material JISA 1050) having a thickness of 0.3 mm, the surface was subjected to a degassing treatment at 50°C for 30 seconds using a 10 mass% of sodium aluminate aqueous solution, and the surface of the aluminum plate was grained using three bundle bristle brushes having a bristle diameter of 0.3 mm and a pumice-water suspension (specific gravity of 1.1 $g/cm^3$) having a median diameter of 25 μm and washed with water thoroughly. The aluminum plate was immersed in a 25 mass% of sodium hydroxide aqueous solution at 45°C for 9 seconds so as to be etched, washed with water, further immersed in a 20 mass% of nitric acid aqueous solution at 60°C for 20 seconds, and washed with water. The etching amount of the grained surface was approximately 3 $g/m^2$.

An electrochemical roughening treatment was continuously performed using an AC voltage of 60 Hz. A 1 mass% of nitric acid aqueous solution (containing 0.5 mass% of aluminum ions) was used as an electrolyte, and the solution temperature was 50°C. Using a trapezoidal rectangular waveform AC having a time TP, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. The current density was 30 $A/dm^2$ as the peak current value, and 5% of the current from the power source was separately flowed to the auxiliary anode. The electric quantity in nitric acid electrolysis was 175 $C/dm^2$ as the electric quantity at the time of anodization of the aluminum plate. Thereafter, washing with water by spraying was performed.

Next, an electrochemical roughening treatment was performed according to the same method as that for the nitric acid electrolysis using a 0.5 mass% of hydrochloric acid aqueous solution (containing 0.5 mass% of aluminum ions) and an electrolyte having a solution temperature of 50°C under a condition of an electric quantity of 50 $C/dm^2$ at the time of anodization of the aluminum plate, and washing with water was performed using a spray.

The aluminum plate was provided with a DC anodized film with a coating amount of 2.5 $g/m^2$ at a current density

of 15 A/$dm^2$ using a 15 mass% of sulfuric acid aqueous solution (containing 0.5 mass% of aluminum ions) as an electrolyte, washed with water, and dried.

Next, a sealing treatment was performed by spraying water vapor at 100°C to the anodized film at a pressure of $1.033 \times 10^5$ Pa for 8 seconds. Further, the aluminum support was immersed in a treatment liquid, obtained by dissolving 0.4 mass% of polyvinyl phosphonic acid (manufactured by PCAS) in pure water, at 53°C for 10 seconds, and the excess treatment liquid was completely removed using a nip roll, thereby producing a support 14.

<Production of support 15>

An aluminum plate (aluminum alloy plate) formed of the material 1S with a thickness of 0.3 mm was subjected to any of the following treatments, thereby producing a support 15. Moreover, during all treatment steps, a water washing treatment was performed, and liquid cutting was performed using a nip roller after the water washing treatment.

<Treatment J: production of support 15>

(J-a) Mechanical roughening treatment (brush grain method)

Using the device shown in Fig. 2, while supplying a suspension of pumice (specific gravity of 1.1 g/$cm^3$) to the surface of an aluminum plate as a polishing slurry liquid, a mechanical roughening treatment was performed using rotating bundle bristle brushes. In Fig. 2, the reference numeral 1 represents an aluminum plate, the reference numerals 2 and 4 represent roller-like brushes (in the present examples, bundle bristle brushes), the reference numeral 3 represents a polishing slurry liquid, and the reference numerals 5, 6, 7, and 8 represent a support roller.

The mechanical roughening treatment is performed under conditions in which the median diameter (μm) of a polishing material was 30 μm, the number of the brushes was four, and the rotation speed (rpm) of the brushes was set to 250 rpm. The material of the bundle bristle brushes was nylon 6 10, the diameter of the brush bristles was 0.3 mm, and the bristle length was 50 mm. The brushes were produced by implanting bristles densely into holes in a stainless steel cylinder having a diameter of φ300 mm. The distance between two support rollers (φ200 mm) of the lower portion of the bundle bristle brushes was 300 mm. The bundle bristle brushes were pressed until the load of a driving motor for rotating the brushes became 10 kW plus with respect to the load before the bundle bristle brushes were pressed against the aluminum plate. The rotation direction of the brush was the same as the moving direction of the aluminum plate.

(J-b) Alkali etching treatment

The aluminum plate was subjected to an etching treatment by spraying a caustic soda aqueous solution in which the concentration of caustic soda was 26 mass% and the concentration of aluminum ions was 6.5 mass% using a spray at a temperature of 70°C. Thereafter, washing with water by spraying was performed. The dissolved aluminum amount of the surface to be subjected to an electrochemical roughening treatment was 10 g/$m^2$.

(J-c) Desmutting treatment using acidic aqueous solution

Next, a desmutting treatment was performed using an acidic aqueous solution. Specifically, the desmutting treatment was performed for 3 seconds by spraying the acidic aqueous solution to an aluminum plate using a spray. As the acidic aqueous solution used in the desmutting treatment, a waste liquid of nitric acid used in electrochemical roughening treatment of the subsequent step was used. The solution temperature was 35°C.

(J-d) Electrochemical roughening treatment using nitric acid aqueous solution

An electrochemical roughening treatment was continuously performed using an AC voltage of 60 Hz in nitric acid electrolysis. An electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. As an electrolytic cell, the electrolytic cell shown in Fig. 4 was used. The current density was 30 A/$dm^2$ as the peak current value, and 5% of the current from the power source was separately flowed to the auxiliary anode. The electric quantity (C/$dm^2$) was 185 C/$dm^2$ as the sum total of electric quantity at the time of anodization of the aluminum plate.

(J-e) Alkali etching treatment

The obtained aluminum plate was subjected to an etching treatment by spraying a caustic soda aqueous solution in which the concentration of caustic soda was 27 mass% and the concentration of aluminum ions was 2.5 mass% using a spray at a temperature of 50°C. Thereafter, washing with water by spraying was performed. Further, the amount of aluminum dissolved was 3.5 g/$m^2$.

(J-f) Desmutting treatment using acidic aqueous solution

Next, a desmutting treatment was performed using a sulfuric acid aqueous solution. Specifically, the desmutting treatment was performed for 3 seconds by spraying the sulfuric acid aqueous solution to an aluminum plate using a spray. As the sulfuric acid aqueous solution used in the desmutting treatment, a solution in which the concentration of sulfuric acid was 170 g/L and the concentration of aluminum ions was 5 g/L was used. The solution temperature was 30°C.

(J-g) Electrochemical roughening treatment using hydrochloric acid aqueous solution

An electrochemical roughening treatment was continuously performed using an AC voltage of 60 Hz in hydrochloric acid electrolysis. An electrolyte which had been adjusted to have a concentration of aluminum ions of 4.5 g/L by adding aluminum chloride to a hydrochloric acid aqueous solution having a concentration of 6.2 g/L, and of which the solution temperature was 35°C was used. Using a trapezoidal rectangular waveform AC having a time tp, until the current value reached a peak from zero, of 0.8 msec and the duty ratio of 1:1 as an AC power source waveform which is a waveform shown in Fig. 3, the electrochemical roughening treatment was performed using a carbon electrode as a counter electrode. As an auxiliary anode, ferrite was used. As an electrolytic cell, the electrolytic cell shown in Fig. 4 was used. The current density was 25 A/$dm^2$ as the peak current value, and the electric quantity (C/$dm^2$) in the hydrochloric acid electrolysis was 63 C/$dm^2$ as the sum total of electric quantity at the time of anodization of the aluminum plate. Thereafter, washing with water by spraying was performed.

(J-h) Alkali etching treatment

The obtained aluminum plate was subjected to an etching treatment by spraying a caustic soda aqueous solution in which the concentration of caustic soda was 5 mass% and the concentration of aluminum ions was 0.5 mass% using a spray at a temperature of 60°C. Thereafter, washing with water by spraying was performed. The amount of aluminum dissolved was 0.2 g/$m^2$.

(J-i) Desmutting treatment using acidic aqueous solution

Next, a desmutting treatment was performed using a sulfuric acid aqueous solution. Specifically, the desmutting treatment was performed for 4 seconds by spraying the sulfuric acid aqueous solution to an aluminum plate using a spray. As the sulfuric acid aqueous solution used for the desmutting treatment, a waste liquid generated in the anodizing treatment step (an aqueous solution having a sulfuric acid concentration of 170 g/L and an aluminum ion concentration of 5 g/L) was used. The solution temperature was 35°C.

(J-j) First step of anodizing treatment

A first step of an anodizing treatment was performed with an anodizing device using DC electrolysis having the structure shown in Fig. 1. An anodized film having a predetermined coating amount was formed by performing an anodizing treatment under conditions in the columns of "first anodizing treatment" listed in Table V

[Table 27]

| Table V | | | | | |
|---|---|---|---|---|---|
| Support | First anodizing treatment | | | | |
| | Sulfuric acid concentration of electrolyte (g/l) | Phosphoric acid concentration of electrolyte (g/l) | Temperature (°C) | Current density (A/$dm^2$) | Coating amount (g/$m^2$) |
| Support 15 | 170 | - | 50 | 30 | 0.3 |

(J-k) Pore widening treatment

The aluminum plate after having been subjected to the anodizing treatment was subjected to a pore widening treatment by being immersed in a caustic soda aqueous solution in which the concentration of caustic soda was 5 mass% and the concentration of aluminum ions was 0.5 mass% at a temperature of 40°C for the time listed in Table W. Thereafter, washing with water by spraying was performed.

[Table 28]

| Table W | | |
|---|---|---|
| Support | Pore widening treatment | |
| | Temperature (°C) | Time (second) |
| Support 15 | 40 | 3 |

(J-1) Second step of anodizing treatment

A second step of an anodizing treatment was performed with an anodizing device using DC electrolysis having the structure shown in Fig. 1. An anodized film having a predetermined coating amount was formed by performing an anodizing treatment under conditions in the columns of the "second anodizing treatment" listed in Table X.

[Table 29]

| Table X | | | | | |
|---|---|---|---|---|---|
| Support | Second anodizing treatment | | | | |
| | Sulfuric acid concentration of electrolyte (g/l) | Phosphoric acid concentration of electrolyte (g/l) | Temperature (°C) | Current density ($A/dm^2$) | Coating amount ($g/m^2$) |
| Support 15 | 170 | - | 50 | 13 | 2.1 |

(J-m) Hydrophilization treatment

In order to ensure hydrophilicity of a non-image area, the obtained aluminum plate was subjected to a silicate treatment by being dipped in 2.5 mass% of a No. 3 sodium silicate aqueous solution at 50°C for 7 seconds. The adhesion amount of Si was 8.5 $mg/m^2$. Thereafter, washing with water by spraying was performed.

In each of the supports 4-15, the average diameter of micropores in the surface of the obtained anodized film on a side opposite to an aluminum plate side is collectively listed in Table Y

The average diameter of micropores is calculated by observing 4 sheets (N = 4) of the surfaces of the anodized film using FE-SEM at a magnification of 150000, measuring the diameters of micropores present 400 nm $\times$ 600 $nm^2$ in the obtained four sheets of images, and averaging the values.

Further, in a case where the shape of the micropores is not circular, an equivalent circle diameter is used. The "equivalent circle diameter" is a diameter of a circle obtained by assuming the shape of an opening portion of a micropore as a circle having the same projected area as the projected area of the opening portion.

[Table 30]

| Table Y | |
|---|---|
| Support | Average diameter of micropores |
| | (nm) |
| Support 4 | 13 |
| Support 5 | 30 |
| Support 6 | 100 |
| Support 7 | 30 |

(continued)

| Table Y | |
|---|---|
| Support | Average diameter of micropores |
| | (nm) |
| Support 8 | 30 |
| Support 9 | 40 |
| Support 10 | 100 |
| Support 11 | 40 |
| Support 12 | 148 |
| Support 13 | 7 |
| Support 14 | 7 |
| Support 15 | 30 |

[Example 49]

<Formation of back coat layer>

(Preparation of back coat layer coating solution (49))

· BR-605 (acrylic resin), manufactured by Mitsubishi Chemical Corporation: 11.072 g
· SUMECTON-SEN (tabular particles), manufactured by Kunimine Industries Co., Ltd.: 0.500 g
· Acrylic particles ART PEARL J-6PF, manufactured by Negami Chemical Industrial Co., Ltd.: 0.975 g
· RHEODOL TW-S106V (polyoxyethylene (6) sorbitan monostearate), manufactured by Kao Corporation: 0.250 g
· 2-butanone 74.123 g
· 1-methoxy-2-propanol 8.720 g
· Methanol 4.360 g

The components were mixed and stirred, thereby a back coat layer coating solution (49) was prepared.

The surface of the support 1 on the back coat layer side (non-printing surface side) was bar-coated with the back coat layer coating solution (49) with the above-described composition and dried at 100°C for 120 seconds, thereby forming a back coat layer having a thickness of 1.2 $\mu$m.

<Formation of undercoat layer>

The other surface (printing surface side) of the support 1 was coated with the undercoat layer coating solution (1) with the above-described composition such that the drying coating amount thereof reached 20 mg/m$^2$, thereby forming an undercoat layer.

<Formation of image recording layer>

The undercoat layer of the support including a back coat layer and an undercoat layer was bar-coated with the image recording layer coating solution (2) with the following composition and dried in an oven at 70°C for 60 seconds to form an image recording layer (polymer-containing layer 1) having a drying coating amount of 0.6 g/m$^2$, thereby producing a planographic printing plate precursor.

[Examples 50-58]

Back coat layers, undercoat layers, and image recording layers were formed in the same manner as in Example 49 except that the support of Example 49 was changed as listed in Table 2, thereby producing planographic printing plate precursors.

[Example 59]

<Formation of back coat layer>

The surface of the support 2 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of image recording layer>

An image recording layer aqueous coating solution containing thermoplastic polymer particles, an infrared absorbent, and polyacrylic acid described below was prepared, the pH thereof was adjusted to 3.6, and the surface of the support 2 on the printing surface side was coated with the coating solution and dried at 50°C for 1 minute to form and produce an image recording layer. The coating amount after the drying of each component is shown below.

Thermoplastic polymer particles: 0.7 g/$m^2$
Infrared absorbent IR-01: 1.20 $\times$ $10^{-4}$ g/$m^2$
Polyacrylic acid: 0.09 g/$m^2$

The thermoplastic polymer particles, the infrared absorbent IR-01, the polyacrylic acid used for the image recording layer coating solution are as follows.

[Example 60]

<Formation of back coat layer>

The surface of the support 3 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 3 on the printing surface side was coated with the undercoat layer coating solution (1) such that the drying coating amount thereof reached 20 mg/$m^2$, thereby forming an undercoat layer.
The undercoat layer was bar-coated with an image recording layer coating solution (3) with the above composition and dried in an oven at 100° for 60 seconds, thereby forming an image recording layer having a drying coating amount of 1.0 g/$m^2$.

<Formation of protective layer>

The image recording layer was bar-coated with a protective layer coating solution (1) with the above composition and dried in an oven at 120° for 60 seconds to form a protective layer having a drying coating amount of 0.15 g/$m^2$, thereby producing a planographic printing plate precursor.

[Example 61]

<Formation of back coat layer>

The surface of the support 3 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 3 having the back coat layer used for production of Example 61 on the printing surface side was coated with the undercoat layer coating solution (2) with the above-described composition using a wire bar and dried at 90°C for 30 seconds. The coating amount thereof was 10 mg/$m^2$.

<Formation of image recording layer>

The undercoat layer was coated with the image recording layer coating solution (4) with the above composition using a wire bar and dried at 115°C for 34 seconds using a hot air dryer. The coating amount after the drying was 1.4 g/$m^2$.

<Formation of protective layer>

The image recording layer was coated with the protective layer coating solution (2) with the above composition using a wire bar and dried at 125°C for 75 seconds using a hot air dryer, thereby forming a protective layer. The coating amount after the drying was 1.6 g/$m^2$. In this manner, a planographic printing plate precursor of Example 61 was produced.

[Example 62]

<Formation of back coat layer>

The surface of the support 3 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 3 having the back coat layer used for production of Example 62 on the printing surface side was coated with the undercoat layer coating solution (3) with the above-described composition using a bar coater and dried at 80°C for 15 seconds, thereby forming an undercoat layer having a coating amount of 18 mg/$m^2$ after the drying of the solution.

<Formation of image recording layer>

The undercoat layer was coated with an underlayer coating solution with the following composition using a bar coater such that the coating amount after the drying was set to 0.85 g/$m^2$, dried at 160°C for 44 seconds, and immediately cooled with cold air in a temperature range of 17-20°C until the temperature of the support was set to 35°C, thereby forming an underlayer. Thereafter, the underlayer was coated with an upper layer coating solution with the following composition using a bar coater such that the coating amount after the drying was set to 0.22 g/$m^2$, dried at 148°C for 25 seconds, and gradually cooled with air in a temperature range of 20-26°C, thereby forming an upper layer. In this manner, a planographic printing plate precursor of Example 62 was produced.

(Underlayer coating solution)

· N-(4-aminosulfonylphenyl)methacrylamide/acrylonitrile/methyl methacrylate 2.1 g (36/34/30 mass%: mass average molecular weight of 50000, acid value of 2.65)
· m,p-cresol novolac 0.1 g (m/p ratio = 6/4, mass average molecular weight of 4500, containing 0.8 mass% of unreacted cresol, Tg: 75°C)
· Cyanine dye A (the following structure) 0.13 g
· 4,4'-bishydroxyphenylsulfone 0.13 g
· Tetrahydrophthalic anhydride 0.19 g
· p-toluenesulfonic acid 0.008 g
· 3-methoxy-4-diazodiphenylamine hexafluorophosphate 0.032 g
Dye obtained by changing counter ion of ethyl violet into 6-hydroxy-2-naphthalenesulfonic acid 0.078 g
· Fluorine-based surfactant B (the following structure) 0.007 g
· Methyl ethyl ketone 25.0 g
· 1-methoxy-2-propanol 13.0g
· γ-butyrolactone 13.0 g

cyanine dye A

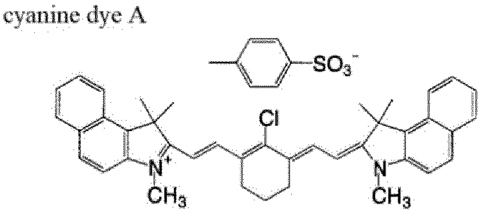

fluorine-based surfactant B

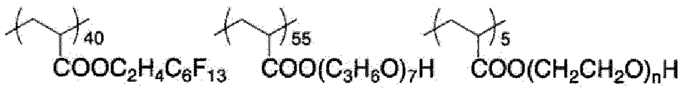

Mw:35, 000

(Upper layer coating solution)

- · Phenol/m-cresol/p-cresol novolac 0.35 g
(molar ratio = 5/3/2, mass average molecular weight: 5000, content of unreacted cresol: 1.2 mass%, Tg: 70°C)
- · Acrylic resin C (the following structure) 0.042 g
- · Cyanine dye A (the above structure) 0.019 g
- · Ammonium compound D (the following structure) 0.004 g
- · Sulfonium compound G (the following structure) 0.032 g
- · Fluorine-based surfactant B (the above structure) 0.0045 g
- · Fluorine-based surfactant E (the following structure) 0.0033 g
- · Fluorine-based polymer F (the following structure) 0.018 g
- · Methyl ethyl ketone 10.0 g
- · 1-methoxy-2-propanol 20.0 g

acrylic resin C

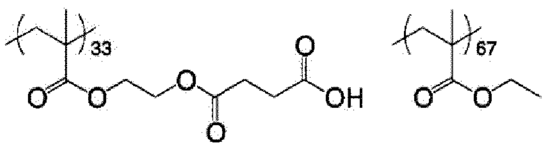

Mw:100, 000

ammonium compound D

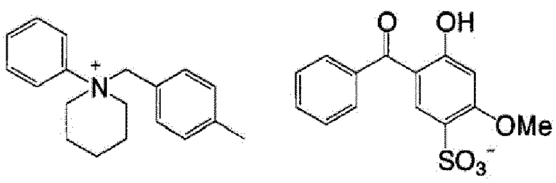

fluorine-based surfactant E

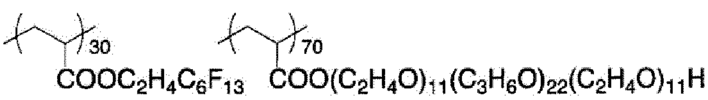

Mw:35, 000

fluorine-based polymer F (X:Y:Z=36:34:30)

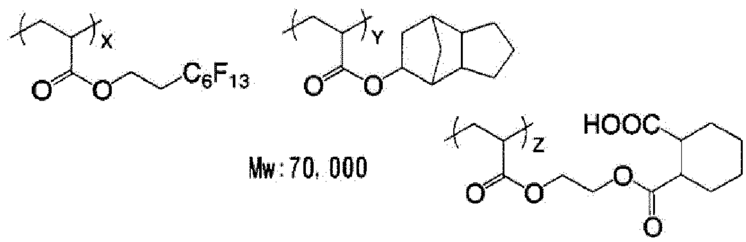

Mw:70, 000

sulfonium compound G

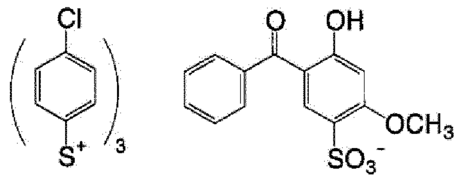

[Example 63]

<Formation of back coat layer>

The surface of the support 3 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 3 having the back coat layer used for production of Example 63 on the printing surface side was coated with the undercoat layer coating solution (4) with the above-described composition using a bar coater and dried at 80°C for 15 seconds, thereby forming an undercoat layer having a coating amount of 18 $mg/m^2$ after the drying of the solution.

<Formation of non-photosensitive layer>

The undercoat layer was bar-coated with a non-photosensitive layer coating solution (1) with the above composition and dried at 100°C for 60 seconds, thereby forming a non-photosensitive layer. The coating amount after the drying was 1.0 $mg/m^2$.

<Formation of hydrophilic layer>

The non-photosensitive layer was bar-coated with a hydrophilic layer coating solution (1) having the above composition and dried at 125°C for 75 seconds, thereby forming a non-photosensitive layer. The coating amount after the drying was 1.6 $mg/m^2$. In this manner, a printing key plate precursor of Example 63 was produced.

[Example 64]

A printing key plate precursor of Example 64 was produced in the same manner as in the production of Example 60 except that the infrared absorbent (1) and the polymerization initiator (1) were removed from the image recording layer coating solution (3).

[Example 65]

<Formation of back coat layer>

The surface of the support 13 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 13 having the back coat layer used for production of Example 65 on the printing surface side was coated with an undercoat layer coating solution (65) with the following composition such that the drying coating amount thereof reached 20 mg/$m^2$, thereby forming an undercoat layer.

(Undercoat layer coating solution (65))

- · Compound for undercoat layer (2) (the following structure): 0.18 parts
- · Tetrasodium ethylenediaminetetraacetate: 0.10 parts
- · Polyoxyethylene lauryl ether: 0.03 parts
- · Water: 61.39 parts

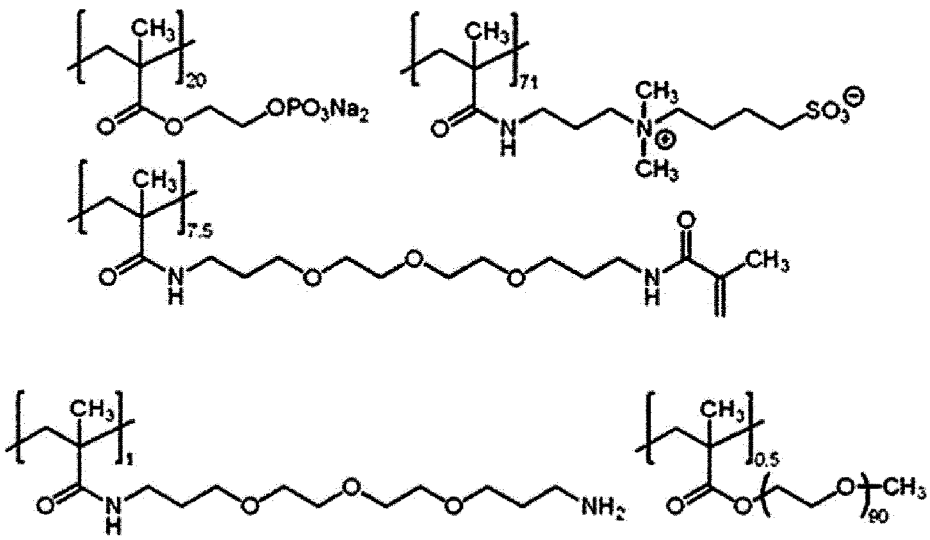

compound for undercoat layer (2) Mw 100,000

The numerical values on the lower right side of the parentheses of each constitutional unit in the above-described compound (2) for an undercoat layer indicate the mass ratios, and the numerical values on the lower right side of the parentheses of each ethyleneoxy unit indicate the repetition numbers.

<Formation of image recording layer>

The undercoat layer was bar-coated with an image recording layer coating solution (65) with the following composition and dried in an oven at 100° for 60 seconds, thereby forming an image recording layer 3 having a thickness of 1 μm.

The image recording layer coating solution (65) was obtained by mixing a photosensitive solution (2) and a microgel solution (2) described below immediately before the coating and then stirring the solution.

<Photosensitive solution (2)>

· Binder polymer (2) (the following structure, Mw: 50000 and n (number of ethylene oxide (EO) repeating units: 4)): 0.480 parts
· Infrared absorbent (1) (described above): 0.030 parts
· Borate compound (Sodium tetraphenylborate): 0.014 parts
· Polymerization initiator (1) (described above): 0.234 parts
· Polymerizable compound (tris(acryloyloxyethyl) isocyanurate, NK ESTER A-9300, manufactured by Shin-Nakamura Chemical Co., Ltd.): 0.192 parts
· Low-molecular weight hydrophilic compound (1) (tris(2-hydroxyethyl) isocyanurate): 0.052 parts
· Anionic surfactant 1 (described above): 0.099 parts
· Oil sensitizing agent phosphonium compound (1) (the following structure): 0.12 parts
· Oil sensitizing agent ammonium group-containing polymer (the following structure, reduced specific viscosity of 44 ml/g): 0.035 parts
· Oil sensitizing agent benzyldimethyloctyl ammonium·$PF_6$ salt: 0.032 parts
· Colorant ethyl violet (the following structure): 0.030 parts
· Fluorine-based surfactant (1) (described above): 0.02 parts
· 2-butanone: 1.091 parts
· 1-methoxy-2-propanol: 8.609 parts

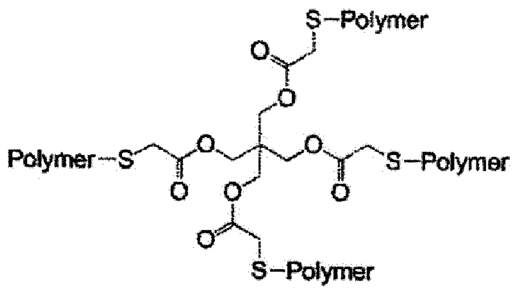

polymer moiety illustrated above

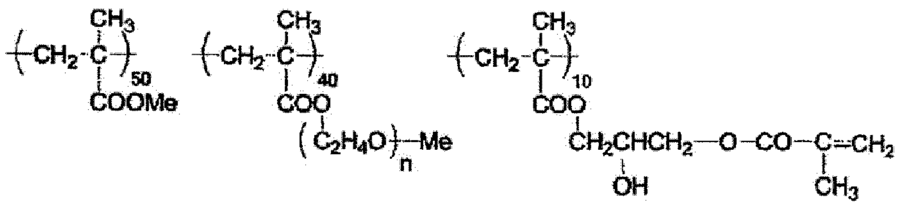

binder polymer (2)

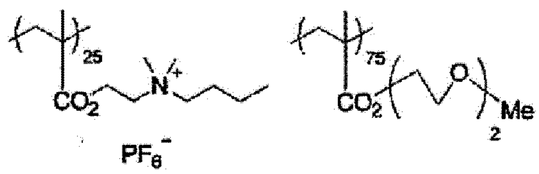

ammonium group-containing polymer

The numerical values on the lower right side of the parentheses of each constitutional unit of the binder polymer (2) and the ammonium group-containing polymer indicate the molar ratios. Me represents a methyl group.

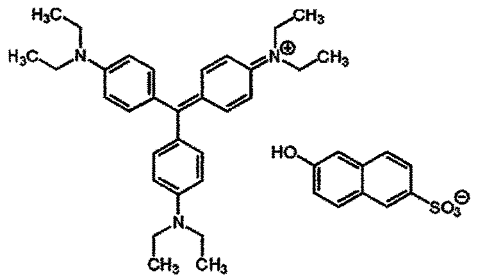

ethyl violet

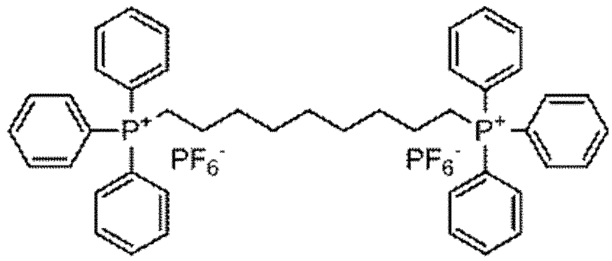

phosphonum compound (1)

<Microgel solution (2)>

· Microgel (2): 1.580 parts
· Distilled water: 1.455 parts

(Preparation of microgel (2))

A method of preparing a microgel (2) used for the microgel solution (2) will be described below.

10 parts of an adduct (TAKENATE D-110N, manufactured by Mitsui Chemicals Polyurethanes, Inc.) of trimethylolpropane and xylene diisocyanate, 5.54 parts of dipentaerythritol pentaacrylate (SR-399, manufactured by Sartomer Japan Inc.), and 0.1 parts of PIONINE A-41C (manufactured by TAKEMOTO OIL & FAT Co., Ltd.), as oil phase components, were dissolved in 17 parts of ethyl acetate. As a water phase component, 40 parts of a 4 mass% of aqueous solution of PVA-205 was prepared. The oil phase components and the water phase components were mixed with each other and emulsified at 12,000 rpm for 10 minutes using a homogenizer. 25 parts of distilled water were added to the obtained emulsion, and the solution was stirred at room temperature (25°C, the same applies hereinafter) for 30 minutes and further stirred at 50°C for 3 hours. The microgel solution obtained in this manner was diluted with distilled water such that the concentration of solid contents was set to 15 mass%, thereby preparing a microgel (2). The average particle diameter of the microgel measured by a light scattering method was 0.2 μm.

<Formation of protective layer>

The image recording layer was further bar-coated with a protective layer coating solution (65) with the following composition and dried in an oven at 120° for 60 seconds to form a protective layer having a drying coating amount of 0.15 g/$m^2$, thereby obtaining a planographic printing plate precursor.

<Protective layer coating solution (65)>

· Inorganic layered compound dispersion liquid (1) (obtained in the above-described manner): 1.5 parts
· Hydrophilic polymer (1) (solid content) [the following structure, Mw: 30000]: 0.55 parts
· Polyvinyl alcohol (CKS50, manufactured by Nippon Synthetic Chemical Industry Co., Ltd., sulfonic acid-modified,

saponification degree: 99% by mole or greater, degree of polymerization: 300) 6 mass% of aqueous solution: 0.10 parts

· Polyvinyl alcohol (PVA-405, manufactured by KURARAY CO., LTD., saponification degree: 81.5% by mole, degree of polymerization: 500) 6 mass% of aqueous solution: 0.03 parts

· Surfactant (RAPISOL A-80 (trade name), manufactured by NOF Corporation) 80 mass% of aqueous solution: 0.011 parts

· Ion exchange water: 6.0 parts

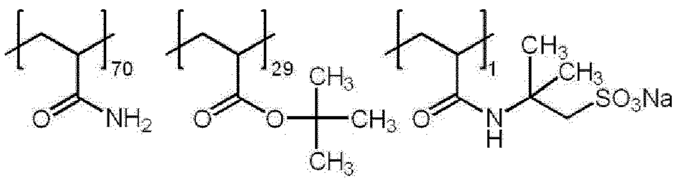

hydrophilic polymer (1)

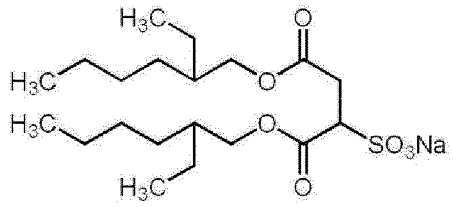

RAPISOL A-80

Further, the numerical values on the lower right side of the parentheses of each constitutional unit in the hydrophilic polymer (1) indicate the molar ratios.

[Example 66]

<Formation of back coat layer>

The surface of the support 14 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of image recording layer>

The surface of the support 14 having the back coat layer used for production of Example 66 on the printing surface side was bar-coated with an image recording layer coating solution (66) with the following composition and dried in an oven at 120°C for 40 seconds, thereby forming an image recording layer having a coating amount of 1.0 $g/m^2$ after the drying of the solution.

<Image recording layer coating solution (66)>

· Binder polymer (4) (the following structure): 4.09 pbm

· SR399: 2.66 pbm

· NK-Ester A-DPH: 2.66 pbm

· CD9053: 0.53 pbm

· Bis-t-butylphenylionoium tetraphenyl borate: 0.96 pbm

· Fluor N2900: 0.11 pbm

· Pigment 1 (the following structure): 0.73 pbm

· Infrared absorbent (4) (the following structure): 0.27 pbm

· Phosmer PE (manufactured by Uni-Chemical Co., Ltd.): 0.55 pbm

· Ion exchange water: 13.77 pbm

· 1-methoxy-2-propanol: 48.18 pbm
· 2-butyrolactone: 13.77 pbm
· 2-butanone: 61.94 pbm

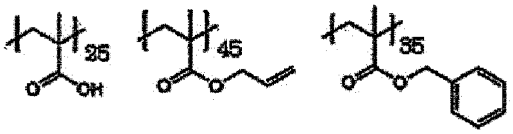

binder polymer (4)

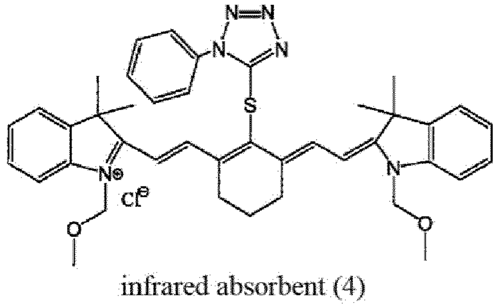

infrared absorbent (4)

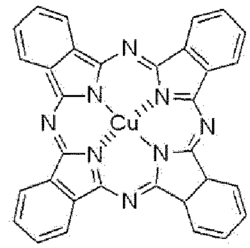

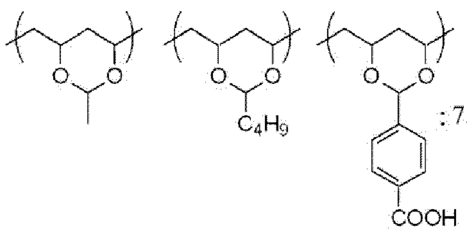

: 7.7% by mass

Irgalith Blue GLVO
(C.I. Pigment Blue 15:4) : 76.9% by mass

Disperbyk 167 : 15.4% by mass

Pigment 1

Pigment 1 is a mixture formed of the above-described components (the pigment, the polymer, and the dispersant). Disperbyk 167 is a dispersant which is available from BYK Chemie GmbH).

SR-399: dipentaerythritol pentaacrylate (manufactured by Sartomer Japan Inc.)
NK-Ester A-DPH: dipentaerythritol hexaacrylate (manufactured by Shin-Nakamura Chemical Co., Ltd.)
CD9053: acid-modified acrylate (trifunctional) (manufactured by Sartomer Japan Inc.)
FluorN 2900: surfactant (available from Cytnoix LLC)
Phosmer PE (manufactured by Uni-Chemical Co., Ltd.): the following structure

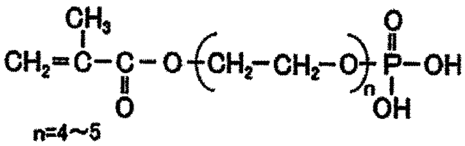

n=4~5

<Formation of protective layer>

The image recording layer was bar-coated with a protective layer coating solution (66) with the following composition and dried in an oven at 120° for 60 seconds to form a protective layer having a drying coating amount of 0.5 g/m$^2$, thereby obtaining a planographic printing plate precursor.

(Protective layer coating solution (66))

- · Polyvinyl alcohol (PVA-405, manufactured by KURARAY CO., LTD., saponification degree: 81.5 mol%, degree of polymerization: 500) 6 mass% of aqueous solution: 66.33 pbm
- · Surfactant (Masurf 1520, manufactured by Pilot Chemical Corp.): 0.02 pbm
- · Ion exchange water: 8.65 pbm

[Example 67]

<Formation of back coat layer>

The surface of the support 2 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of image recording layer>

The surface of the support 2 having the back coat layer used for production of Example 67 on the printing surface side was bar-coated with an image recording layer coating solution (67) with the following composition and dried in an oven at 90°C for 60 seconds, thereby forming an image recording layer having a coating amount of 1.3 g/$m^2$ after the drying of the solution.

<Image recording layer coating solution (67)>

- · Binder polymer (4) (described above): 0.23 pbm
- · Urethane methacrylate oligomer (formed from reaction of glycerol dimethyl acrylate, glycerol monomethyl acrylate, propylene glycol methacrylate, and hexamethylene diisocyanate): 0.38 pbm
- · Ethoxylated bisphenol A diacrylate (NK ESTER BPE 500, manufactured by Shin-Nakamura Chemical Co., Ltd.): 0.06 pbm
- · Polymerization initiator (5) (the following structure): 0.07 pbm
- · Sensitizing dye (5) (the following structure): 0.04 pbm
- · Chain transfer agent (mercaptobenzothiazole): 0.005 pbm
- · Pigment (polymer dispersion of Heliogen Blue 7565): 0.038 pbm
- · Surfactant (BYK307, manufactured by BYK Chemie GmbH): 0.002 pbm
- · Phenoxyethanol: 10.35 pbm
- · Acetone: 1.15 pbm

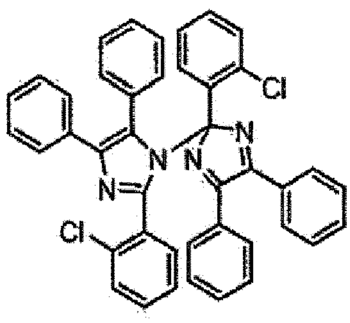

polymerization initiator (5)

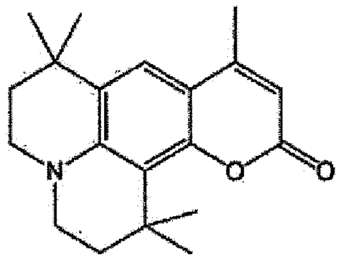

sensitizing dye (5)

<Formation of protective layer>

The image recording layer was bar-coated with a protective layer coating solution (67) with the following composition and dried in an oven at 125°C for 70 seconds to form a protective layer having a drying coating amount of 1.8 g/$m^2$.

(Protective layer coating solution (67))

· PVA-1 (Gohseran L-3266, manufactured by The Nippon Synthetic Chemical Industry Co., Ltd.): 0.61 pbm
· PVA-2 (Nichigo G-Polymer AZF8035, manufactured by The Nippon Synthetic Chemical Industry Co., Ltd.): 0.32 pbm
· Surfactant (EMALEX 710, manufactured by Nihon Emulsion Co., Ltd.): 0.002 pbm
· Water: 13 pbm

[Example 68]

<Formation of back coat layer>

The surface of the support 15 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 15 having the back coat layer used for production of Example 68 on the printing surface side was coated with an undercoat layer coating solution (68) with the following composition such that the drying coating amount thereof reached 26 mg/$m^2$, thereby forming an undercoat layer.

(Undercoat layer coating solution (68))

· Compound for undercoat layer (2) (the following structure): 0.13 pbm
· Hydroxyethyl imino diacetic acid: 0.05 pbm
· Tetrasodium ethylenediaminetetraacetate: 0.05 pbm
· Polyoxyethylene lauryl ether: 0.03 pbm
· Water: 61.39 pbm

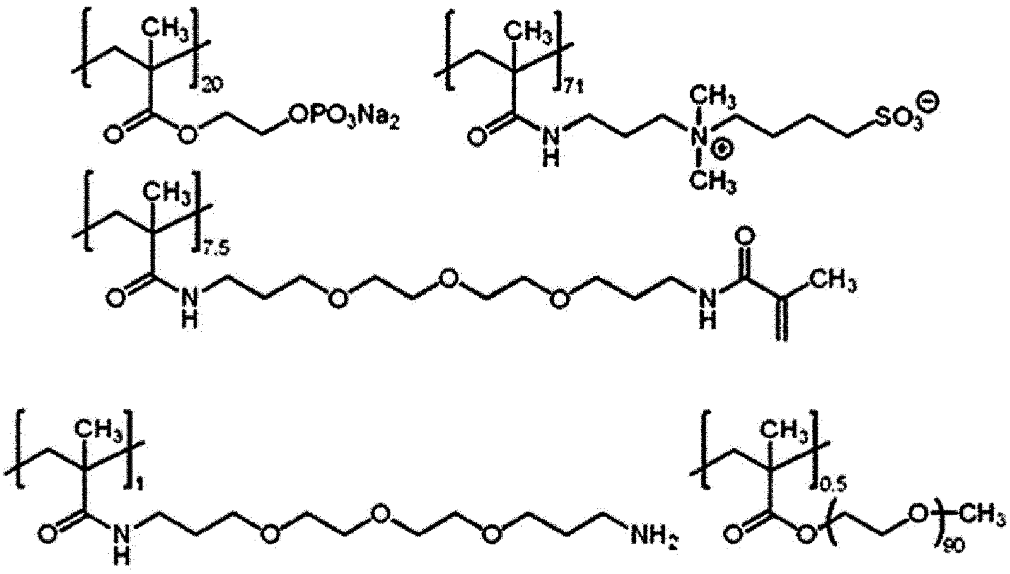

compound for undercoat layer (2) Mw 100,000

The numerical values on the lower right side of the parentheses of each constitutional unit in the above-described compound (2) for an undercoat layer indicate the mass ratios, and the numerical values on the lower right side of the parentheses of each ethyleneoxy unit indicate the repetition numbers.

<Formation of image recording layer>

The undercoat layer was bar-coated with an image recording layer coating solution (68) with the following composition and dried in an oven at 100° for 60 seconds, thereby forming an image recording layer having a drying coating amount of 1.2 g/$m^2$.

The image recording layer coating solution (68) was obtained by mixing a photosensitive solution (3) and a microgel solution (4) described below immediately before the coating and then stirring the solution.

(Image recording layer coating solution (68))

(Photosensitive solution (3))

· Binder polymer (6) 23 mass% of 1-methoxy-2-propanol solution (the following structure, Mw: 35,000 and n (number of ethylene oxide (EO) repeating units)): 0.3755 parts
· Binder polymer (7) 23 mass% of 1-methoxy-2-propanol solution (the following structure, Mw: 35,000 and n (number of ethylene oxide (EO) repeating units)): 0.3755 parts
· Infrared absorbent (1) (the following structure): 0.0278 parts
· Borate compound (1) (Sodium tetraphenylborate): 0.015 parts
· Polymerization initiator (1) (the following structure): 0.2348 parts
· Polymerizable compound (1) (tris(acryloyloxyethyl) isocyanurate, NK ESTER A-9300 40 mass% of 2-butanone solution, manufactured by Shin-Nakamura Chemical Co., Ltd.): 0.2875 parts
Low-molecular weight hydrophilic compound (1) (tris(2-hydroxyethyl)isocyanurate): 0.0287 parts
· Low-molecular weight hydrophilic compound (2) (trimethylglycine): 0.0147 parts
· Anionic surfactant 1 30 mass% of aqueous solution (the following structure): 0.25 parts
· Ultraviolet absorbent (1) (TINUVIN 405, manufactured by BASF SE) (the following structure): 0.04 parts
· Fluorine-based surfactant (1) (the following structure): 0.004 parts
· Phosphonium compound (1) (the following structure): 0.020 parts
· 2-butanone: 5.346 parts
· 1-methoxy-2-propanol: 3.128 parts
· Methanol: 0.964 parts
· Pure water: 0.036 parts

(Microgel solution (4))

· Microgel (4) (concentration of solid contents 21.8 mass%): 2.243 parts
· 1-methoxy-2-propanol: 0.600 parts

(Production of microgel (4))

A method of preparing a microgel (1) used for the microgel solution will be described below.

<Preparation of polyvalent isocyanate compound (1)>

0.043 parts of bismuth tris(2-ethylhexanoate) (NEOSTANN U-600, manufactured by NITTO KASEI CO., LTD.) was added to an ethyl acetate (25.31 parts) suspension solution of 17.78 parts (80 molar equivalent) of isophorone diisocyanate and 7.35 parts (20 molar equivalent) of the following polyhydric phenol compound (1), and the solution was stirred. The reaction temperature was set to 50°C at the time of heat generation being subsided, and the solution was stirred for 3 hours, thereby obtaining an ethyl acetate solution (50 mass%) of a polyvalent isocyanate compound (1).

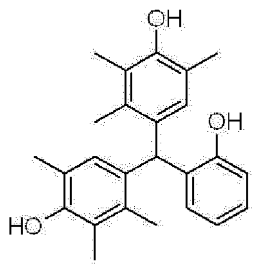

polyhydric phenol compound (1)

<Preparation of microgel (4)>

The following oil phase components and the water phase component were mixed with each other and emulsified at 12,000 rpm for 10 minutes using a homogenizer. The obtained emulsion was stirred at 45°C for 4 hours, 5.20 parts of a 10 mass% of aqueous solution of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. The concentration of solid contents was adjusted to 21.8 mass% using distilled water, thereby obtaining an aqueous dispersion liquid of the microgel (4). The volume average particle diameter was measured using a dynamic light scattering type particle size distribution measuring device LB-500 (manufactured by Horiba Ltd.) according to a light scattering method, and the value was 0.28 μm.

(Oil phase components)

(Component 1) ethyl acetate: 12.0 parts
(Component 2) adduct (50 mass% of ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto: 3.76 parts
(Component 3) polyvalent isocyanate compound (1) (as 50 mass% of ethyl acetate solution): 15.0 parts
(Component 4) 65 mass% of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts
(Water phase component)
Distilled water: 46.87 parts

<Synthesis of binder polymer (6)>

78.0 g of 1-methoxy-2-propanol was weighed in a three-neck flask and heated to 70°C in a nitrogen stream. A mixed solution formed of 52.1 g of BLEMMER PME-100 (methoxy diethylene glycol monomethacrylate, manufactured by NOF Corporation), 21.8 g of methyl methacrylate, 14.2 g of methacrylic acid, 2.15 g of hexakis(3-mercaptopropionic acid) dipentaerythritol, 0.38 g of V-601 (2,2'-azobis(isobutyric acid) dimethyl, manufactured by Wako Pure Chemical Industries, Ltd.), and 54 g of 1-methoxy-2-propanol was added dropwise to the reaction container for 2 hours and 30 minutes. After the dropwise addition, the solution was heated to 80°C to further continue the reaction for 2 hours. A mixed solution formed of 0.04 g of V-601 and 4 g of 1-methoxy-2-propanol was added thereto, the solution was heated to 90°C to further continue the reaction for 2.5 hours. After completion of the reaction, the reaction solution was cooled to room temperature.

137.2 g of 1-methoxy-2-propanol, 0.24 g of 4-hydroxytetramethylpiperidine-N-oxide, 26.0 g of glycidyl methacrylate, and 3.0 g of tetraethylammonium bromide were added to the reaction solution, and the resulting solution was stirred thoroughly and heated to 90°C.

After 18 hours, the reaction solution was cooled to room temperature (25°C) and diluted by adding 99.4 g of 1-methoxy-2-propanol thereto.

The concentration of solid contents in a binder polymer (6) obtained in the above-described manner was 23 mass%, and the weight-average molecular weight thereof in terms of polystyrene which was measured by GPC was 35000.

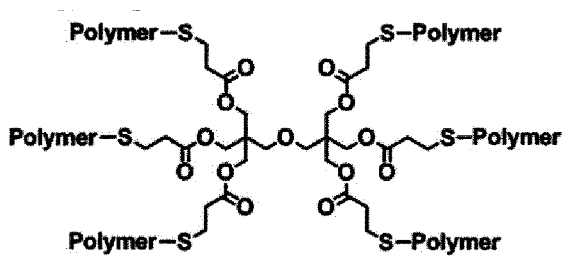

polymer moiety

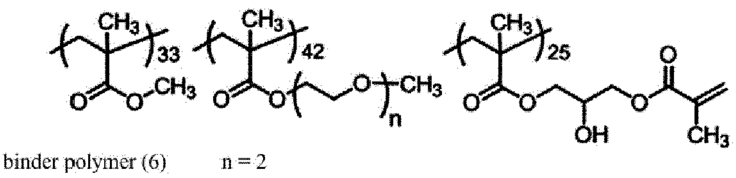

binder polymer (6) n = 2

<Synthesis of binder polymer (7)>

78.00 g of 1-methoxy-2-propanol was weighed in a three-neck flask and heated to 70°C in a nitrogen stream. A mixed solution formed of 52.8 g of BLEMMER PME-100 (methoxy diethylene glycol monomethacrylate, manufactured by NOF Corporation), 2.8 g of methyl methacrylate, 25.0 g of methacrylic acid, 6.4 g of hexakis(3-mercaptopropionic acid) dipentaerythritol, 1.1 g of V-601 (2,2'-azobis(isobutyric acid) dimethyl, manufactured by Wako Pure Chemical Industries, Ltd.), and 55 g of 1-methoxy-2-propanol was added dropwise to the reaction container for 2 hours and 30 minutes. After the dropwise addition, the solution was heated to 80°C to further continue the reaction for 2 hours. After 2 hours, a mixed solution formed of 0.11 g of V-601 and 1 g of 1-methoxy-2-propanol was added thereto, the solution was heated to 90°C to further continue the reaction for 2.5 hours. After completion of the reaction, the reaction solution was cooled to room temperature.

177.2 g of 1-methoxy-2-propanol, 0.28 g of 4-hydroxytetramethylpiperidine-N-oxide, 46.0 g of glycidyl methacrylate, and 3.4 g of tetrabutylammonium bromide were added to the reaction solution, and the resulting solution was stirred thoroughly and heated to 90°C.

After 18 hours, the reaction solution was cooled to room temperature (25°C) and diluted by adding 0.06 g of 4-methoxyphenol and 114.5 g of 1-methoxy-2-propanol thereto.

The concentration of solid contents in a binder polymer (7) obtained in the above-described manner was 23 mass%, and the weight-average molecular weight thereof in terms of polystyrene which was measured by GPC was

15000.

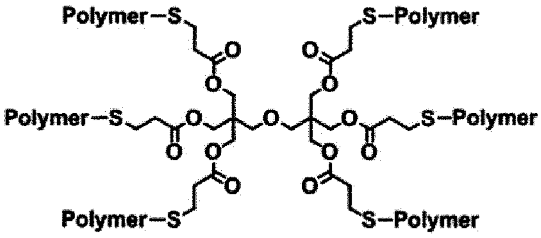

polymer moiety

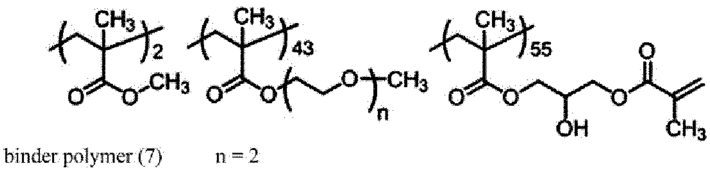

binder polymer (7) n = 2

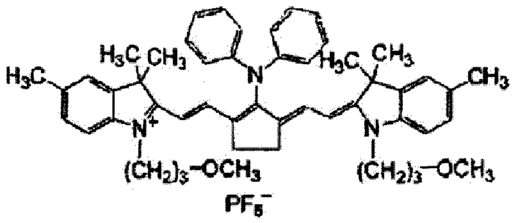

infrared absorbent (1)

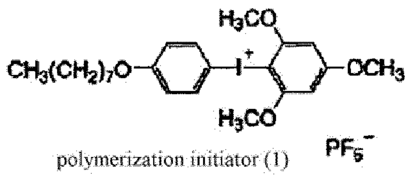

polymerization initiator (1)

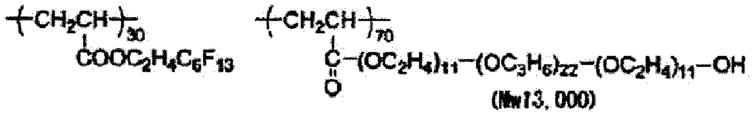

fluorine-based surfactant (1)

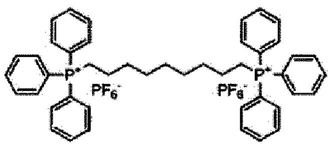

phosphonium compound (1)

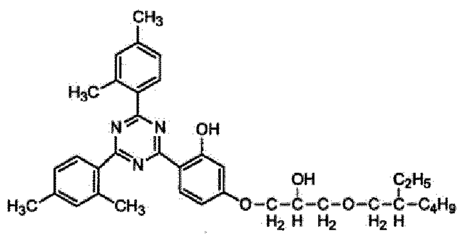

ultraviolet absorbent (1)

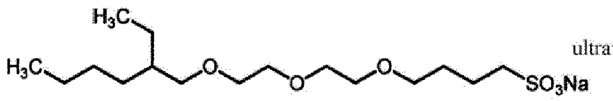

anionic surfactant 1

low-molecular weight hydrophilic compound (1)

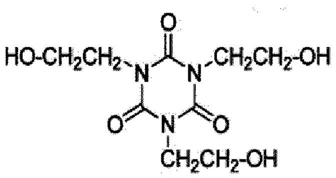

low-molecular weight hydrophilic compound (2)

$(CH_3)_3N^+CH_2COO^-$

borate compound (1)

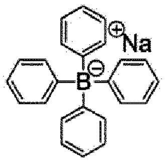

polymerizable compound (1)

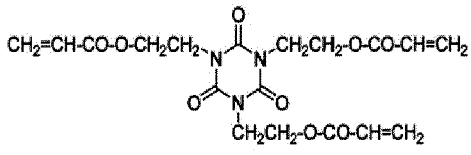

<Formation of protective layer>

The image recording layer was bar-coated with a protective layer coating solution (68) with the following composition and dried in an oven at 120° for 60 seconds to form a protective layer having a drying coating amount of 0.18 g/m$^2$, thereby producing a planographic printing plate precursor.

(Protective layer coating solution (68))

· Inorganic layered compound dispersion liquid (1) 2.290 g
· Polyvinyl alcohol (CKS50, manufactured by Nippon Synthetic Chemical Industry Co., Ltd., sulfonic acid-modified, saponification degree: 99 mol% or greater, degree of polymerization: 300) 6 mass% of aqueous solution 1.083 parts
· Surfactant (RAPISOL A-80 (the following structure), manufactured by NOF Corporation, 80 mass% of aqueous solution): 0.015 parts
· Phosphoric acid (85 mass% of aqueous solution) 0.032 parts
· Diammonium hydrogen phosphate: 0.044 parts
· Pure water 4.517 parts

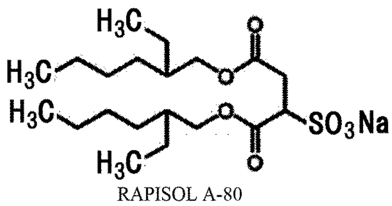

RAPISOL A-80

[Example 69]

<Formation of back coat layer>

The surface of the support 15 on the back coat layer side (non-printing surface side) was bar-coated with the back coat layer coating solution (49) of Example 49 and dried at 100°C for 120 seconds, thereby forming a back coat layer having a thickness of 1.2 μm.

<Formation of undercoat layer>

The surface of the support 15 having the back coat layer used for production of Example 69 on the printing surface side was coated with the undercoat layer coating solution (68) with the above-described composition such that the drying coating amount thereof reached 26 mg/m$^2$, thereby forming an undercoat layer.

<Formation of image recording layer>

An image recording layer was formed in the same manner as in Example 68 except that the amount of the binder polymer (6) and the amount of the binder polymer (7) in the image recording layer coating solution (68) of Example 68 were respectively changed to 0.2891 parts and 0.4574 parts.

<Formation of protective layer>

The image recording layer was bar-coated with a protective layer coating solution (69) with the following composition and dried in an oven at 120° for 60 seconds to form a protective layer having a drying coating amount of 0.18 g/m$^2$, thereby producing a planographic printing plate precursor.

(Protective layer coating solution (69))

- · Inorganic layered compound dispersion liquid (1) 2.212 parts
- · Polyvinyl alcohol (Gohseran L-3266, manufactured by The Nippon Synthetic Chemical Industry Co., Ltd., sulfonic acid-modified, saponification degree of 85% by mole) 6 mass% of aqueous solution: 1.440 parts
- · Surfactant (PIONINE A-32-B (the following structure), manufactured by TAKEMOTO OIL & FAT Co., Ltd., 40 mass% of aqueous solution): 0.014 parts
- · Surfactant (SURFYNOL 465 (the following structure), manufactured by Nissin Chemical Co., Ltd.): 0.006 parts
- · Phosphoric acid (85 mass% of aqueous solution) 0.023 parts
- · Diammonium hydrogen phosphate: 0.032 parts
- · Pure water 3.983 parts

$C_nH_{2n+1}-SO_3Na$
(n=10-16)

PIONINE A-32-B

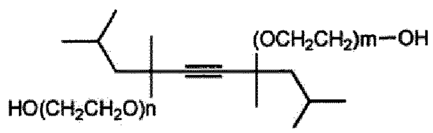

SURFYNOL 465

[Example 70]

<Formation of back coat layer>

A back coat layer was formed in the same manner as in Example 49 except that the amount of the tabular particles added to the back coat layer coating solution (49) was changed as listed in Table 2.

<Formation of undercoat layer>

The surface of the support 15 having the back coat layer used for production of Example 70 on the printing surface side was coated with the undercoat layer coating solution (68) with the above-described composition such that the drying coating amount thereof reached 26 mg/m$^2$, thereby forming an undercoat layer.

<Formation of image recording layer>

An image recording layer was formed in the same manner as in Example 68 except that the amount of the binder polymer (6) and the amount of the binder polymer (7) in the image recording layer coating solution (68) of Example 68 were respectively changed to 0.2891 parts and 0.4574 parts.

<Formation of protective layer>

The image recording layer was bar-coated with a protective layer coating solution (69) with the above composition and dried in an oven at 120° for 60 seconds to form a protective layer having a drying coating amount of 0.18 g/m$^2$, thereby producing a planographic printing plate precursor.

[Example 71]

<Formation of back coat layer>

A back coat layer was formed in the same manner as in Example 49 except that the amount of the tabular particles added to the back coat layer coating solution (49) was changed as listed in Table 2.

<Formation of undercoat layer>

The surface of the support 15 having the back coat layer used for production of Example 71 on the printing surface side was coated with the undercoat layer coating solution (68) with the above-described composition such that the drying coating amount thereof reached 26 $mg/m^2$, thereby forming an undercoat layer.

<Formation of image recording layer>

An image recording layer was formed in the same manner as in Example 68 except that the amount of the binder polymer (6) and the amount of the binder polymer (7) in the image recording layer coating solution (68) of Example 68 were respectively changed to 0.2891 parts and 0.4574 parts.

<Formation of protective layer>

The image recording layer was bar-coated with a protective layer coating solution (69) with the above composition and dried in an oven at 120° for 60 seconds to form a protective layer having a drying coating amount of 0.18 $g/m^2$, thereby producing a planographic printing plate precursor.

[Example 72]

<Formation of back coat layer>

A back coat layer was formed in the same manner as in Example 49 except that the amount of the tabular particles added to the back coat layer coating solution (49) was changed as listed in Table 2.

<Formation of undercoat layer>

The surface of the support 15 having the back coat layer used for production of Example 72 on the printing surface side was coated with the undercoat layer coating solution (68) with the above-described composition such that the drying coating amount thereof reached 26 $mg/m^2$, thereby forming an undercoat layer.

<Formation of image recording layer>

An image recording layer was formed in the same manner as in Example 68 except that the amount of the binder polymer (6) and the amount of the binder polymer (7) in the image recording layer coating solution (68) of Example 68 were respectively changed to 0.2891 parts and 0.4574 parts.

<Formation of protective layer>

The image recording layer was bar-coated with a protective layer coating solution (69) with the above composition and dried in an oven at 120° for 60 seconds to form a protective layer having a drying coating amount of 0.18 $g/m^2$, thereby producing a planographic printing plate precursor.

[Evaluation of printing plate precursor]

The scratch resistance, the abrasion resistance, and the measurement of the arithmetic average height Sa of the layer containing tabular particles of the printing plate precursors (the planographic printing plate precursors and the printing key plate precursors) obtained in each example and each comparative example were evaluated in the same manners as described above.

The evaluation results were listed in Table 2.

[Table 31]

| Table 2 | | | | | | | | | | | | | | | | | |
|---|---|---|---|---|---|---|---|---|---|---|---|---|---|---|---|---|---|
| | Support | Printing surface side | | Non-printing suriace side | | | | | | | | | | | | | |
| | | | | Layer component | | | Tabular particles | | | | | Particles otner than tabular particles | | | | | |
| | Type | Layer con-taining polymer | protective layer | Type | Detail | Thickness ($\mu$m) | Type | Detail | Thickness (nm) | Aspect ratio | Addition amount (mg/$m^2$) | Type | Detail | Thickness (nm) | Aspect ratio | Addition amount (mg/$m^2$) |
| Example 49 | 1 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |
| Example 50 | 4 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |
| Example 51 | 5 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |
| Example 52 | 6 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |
| Example 53 | 7 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |
| Example 54 | 8 | Layer 1 | None | BR-605 (RHEOD-OL 24 mg/$m^2$) | Acrylic resin | 1.2 | SUMECTON-SEN | Organic smectite | 1 | 50 | 50 | ART PEARL 6PF | Acrylic | 4 | 1 | 93 |

(continued)

| Table 2 | | | | | | | | | | | | | | | | | |
|---|---|---|---|---|---|---|---|---|---|---|---|---|---|---|---|---|---|
| | Support | Printing surface side | | Non-printing suriace side | | | | | | | | | | | | | |
| | | | | Layer component | | | Tabular particles | | | | | Particles otner than tabular particles | | | | | |
| | Type | Layer con-taining polymer | protective layer | Type | Detail | Thickness ($\mu$m) | Type | Detail | Thickness (nm) | Aspect ratio | Addition amount (mg/m$^2$) | Type | Detail | Thickness (nm) | Aspect ratio | Addition amount (mg/m$^2$) |
| Example 55 | 9 | Layer 1 | None | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |
| Example 56 | 10 | Layer 1 | None | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |
| Example 57 | 11 | Layer 1 | None | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |
| Example 58 | 12 | Layer 1 | None | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |
| Example 59 | 2 | Layer 2 | None | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |
| Example 60 | 3 | Layer 3 | Formed | BR-605 (RHEOD-OL 24 mg/m$^2$) | Acrylic resin | 1.2 | SUMECTON-SEN | Organic smectite | 1 | 50 | 50 | ART PEARL 6PF | Acrylic | 4 | 1 | 93 |

(continued)

Table 2

| | Support | Printing surface side | | Non-printing suriace side | | | | | | | | | | | | |
|---|---|---|---|---|---|---|---|---|---|---|---|---|---|---|---|---|
| | | | | Layer component | | | Tabular particles | | | | | Particles otner than tabular particles | | | | |
| | Type | Layer con-taining polymer | protective layer | Type | Detail | Thickness (μm) | Type | Detail | Thickness (nm) | Aspect ratio | Addition amount ($mg/m^2$) | Type | Detail | Thickness (nm) | Aspect ratio | Addition amount ($mg/m^2$) |
| Example 61 | 3 | Layer 4 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |
| Example 62 | 3 | Layer 5 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |
| Example 63 | 3 | Layer 6 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |
| Example 64 | 3 | Layer 7 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |
| Example 65 | 13 | Layer 8 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |
| Example 66 | 14 | Layer 9 | Formed | BR-605 (RHEOD-OL 24 $mg/m^2$) | Acrylic resin | 1.2 | SUMECTON-SEN | Organic smectite | 1 | 50 | 50 | ART PEARL 6PF | Acrylic | 4 | 1 | 93 |

(continued)

Table 2

| | Support | Printing surface side | | Non-printing suriace side | | | | | | | | | | | | |
|---|---|---|---|---|---|---|---|---|---|---|---|---|---|---|---|---|
| | | | | Layer component | | | Tabular particles | | | | | Particles other than tabular particles | | | | |
| | Type | Layer con-taining polymer | protective layer | Type | Detail | Thickness (μm) | Type | Detail | Thickness (nm) | Aspect ratio | Addition amount (mg/m²) | Type | Detail | Thickness (nm) | Aspect ratio | Addition amount (mg/m²) |
| Example 67 | 2 | Layer 10 | Formed | BR-605 (RHEODOL 24 mg/m²) | Acrylic resin | 1.2 | SUMECTON-SEN | Organic smectite | 1 | 50 | 50 | ART PEARL 6PF | Acrylic | 4 | 1 | 93 |
| Example 68 | 15 | Layer 11 | Formed | BR-605 (RHEODOL 24 mg/m²) | Acrylic resin | 1.2 | SUMECTON-SEN | Organic smectite | 1 | 50 | 50 | ART PEARL 6PF | Acrylic | 4 | 1 | 93 |
| Example 69 | 15 | Layer 12 | Formed | BR-605 (RHEODOL 24 mg/m²) | Acrylic resin | 1.2 | SUMECTON-SEN | Organic smectite | 1 | 50 | 50 | ART PEARL 6PF | Acrylic | 4 | 1 | 93 |
| Example 70 | 15 | Layer 12 | Formed | BR-605 (RHEODOL 24 mg/m²) | Acrylic resin | 1.2 | SUMECTON-SEN | Organic smectite | 1 | 50 | 40 | ART PEARL 6PF | Acrylic | 4 | 1 | 93 |
| Example 71 | 15 | Layer 12 | Formed | BR-605 (RHEODOL 24 mg/m²) | Acrylic resin | 1.2 | SUMECTON-SEN | Organic smectite | 1 | 50 | 30 | ART PEARL 6PF | Acrylic | 4 | 1 | 93 |
| Example 72 | 15 | Layer 12 | Formed | BR-605 (RHEODOL 24 mg/m²) | Acrylic resin | 1.2 | SUMECTON-SEN | Organic smectite | 1 | 50 | 20 | ART PEARL 6PF | Acrylic | 4 | 1 | 93 |

[Table 32]

| Table 2 (continued) | | | |
|---|---|---|---|
| | Evaluation result | | |
| | Sa | Scratch resistance | Abrasion resistance |
| Example 49 | 1.7 | 5 | 5 |
| Example 50 | 1.7 | 5 | 5 |
| Example 51 | 1.7 | 5 | 5 |
| Example 52 | 1.7 | 5 | 5 |
| Example 53 | 1.7 | 5 | 5 |
| Example 54 | 1.7 | 5 | 5 |
| Example 55 | 1.7 | 5 | 5 |
| Example 56 | 1.7 | 5 | 5 |
| Example 57 | 1.7 | 5 | 5 |
| Example 58 | 1.7 | 5 | 5 |
| Example 59 | 1.7 | 5 | 5 |
| Example 60 | 1.7 | 5 | 5 |
| Example 61 | 1.7 | 5 | 5 |
| Example 62 | 1.7 | 5 | 5 |
| Example 63 | 1.7 | 5 | 5 |
| Example 64 | 1.7 | 5 | 5 |
| Example 65 | 1.7 | 5 | 5 |
| Example 66 | 1.7 | 5 | 5 |
| Example 67 | 1.7 | 5 | 5 |
| Example 68 | 1.7 | 5 | 5 |
| Example 69 | 1.7 | 5 | 5 |
| Example 70 | 1.7 | 4 | 4 |
| Example 71 | 1.7 | 4 | 4 |
| Example 72 | 1.7 | 3 | 3 |

According to the present invention, it is possible to provide a printing plate precursor which is capable of preventing scratches on a rear surface layer and peeling of the rear surface layer even without interleaving paper in a case where printing plate precursors each including a planographic printing plate precursor and a key plate precursor are laminated. Further, it is also possible to provide a laminate of the printing plate precursors.

Explanation of References

1: Aluminum plate
2, 4: Roller-like brush
3: Polishing slurry liquid
5, 6, 7, 8: Support roller
50: Main electrolytic cell
51: AC power source

52: Radial drum roller
53a, 53b: Main pole
54: Electrolyte supply port
55: Electrolyte
56: Slit
57: Electrolyte passage
58: Auxiliary anode
60: Auxiliary anode cell
W: Aluminum plate
410: Anodizing device
412: Power supply tank
414: Electrolytic treatment tank
416: Aluminum plate
418, 426: Electrolyte
420: Power supply electrode
422, 428: Roller
424: Nip roller
430: Electrolytic electrode
432: Tank wall
434: DC power source

## Claims

**1.** A printing plate precursor comprising:

1) an aluminum support;
2) a layer containing a polymer on a printing surface side on the aluminum support; and
3) a layer containing

- tabular particles having an aspect ratio (Z) of ≥ 5 on a non-printing surface side opposite to the layer containing the polymer in a state of sandwiching the support therebetween;
the aspect ratio being defined as the ratio Z = L/a of the long diameter (L) to the thickness (a) of a particle, wherein L is the number average particle diameter determined with a LB-500 type dynamic light scattering (DLC) particle size distribution measuring device of Horiba, Ltd. while the particles are dispersed in a solvent, and the unit thickness a is a value calculated by measuring a diffraction peak of a particle using a SmartLab SE powder X-ray diffraction device of Rigaku Corporation; and
- particles other than the tabular particles, having an average particle diameter which is ≥ 0.1 um and is greater than the thickness of the layer containing the tabular particles.

**2.** The printing plate precursor of claim 1, wherein the thickness of each of the tabular particles is smaller than that of the layer containing the tabular particles.

**3.** The printing plate precursor of claim 1 or 2, wherein the tabular particles contain a silicon atom and an oxygen atom.

**4.** The printing plate precursor of claim 3, wherein the tabular particles containing a silicon atom and an oxygen atom are smectite, bentonite, or mica.

**5.** The printing plate precursor of any of claims 1-4, wherein the layer containing the tabular particles contains a polymer or a metal oxide obtained by hydrolyzing and polycondensing an organic metal compound or an inorganic metal compound.

**6.** The printing plate precursor of any of claims 1-5, wherein the particles other than the tabular particles are organic resin particles, inorganic particles, or organic-inorganic composite particles.

**7.** The printing plate precursor of any of claims 1-6, wherein the arithmetic average height Sa of the layer containing the tabular particles is 0.1-20 μm.

8. The printing plate precursor of any of claims 1-7, wherein the layer containing the polymer is an image recording layer including an infrared absorbent, a polymerization initiator, a polymerizable compound, and a polymer compound having a particle shape.

9. The printing plate precursor of claim 8, wherein the polymer compound having a particle shape contained in the image recording layer has a hydrophobic main chain and both of a constitutional unit (i) which contains a pendant-cyano group directly bonded to the hydrophobic main chain and a constitutional unit (ii) which contains a pendant group having a hydrophilic polyalkylene oxide segment.

10. The printing plate precursor of any of claims 1-7, wherein the layer containing the polymer includes an infrared absorbent and thermoplastic polymer particles.

11. A printing plate precursor laminate which is obtained by laminating a plurality of the printing plate precursors of any of claims 1-10, wherein the printing plate precursor laminate is formed such that an outermost layer on a surface where the layer containing the polymer is provided and an outermost layer on a surface where the layer containing the tabular particles is provided are laminated by being brought into direct contact with each other.

## Patentansprüche

1. Druckplattenvorläufer, umfassend:

    1) einen Aluminiumträger;
    2) eine Schicht, die ein Polymer enthält, auf einer Druckoberflächenseite auf dem Aluminiumträger; und
    3) eine Schicht, enthaltend

        - tafelförmige Partikel mit einem Seitenverhältnis (Z) von ≥ 5 auf einer Nicht-Druckoberflächenseite gegenüberliegend der das Polymer enthaltenden Schicht in einem Zustand, in dem der Träger hierzwischen eingeschlossen ist;
        wobei das Seitenverhältnis als das Verhältnis Z = L/a des langen Durchmessers (L) zur Dicke (a) eines Partikels definiert ist, worin L der zahlengemittelte Partikeldurchmesser ist, bestimmt mit einem dynamischen Lichtstreuungs-(DLC)-Partikelgrößenverteilungs-Messgerät von Horiba, Ltd., vom Typ LB-500, während die Partikel in einem Lösungsmittel dispergiert sind, und die Einheitsdicke a ein Wert ist, der durch Messen eines Beugungspeaks eines Partikels berechnet wird, wobei eine SmartLab SE-Pulver-Röntgen-Beugungsvorrichtung von Rigaku Corporation verwendet wird; und
        - Partikel außer den tafelförmigen Partikeln mit einem mittleren Partikeldurchmesser, der ≥ 0,1 μm ist und größer ist als die Dicke der Schicht, die die tafelförmigen Partikel enthält.

2. Druckplattenvorläufer gemäß Anspruch 1, worin die Dicke von jedem der tafelförmigen Partikel kleiner ist als die der Schicht, die die tafelförmigen Partikel enthält.

3. Druckplattenvorläufer gemäß Anspruch 1 oder 2, worin die tafelförmigen Partikel ein Siliciumatom und ein Sauerstoffatom enthalten.

4. Druckplattenvorläufer gemäß Anspruch 3, worin die tafelförmigen Partikel, die ein Siliciumatom und ein Sauerstoffatom enthalten, Smektit, Bentonit oder Glimmer sind.

5. Druckplattenvorläufer gemäß irgendeinem der Ansprüche 1-4, worin die Schicht, die die tafelförmigen Partikel enthält, ein Polymer oder ein Metalloxid enthält, das erhalten wird durch Hydrolysieren und Polykondensieren einer organischen Metallverbindung oder einer anorganischen Metallverbindung.

6. Druckplattenvorläufer gemäß irgendeinem der Ansprüche 1-5, worin die Partikel außer den tafelförmigen Partikeln organische Harzpartikel, anorganische Partikel oder organisch-anorganische Kompositpartikel sind.

7. Druckplattenvorläufer gemäß irgendeinem der Ansprüche 1-6, worin die arithmetische mittlere Höhe Sa der Schicht, die die tafelförmigen Partikel enthält, 0,1-20 μm beträgt.

8. Druckplattenvorläufer gemäß irgendeinem der Ansprüche 1-7, worin die Schicht, die das Polymer enthält, eine

Bildaufzeichnungsschicht ist, die einen Infrarotabsorber, einen Polymerisationsinitiator, eine polymerisierbare Verbindung und eine Polymerverbindung mit einer Partikelform umfasst.

**9.** Druckplattenvorläufer gemäß Anspruch 8, worin die Polymerverbindung mit einer Partikelform, die in der Bildaufzeichnungsschicht enthalten ist, eine hydrophobe Hauptkette und sowohl eine Aufbaueinheit (i), die eine anhängige Cyanogruppe enthält, die direkt an die hydrophobe Hauptkette gebunden ist, als auch eine Aufbaueinheit (ii), die eine anhängige Gruppe enthält, die ein hydrophiles Polyalkylenoxidsegment aufweist, umfasst.

**10.** Druckplattenvorläufer gemäß irgendeinem der Ansprüche 1-7, worin die das Polymer enthaltende Schicht einen Infrarotabsorber und thermoplastische Polymerpartikel enthält.

**11.** Druckplattenvorläuferlaminat, welches erhalten ist durch Laminieren einer Vielzahl der Druckplattenvorläufer gemäß irgendeinem der Ansprüche 1-10, worin das Druckplattenvorläuferlaminat so gebildet ist, dass eine äußerste Schicht auf einer Oberfläche, wo die Schicht, die das Polymer enthält, vorgesehen ist, und eine äußerste Schicht auf einer Oberfläche, worin die Schicht, die die tafelförmigen Partikel enthält, vorgesehen ist, dadurch laminiert sind, dass sie in direkten Kontakt gebracht worden sind.

## Revendications

**1.** Précurseur de plaque d'impression comprenant :

1) un support en aluminium ;
2) une couche contenant un polymère sur un côté surface d'impression sur le support d'aluminium ; et
3) une couche contenant

- des particules tabulaires présentant un rapport d'aspect (Z) de $\geq 5$ sur un côté non-surface d'impression opposé à la couche contenant le polymère dans un état de prise en sandwich du support entre ceux-ci ; le rapport d'aspect étant défini comme étant le rapport Z = L/a du long diamètre (L) sur l'épaisseur (a) d'une particule, dans lequel L est le diamètre de particule moyen en nombre déterminé au moyen d'un dispositif de mesure de distribution de taille de particule à diffusion dynamique de la lumière (DLC) de type LB-500 de Horiba, Ltd. alors que les particules sont dispersées dans un solvant, et l'épaisseur unitaire a est une valeur calculée en mesurant un pic de diffraction d'une particule en utilisant un dispositif de diffraction à rayons X de poudre SE Smart Lab de Rigaku Corporation ; et
- des particules autres que les particules tabulaires, présentant un diamètre de particule moyen qui est $\geq$ 0,1 $\mu$m et est supérieur à l'épaisseur de la couche contenant les particules tabulaires.

**2.** Précurseur de plaque d'impression selon la revendication 1, dans lequel l'épaisseur de chacune des particules tabulaires est inférieure à celle de la couche contenant les particules tabulaires.

**3.** Précurseur de plaque d'impression selon la revendication 1 ou revendication 2, dans lequel les particules tabulaires contiennent un atome de silicium et un atome d'oxygène.

**4.** Précurseur de plaque d'impression selon la revendication 3, dans lequel les particules tabulaires contenant un atome de silicium et un atome d'oxygène sont de la smectite, de la bentonite ou du mica.

**5.** Précurseur de plaque d'impression selon l'une quelconque des revendications 1 à 4, dans lequel la couche contenant les particules tabulaires contient un polymère ou un oxyde métallique obtenu par l'hydrolyse et la polycondensation d'un composé de métal organique ou d'un composé de métal inorganique.

**6.** Précurseur de plaque d'impression selon l'une quelconque des revendications 1 à 5, dans lequel les particules autres que les particules tabulaires sont des particules organiques de résine, des particules inorganiques ou des particules composites organiques-inorganiques.

**7.** Précurseur de plaque d'impression selon l'une quelconque des revendications 1 à 6, dans lequel la hauteur moyenne arithmétique Sa de la couche contenant les particules tabulaires est de 0,1 à 20 $\mu$m.

**8.** Précurseur de plaque d'impression selon l'une quelconque des revendications 1 à 7, dans lequel la couche contenant

le polymère est une couche d'enregistrement d'image incluant un agent d'absorption d'infrarouge, un initiateur de polymérisation, un composé polymérisable et un composé polymère présentant une forme de particule.

**9.** Précurseur de plaque d'impression selon la revendication 8, dans lequel le composé polymère présentant une forme de particule contenu dans la couche d'enregistrement d'image présente une chaîne principale hydrophobe et à la fois un motif constitutif (i) qui contient un groupe cyano pendant directement lié à la chaîne principale hydrophobe et un motif constitutif (ii) qui contient un groupe pendant présentant un segment d'oxyde de polyalkylène hydrophile.

**10.** Précurseur de plaque d'impression selon l'une quelconque des revendications 1 à 7, dans lequel la couche contenant le polymère inclut un agent d'absorption d'infrarouge et des particules polymères thermoplastiques.

**11.** Stratifié de précurseurs de plaque d'impression qui est obtenu en stratifiant une pluralité des précurseurs de plaque d'impression selon l'une quelconque des revendications 1 à 10, dans lequel le stratifié de précurseurs de plaque d'impression est formé de telle sorte qu'une couche la plus extérieure sur une surface où est disposée la couche contenant le polymère et une couche la plus extérieure sur une surface où est disposée la couche contenant les particules tabulaires sont stratifiées en étant amenées en contact direct l'une avec l'autre.

FIG. 1

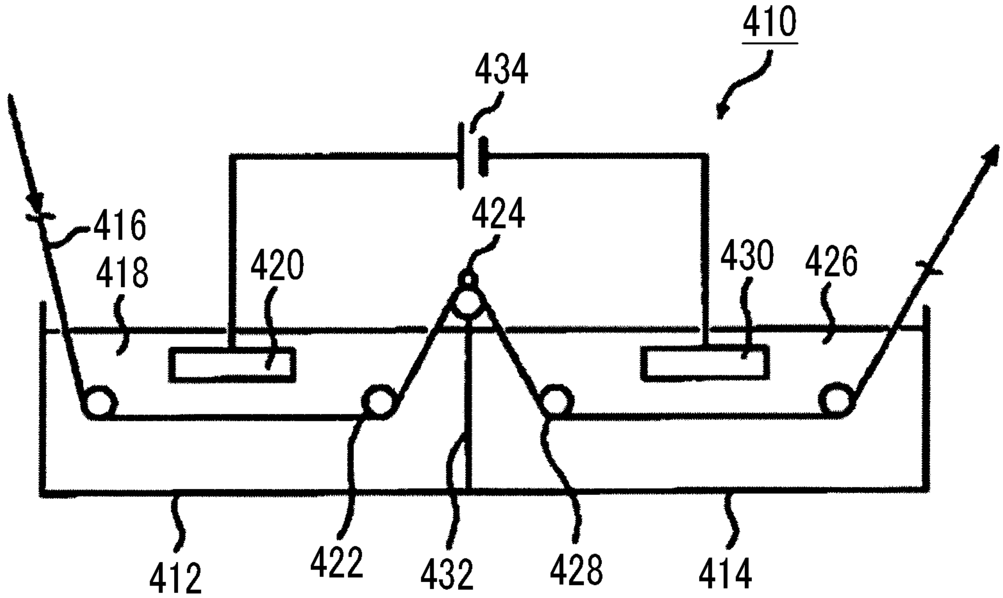


FIG. 2

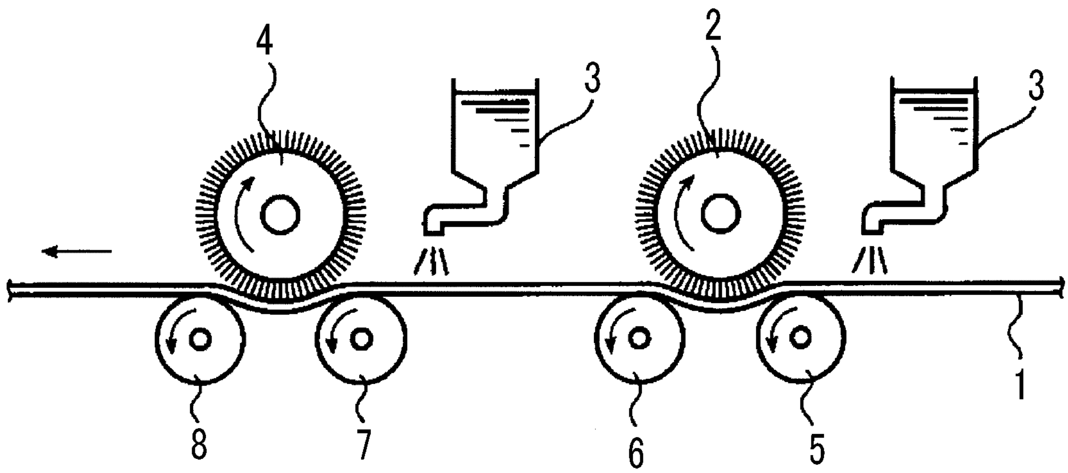

FIG. 3

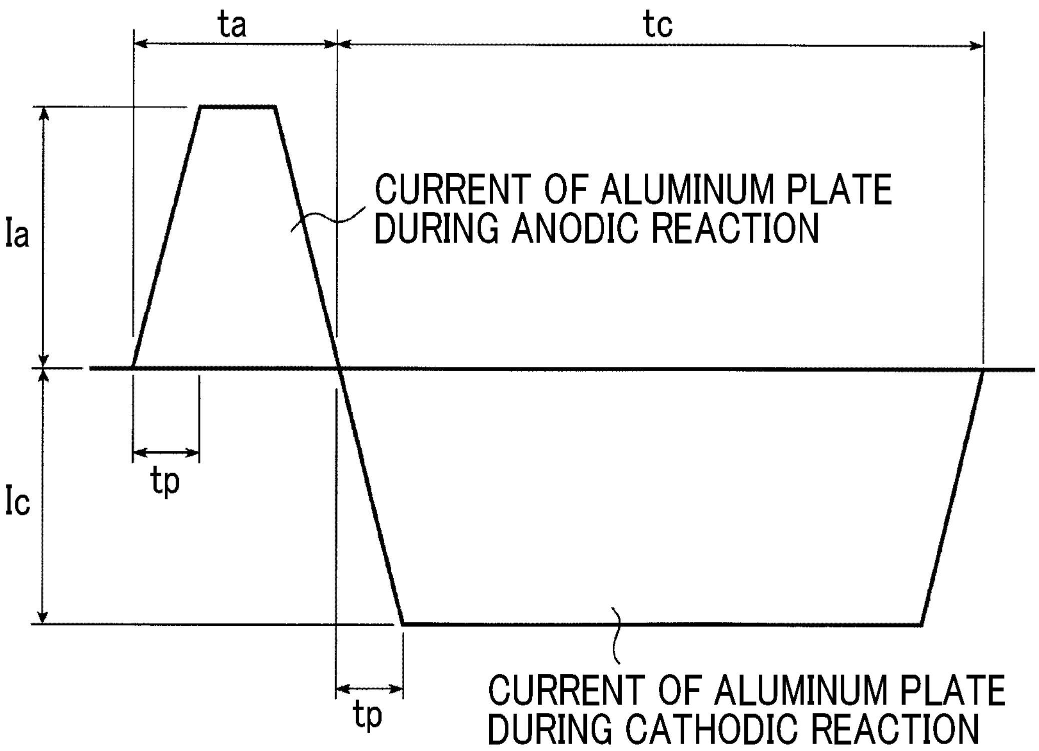
ta
tc
Ia
Ic
tp
tp
CURRENT OF ALUMINUM PLATE DURING ANODIC REACTION
CURRENT OF ALUMINUM PLATE DURING CATHODIC REACTION

FIG. 4

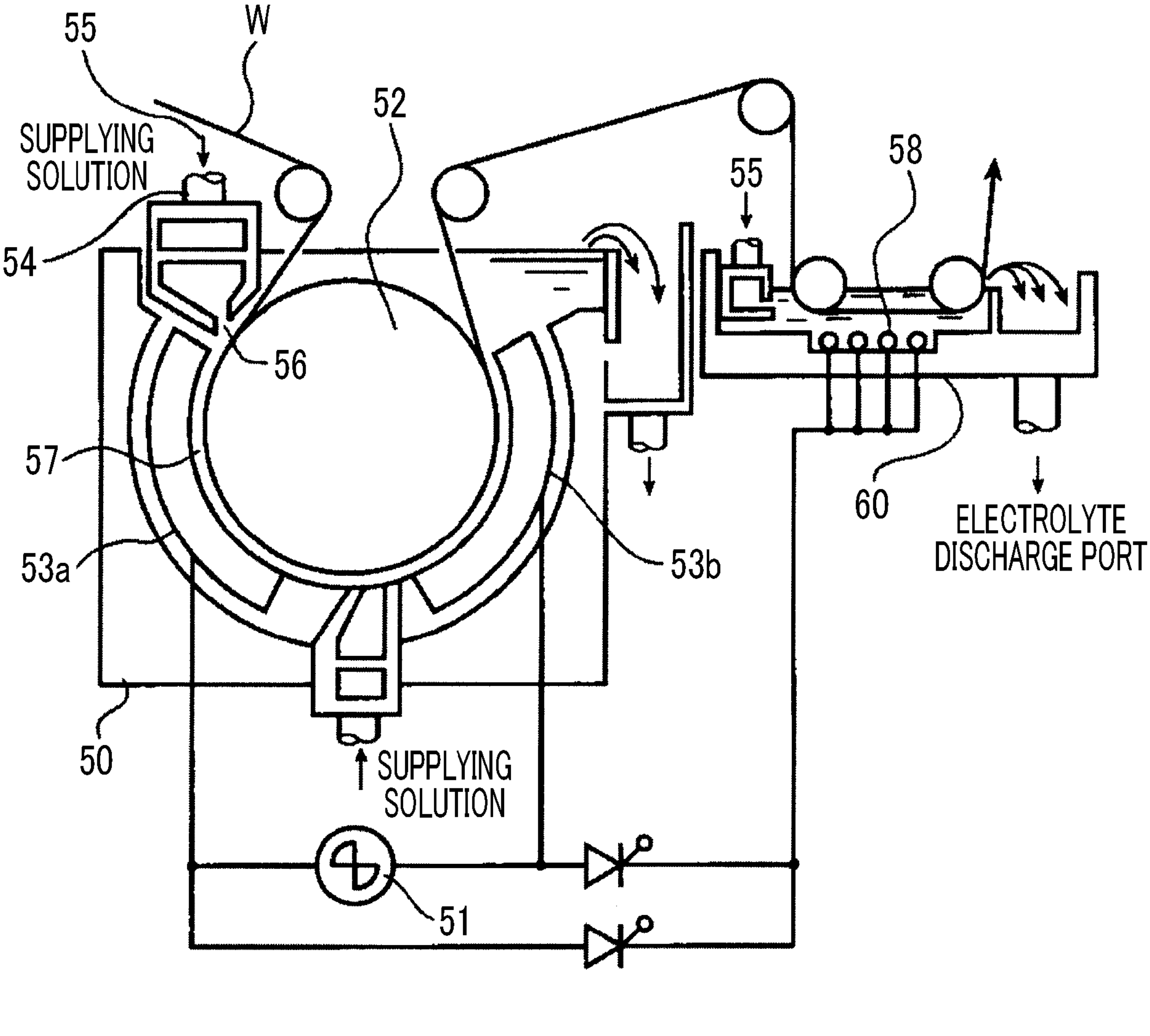
55
W
52
SUPPLYING
SOLUTION
54
56
57
53a
50
55
58
60
53b
ELECTROLYTE
DISCHARGE PORT
SUPPLYING
SOLUTION
51

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2017002641 A
- JP 2002046363 A
- EP 1514681 A
- JP 2004017303 A
- JP 2002333704 A
- JP 8106183 A
- JP 2002327036 A
- JP 2002173410 A
- JP 2004307837 A
- JP 2006038246 A
- JP 2014104631 A
- JP 2008195018 A
- JP 008195018 A
- JP 2012148555 A
- JP 2007276454 A
- JP 2009154525 A
- JP 2008284817 A
- JP 2006091479 A
- US 20080311520 A
- JP 9123387 A
- JP 9131850 A
- JP 9171249 A
- JP 9171250 A
- EP 0931647 B
- JP 2001277740 A
- JP 2001277742 A
- JP 2008503365 A
- WO 96034316 A
- JP 62170950 A
- JP 2008015503 A
- JP 2007148940 A
- JP 10282679 A
- JP 2304441 A
- JP 2005125749 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- JP 2012218778 A
- US 3458311 A
- JP 55049729 A
- JP 2007148040 A

### Non-patent literature cited in the description

- Ultrafine Particles and Materials. SHOKABO Co., Ltd, 1993
- Manufacturing & Application of Microspheres & Powders. CMC Publishing Co., Ltd, 2005
- Latest Pigment Application Technology. CMC Publishing Co., Ltd, 1986
- *Research Disclosure No. 33303,* January 1992
- Dye Handbook. 1970
- Near-Infrared Absorbing Coloring agent. *Chemical Industry,* May 1986, 45-51
- Development and Market Trend of Functional Dyes in 1990's. CMC Publishing Co., Ltd, 1990
- Latest Pigment Handbook. 1977
- Printing Ink Technology. CMC Publishing Co., Ltd, 1984